# EUROPEAN PATENT APPLICATION

(11) **EP 4 716 071 A1**
(43) Date of publication of application: **25.03.2026**
(21) Application number: 23943021.8
(22) Date of filing: 30.06.2023
(51) Int. Cl.: H02K 5/04

(54) **POWER ASSEMBLY WITH LAYOUT CONFORMING TO POWER FLOW AND ELECTRIC VEHICLE**

(71) Applicant: Huawei Digital Power Technologies Co., Ltd., Shenzhen, Guangdong 518043 (CN)
(72) Inventor: GAO, Feng, Shenzhen, Guangdong 518043 (CN); XU, Zhihai, Shenzhen, Guangdong 518043 (CN); DU, Na, Shenzhen, Guangdong 518043 (CN)
(74) Representative: Isarpatent
(86) International application number: PCT/CN2023/105297
(87) International publication number: WO 2025/000527

(57) **Abstract**

Embodiments of this application provide a powertrain arranged along a power flow. The powertrain includes an integrated housing, a motor, and a motor controller. The integrated housing includes a motor accommodating cavity, a controller accommodating cavity, a direct-current input interface mounting hole, and an alternating-current output interface mounting hole. The motor includes a motor shaft and a motor winding. The direct-current input interface mounting hole and the alternating-current output interface mounting hole are arranged relative to each other along a first direction. The alternating-current output interface mounting hole and a wiring terminal of the motor winding are arranged on one side along the first direction. The direct-current input interface mounting hole and an output end of the motor shaft are arranged on the other side along the first direction. A projection of the controller accommodating cavity partially overlaps a projection of the motor accommodating cavity along a second direction. A projection of the direct-current input interface mounting hole, a projection of the alternating-current output interface mounting hole, and a projection of the motor shaft do not overlap along a third direction. The powertrain provided in this application has a compact layout and complies with a flow direction of a power flow, to help implement miniaturization and high power density of the powertrain.

## Description

### TECHNICAL FIELD

This application relates to the field of powertrain technologies, and in particular, to a powertrain arranged along a power flow, and an electric vehicle.

### BACKGROUND

An existing electric vehicle usually uses an integrated powertrain as a power source. Currently, a motor and a motor controller are usually integrated into a two-in-one powertrain; or a motor, a motor controller, and a reducer are usually integrated into a three-in-one powertrain; or a motor, a motor controller, a reducer, and another component of an electric vehicle are usually integrated into an all-in-one powertrain. To improve overall performance of the electric vehicle, various design requirements such as miniaturization, power density, reliability, heat dissipation performance, and power performance need to be comprehensively considered for the powertrain.

Correspondingly, a problem existing in a layout design of components in the powertrain and a structure design of the components not only affects miniaturization or heat dissipation performance of the powertrain, but also affects energy conversion efficiency and therefore reduce power density of the powertrain. In addition, this further affects an energy transmission path, thereby reducing reliability and power performance of the powertrain.

### SUMMARY

This application provides a powertrain arranged along a power flow, and an electric vehicle. A layout design and a structure design of a plurality of components such as a motor, a motor controller, and a reducer in the powertrain can meet design requirements such as miniaturization, power density, reliability, heat dissipation performance, and power performance of the powertrain, thereby improving overall performance of the electric vehicle.

According to a first aspect, an embodiment of this application provides a powertrain arranged along a power flow. The powertrain includes an integrated housing, a motor, and a motor controller. The integrated housing includes a motor accommodating cavity, a controller accommodating cavity, a direct-current input interface mounting hole, and an alternating-current output interface mounting hole. The motor includes a motor shaft and a motor winding. The direct-current input interface mounting hole and the alternating-current output interface mounting hole are arranged relative to each other along a first direction. The alternating-current output interface mounting hole and a wiring terminal of the motor winding are arranged on one side along the first direction. The direct-current input interface mounting hole and an output end of the motor shaft are arranged on the other side along the first direction. A projection of the controller accommodating cavity partially overlaps a projection of the motor accommodating cavity along a second direction. A projection of the direct-current input interface mounting hole, a projection of the alternating-current output interface mounting hole, and a projection of the motor shaft do not overlap along a third direction. Any two of the first direction, the second direction, and third direction are perpendicular to each other.

In the powertrain provided in this embodiment of this application, the integrated housing is configured to accommodate the motor and the motor controller. In comparison with a split powertrain, integration of the powertrain can be improved. In this way, space utilization of the powertrain is increased, and costs are reduced. In addition, in the integrated housing of the powertrain provided in this embodiment of this application, the controller accommodating cavity and the motor accommodating cavity are arranged in the second direction, and the controller accommodating cavity and the motor accommodating cavity partially overlap in the third direction, to help reduce space occupied by the powertrain in the second direction.

In this embodiment of this application, energy transmission sequentially passes through the direct-current input interface mounting hole, the motor controller, the alternating-current output interface mounting hole, the wiring terminal of the motor winding, and the output end of the motor shaft.

In this embodiment of this application, the direct-current input interface mounting hole and the alternating-current output interface mounting hole are provided relative to each other along the first direction, and are respectively located at two ends of the controller accommodating cavity along the first direction. A component configured to transmit a direct current to the motor controller is mounted in the direct-current input interface mounting hole and extends to an inner side of the controller accommodating cavity. In other words, the motor controller is electrically connected to a battery pack through the direct-current input interface mounting hole. A component configured to transmit an alternating current to the motor may be mounted in the alternating-current output interface mounting hole and extends to an outer side of the controller accommodating cavity. In other words, the motor controller is electrically connected to the motor through the alternating-current output interface mounting hole. In this embodiment of this application, the direct-current input interface mounting hole and the alternating-current output interface mounting hole are provided relative to each other along the first direction, to avoid electrical interference generated in a transmission process of the direct current and the alternating current, thereby improving security performance. In this way, the alternating-current output interface mounting hole and the motor are adjacently provided, to help shorten a distance between the motor controller and the wiring terminal of the motor through the alternating-current output interface mounting hole.

In this embodiment of this application, the motor winding is connected to the motor controller through an electrical connecting piece. The wiring terminal of the motor winding is configured to receive an alternating current transmitted by the motor controller. The wiring terminal of the motor winding and the alternating-current output interface mounting hole are adjacently provided and are located on a same side of the controller accommodating cavity. In this way, a transmission path of energy between the motor controller and the motor is short, and impedance becomes smaller. This helps reduce an energy loss on the transmission path and improve energy transmission efficiency. In addition, a layout of the motor controller and the motor is compact and orderly, to help reduce a volume of the powertrain and optimize a layout of a whole vehicle. The wiring terminal of the motor winding and the output end of the motor shaft are disposed relative to each other along the first direction. The output end of the motor shaft and the direct-current input interface mounting hole are provided on a same side. In other words, an axial direction of the motor shaft is parallel to an arrangement direction of the direct-current input interface mounting hole and an alternating-current output interface, to help reduce a volume of the powertrain.

In the powertrain provided in this embodiment of this application, the motor and the motor controller are both disposed in the integrated housing, to increase integration of the powertrain and reduce the volume and costs. This helps implement a lightweight design of the powertrain and improve power density. In addition, in the powertrain provided in this embodiment of this application, a layout design of the direct-current input interface mounting hole, the alternating-current output interface mounting hole, the wiring terminal of the motor winding, and the output end of the motor shaft complies with a flow direction of a power flow, to shorten an energy transmission path in the powertrain and help reduce an energy loss in a transmission process.

In an embodiment, the motor controller includes a capacitor module, a power module, and a copper bar assembly. The controller accommodating cavity is configured to accommodate the capacitor module, the power module, and the copper bar assembly. The capacitor module and the power module are stacked along the second direction. The copper bar assembly and the power module are adjacently arranged along the third direction. A distance between the power module and the motor shaft is greater than a distance between the copper bar assembly and the motor shaft along a radial direction of the motor.

In an embodiment, a projection of the direct-current input interface mounting hole at least partially overlaps a projection of the capacitor module along the first direction. In this embodiment of this application, energy transmission sequentially passes through the direct-current input interface mounting hole, the capacitor module, the power module, and the alternating-current output interface mounting hole. The direct-current input interface mounting hole and the alternating-current output interface mounting hole are provided relative to each other along the first direction. In other words, a flow direction of a power flow between the direct-current input interface mounting hole and the alternating-current output interface mounting hole is the first direction. In this solution, the projection of the direct-current input interface mounting hole is set to at least partially overlap the projection of the capacitor module. In this way, an energy transmission path between the direct-current input interface mounting hole and the capacitor module is short, to help reduce an energy loss in the motor controller.

In an embodiment, a projection of the direct-current input interface mounting hole at least partially overlaps a projection of the power module. This solution helps shorten an energy transmission path between the direct-current input interface mounting hole and the power module, thereby reducing an energy loss in the motor controller.

In an embodiment, a projection of the direct-current input interface mounting hole at least partially overlaps both a projection of the capacitor module and a projection of the power module. This solution helps shorten an energy transmission path among the direct-current input interface mounting hole, the capacitor module, and the power module, thereby reducing an energy loss in the motor controller.

In an embodiment, the capacitor module and the power module are stacked along the second direction, and the copper bar assembly and the power module are adjacently arranged along the third direction. The third direction is perpendicular to the first direction and the second direction. Adjacent along, in comparison with a case in which the capacitor module, the power module, and the copper bar assembly are laid along the first direction, this solution helps reduce a dimension value of the motor controller in the first direction, to reduce the volume of the powertrain. This helps connect the capacitor module and the power module along the second direction, shorten a connection path, and reduce energy consumption of power transmission, to implement a smooth power flow between the capacitor module and the power module.

In an embodiment, the distance between the power module and the motor shaft is greater than the distance between the copper bar assembly and the motor shaft along the radial direction of the motor. In this embodiment of this application, the copper bar assembly is closer to the motor shaft than the power module, to help shorten a distance between the copper bar assembly and the wiring terminal of the motor winding. Because there is an electrical connection relationship between the copper bar assembly and the wiring terminal of the motor winding, the distance between the copper bar assembly and the wiring terminal of the motor winding is set to be small, so that the layout complies with a flow direction of a power flow, thereby reducing an energy loss. This solution further helps reduce a space volume occupied by the motor controller and the motor and improve integration and power density of the powertrain.

In an embodiment, the motor controller further includes a circuit board. The circuit board is electrically connected to the power module. Along the second direction, the circuit board, the capacitor module, and the power module are stacked, a projection of any one of the capacitor module, the power module, and the circuit board does not overlap the copper bar assembly, and a projection of the motor shaft does not overlap the projection of any one of the capacitor module, the power module, and the circuit board. The projection of the motor shaft does not overlap a projection of any one of the capacitor module, the power module, and the circuit board along the third direction. The controller accommodating cavity at least partially overlaps the motor accommodating cavity along the third direction. A length of an overlapping part between the controller accommodating cavity and the motor accommodating cavity in the third direction is less than an outside diameter of the motor stator.

In this embodiment of this application, because a surface of the circuit board usually has a large area, in comparison with a case in which the capacitor module, the power module, and the circuit board are laid along the third direction or the first direction, this solution helps reduce a space volume occupied by the motor controller by sequentially stacking the circuit board, the power module, and the capacitor module along the second direction.

In this embodiment of this application, the projection of the copper bar assembly does not overlap the projection of any one of the capacitor module, the power module, and the circuit board in the second direction. In other words, the copper bar assembly is not stacked with the capacitor module, the power module, and the circuit board along the second direction, to reduce interference caused by power transmitted by the copper bar assembly to signal quality of the circuit board.

The copper bar assembly is electrically connected to the power module. The copper bar assembly is configured to transmit an alternating current output by the power module. The copper bar assembly may be disposed on a side that is of the power module and that is close to the motor shaft along the third direction. Components in the motor controller are appropriately arranged, to avoid an excessively large dimension value of the motor controller in the second direction. This further helps an electrical connection between the copper bar assembly and the motor configured to receive an alternating current, to comply with the flow direction of the power flow. In this embodiment of this application, the projection of the motor shaft does not overlap the projection of any one of the capacitor module, the power module, and the circuit board in the second direction, to help reduce a dimension value of the powertrain in the second direction.

In an embodiment, the projection of the motor shaft does not overlap a projection of any one of the capacitor module, the power module, and the circuit board along the third direction. The controller accommodating cavity at least partially overlaps the motor accommodating cavity along the third direction. A length of an overlapping part between the controller accommodating cavity and the motor accommodating cavity in the third direction is less than an outside diameter of the motor stator.

In this embodiment of this application, the projection of the motor shaft does not overlap the projection of any one of the capacitor module, the power module, and the circuit board in the third direction, to help reduce a dimension value of the powertrain in the third direction. The controller accommodating cavity and the motor accommodating cavity are arranged along the second direction and partially overlap along the third direction, to reduce a total dimension value of the motor controller and the motor in the second direction. The length of the overlapping part between the controller accommodating cavity and the motor accommodating cavity in the third direction is less than the outside diameter of the motor stator, so that the projections of the controller accommodating cavity and the motor accommodating cavity in the third direction do not completely overlap. Space can be provided for another component or apparatus disposed below the controller accommodating cavity, to improve space utilization of the powertrain.

In an embodiment, the direct-current input interface mounting hole is configured to fasten a direct-current input interface. The direct-current input interface is configured to electrically connect to the power battery. The power module includes a plurality of bridge arm components. The plurality of bridge arm components are configured to form an inverter circuit to convert a direct current into an alternating current. Along the first direction, the plurality of bridge arm components are sequentially and adjacently arranged, projections of the plurality of bridge arm components do not overlap a projection of the alternating-current output interface mounting hole, and the projections of the plurality of bridge arm components overlap a projection of the direct-current input interface mounting hole. A projection of the capacitor module covers projections of the plurality of bridge arm components along the second direction.

In this embodiment of this application, the projections of the direct-current input interface mounting hole and the alternating-current output interface mounting hole at most partially overlap in the first direction. The capacitor module is electrically connected to the battery pack through the direct-current input interface mounting hole. The capacitor module and the power module are stacked. In this solution, the projections of the plurality of bridge arm components are set to overlap the projection of the direct-current input interface mounting hole along the first direction. In this way, an energy transmission path from the direct-current input interface mounting hole to the bridge arm components is short, to help reduce an energy loss.

In this embodiment of this application, the copper bar assembly transmits the alternating current through the alternating-current output interface mounting hole. The projections of the copper bar assembly and the bridge arm components do not overlap in the second direction. In this solution, the projections of the plurality of bridge arm components are set to not overlap the projection of the alternating-current output interface mounting hole along the first direction, to provide a precondition for reducing an energy loss between the copper bar assembly and the alternating-current output interface mounting hole. The capacitor module and the power module are stacked along the second direction. The projection of the capacitor module in the second direction covers the projections of the plurality of bridge arm components along the second direction, so that the capacitor module can support the bridge arm components.

In an embodiment, the power module includes three bridge arm components. Two ends of the three bridge arm components are respectively configured to electrically connect to a positive electrode and a negative electrode of the direct-current input interface through two first connecting pieces. A bridge arm midpoint of each bridge arm component is configured to connect to the copper bar assembly through a second connecting piece. The three bridge arm components output three phases of alternating currents to the copper bar assembly through three second connecting pieces. The two first connecting pieces are spaced and arranged in the controller accommodating cavity along the first direction. Projections of the two first connecting pieces at least partially overlap the projection of the direct-current input interface mounting hole along the first direction. The three second connecting pieces are spaced and arranged in the controller accommodating cavity along the first direction. Projections of the three second connecting pieces at least partially overlap the projection of the alternating-current output interface mounting hole along the first direction.

In this embodiment of this application, the power module includes the three bridge arm components. Each bridge arm component includes two first connecting pieces and one second connecting piece. The first connecting pieces and the second connecting piece are respectively located on two sides of the bridge arm component along the third direction. The battery pack transmits a direct current to the first connecting pieces of the three bridge arm components through the direct-current input interface and the capacitor module. After converting the direct current into an alternating current, the three bridge arm components sequentially transmit the alternating current to the copper bar assembly and the alternating-current output interface mounting hole through the second connecting pieces.

In this embodiment of this application, the two first connecting pieces of each bridge arm component are spaced and arranged along the first direction, and a projection of the first connecting piece at least partially overlaps a projection of the direct-current input interface in the first direction. Because there is an electrical connection relationship between the first connecting piece and the direct-current input interface, this solution helps shorten an energy transmission path between the first connecting piece and the direct-current input interface. The three second connecting pieces of the three bridge arm components are spaced and arranged along the first direction. A projection of the second connecting piece at least partially overlaps a projection of the alternating-current output interface in the first direction. Because the second connecting piece is directly electrically connected to the copper bar assembly, the alternating current is transmitted from the second connecting piece to the alternating-current output interface mounting hole through the copper bar assembly. This solution further helps reduce an energy loss between the second connecting piece and the alternating-current output interface mounting hole.

In an embodiment, the integrated housing further includes a power interface mounting hole. The power interface mounting hole and the direct-current input interface mounting hole are arranged relative to each other along the first direction. The power interface mounting hole, the alternating-current output interface mounting hole, and the wiring terminal of the motor winding are arranged on the side along the first direction. The alternating-current output interface mounting hole and the alternating-current mounting hole are adjacently arranged along the third direction.

In an embodiment, an external power supply charges the battery pack through the power interface mounting hole, the motor controller, and the direct-current input interface mounting hole, and the power interface mounting hole and the direct-current input interface mounting hole are arranged relative to each other along the first direction, to help shorten a transmission path between the power interface mounting hole and the direct-current input interface mounting hole, thereby reducing an energy loss in a charging process. In this embodiment of this application, the power interface mounting hole and the direct-current input interface mounting hole are arranged relative to each other along the first direction, to help implement electrical isolation.

In an embodiment, the power interface mounting hole is configured to fasten a power interface. The power interface is configured to electrically connect to an external power supply. The power interface mounting hole penetrates the integrated housing along the first direction and is connected to the controller accommodating cavity. A distance between the alternating-current output interface mounting hole and the motor shaft is greater than a distance between the power interface mounting hole and the motor shaft along the radial direction of the motor.

In this embodiment of this application, the alternating-current output interface mounting hole is closer to the motor than the power interface mounting hole in the second direction and the third direction. Because there is an electrical connection relationship between the alternating-current output interface mounting hole and the wiring terminal of the motor winding, this solution helps shorten an energy transmission path. A layout of the motor controller and the motor is more compact, to help reduce a space volume of the powertrain and improve power density.

In an embodiment, the alternating-current output interface mounting hole is configured to fasten the alternating-current output interface. The alternating-current output interface is configured to electrically connect to the wiring terminal of the motor winding through an input copper bar. The input copper bar, the alternating-current output interface mounting hole, and the wiring terminal of the motor winding are arranged on the side along the first direction. A length direction of the input copper bar intersects the first direction, the second direction, and the third direction.

In this embodiment of this application, the alternating-current output interface mounting hole, the input copper bar, and the wiring terminal of the motor winding are sequentially connected. The alternating-current output interface mounting hole and the input copper bar are arranged relative to each other along the first direction, so that the alternating current output by the motor controller is transmitted to the input copper bar. The input copper bar includes a first end and a second end that are disposed relative to each other. The first end of the input copper bar is configured to connect to the alternating-current output interface mounting hole, and the second end of the input copper bar is configured to connect to the wiring terminal of the motor winding. In the second direction, a distance between the first end of the input copper bar and the alternating-current output interface mounting hole is less than a distance between the first end of the input copper bar and the wiring terminal of the motor winding, and a distance between the second end of the input copper bar and the wiring terminal of the motor winding is less than a distance between the second end of the input copper bar and the alternating-current output interface mounting hole. In other words, an extension direction of the input copper bar complies with a direction of a power flow in the alternating-current output interface mounting hole, the input copper bar, and the wiring terminal of the motor winding. Specifically, an angle value of an included angle between the extension direction of the input copper bar and the second direction is less than 90°. In this case, a loss of the alternating current is small in a process of transmission between the motor controller and the motor, so that the motor can more efficiently drive wheels to rotate, to enhance power performance of the vehicle.

**In** an embodiment, the alternating-current output interface includes three wiring ports. The three wiring ports are electrically connected to the wiring terminal of the motor winding respectively through three input copper bars. The three input copper bars are spaced and arranged. An arrangement direction of the three input copper bars intersects both the first direction and the second direction.

In this embodiment of this application, the alternating-current output interface is located between the copper bar assembly and the input copper bar along the first direction. The bridge arm component in the power module outputs an alternating current to the copper bar assembly. The copper bar assembly is sequentially electrically connected to the input copper bar and the wiring terminal of the motor winding through the alternating-current output interface, and transmits the alternating current to the motor. The three phases of alternating currents output by the three second connecting pieces of the bridge arm components are respectively transmitted to the three input copper bars. The three input copper bars are spaced and arranged, to help reduce electrical interference generated between the input copper bars.

In an embodiment, the powertrain further includes a reducer. The reducer is connected to an output end of the motor shaft in a transmission manner. The reducer and the alternating-current output interface mounting hole are arranged relative to each other along the first direction. The reducer and the direct-current input interface mounting hole are arranged on the other side along the first direction.

In this embodiment of this application, the direct-current input interface mounting hole and an opening of the reducer are provided on a same side, and the alternating-current output interface mounting hole and an opening of the motor are provided on a same side, so that two ends of the integrated housing are basically aligned along the first direction. An internal layout of the powertrain is compact and orderly, to shorten an energy transmission path.

In this embodiment of this application, the reducer is configured to receive mechanical energy transmitted by the motor, and drive wheels to rotate by using wheel drive terminals. The controller accommodating cavity and the motor accommodating cavity are arranged along the second direction and partially overlap in the third direction. In this way, there is installation space below the controller accommodating cavity along the second direction. Because the wheel drive terminals of the reducer need to be connected to the wheels, this solution helps provide installation space for the connection between the reducer and each wheel. An axis of the wheel drive terminal is parallel to the motor shaft. An arrangement direction of the axis of the wheel drive terminal and the motor shaft is perpendicular to the first direction. In this way, a layout of the motor and the reducer is compact and orderly.

In this embodiment of this application, a power flow direction of the motor controller and an energy flow direction of the motor are opposite to each other, and approximately present a U shape; and an energy flow direction from the motor to the reducer and that from the reducer to the wheel drive terminal are also opposite to each other, and approximately present a U shape. A U-shaped opening in the U-shaped energy flow direction of the motor controller and the motor is opposite to a U-shaped opening in the U-shaped energy flow direction from the motor to the reducer and then to the wheel drive terminal. The wheel drive terminal is located below the motor controller. In this way, an entire energy flow of the powertrain is smooth, and an energy path is short, to help implement a small volume, space saving, higher integration, and miniaturization of the powertrain.

In an embodiment, the integrated housing further includes a reducer accommodating cavity. The reducer accommodating cavity is configured to accommodate the reducer. The reducer accommodating cavity communicates with the motor accommodating cavity. The controller accommodating cavity, the motor accommodating cavity, and the reducer accommodating cavity each include an opening. Along the first direction, an orientation of the opening of the motor accommodating cavity is opposite to an orientation of the opening of the reducer accommodating cavity, and a length of the opening of the controller accommodating cavity is less than a sum of lengths of the reducer accommodating cavity and the motor accommodating cavity. An orientation of the opening of the controller accommodating cavity is perpendicular to the first direction and the third direction.

In this embodiment of this application, there is a transmission relationship between the reducer and the motor, and the reducer accommodating cavity is set to communicate with the motor accommodating cavity, so that a part of the motor shaft extends into the reducer accommodating cavity, to implement mechanical transmission between the motor and the reducer. The controller accommodating cavity does not communicate with either of the reducer accommodating cavity and the motor accommodating cavity, so that a cooling oil medium in the motor accommodating cavity and the reducer accommodating cavity cannot flow into the controller accommodating cavity and does not further cause electrical interference to an electrical component in the motor controller, thereby ensuring normal working of the motor controller.

In an embodiment, the powertrain further includes a motor end cover, a reducer end cover, and a motor controller cover. The motor end cover, the reducer end cover, and the motor controller cover are respectively configured to cover the opening of the controller accommodating cavity, the opening of the motor accommodating cavity, and the opening of the reducer accommodating cavity. Along the first direction, a length of the motor controller cover is less than a distance between the motor end cover and the reducer end cover, and a length of the controller accommodating cavity is less than a distance between the motor end cover and the reducer end cover.

In this embodiment of this application, the motor controller cover covers the opening of the controller accommodating cavity along the second direction, and the motor end cover and the reducer end cover respectively cover the opening of the motor and the opening of the reducer along the first direction. A position relationship of the motor controller cover, the motor end cover, and the reducer end cover is similar to a position relationship of the opening of the motor controller, the opening of the motor, and the opening of the reducer. A length of the motor controller cover along the first direction is less than a distance between the motor end cover and the reducer end cover along the first direction. In other words, the motor controller cover is located between the motor end cover and the reducer end cover along the first direction, to help reduce a total dimension value of the motor controller, the motor, and the reducer in the first direction, thereby reducing a space volume occupied by the powertrain in the electric vehicle. The length of the controller accommodating cavity along the first direction is less than the distance between the motor end cover and the reducer end cover along the first direction. This also reduces the volume of the powertrain.

In an embodiment, the powertrain further includes a wiring cover. Along the first direction, the wiring cover and the reducer cover are arranged relative to each other, the motor end cover is arranged between the motor stator and the wiring cover, a gap between the wiring cover and the motor end cover is used to accommodate the input copper bar, and a projection of the wiring cover covers projections of the alternating-current output interface mounting hole, the three input copper bars, the wiring terminal of the motor winding, and the motor shaft.

In this embodiment of this application, two ends of the input copper bar are respectively connected to the alternating-current output interface mounting hole and the wiring terminal of the motor winding, and the input copper bar is configured to transmit the alternating current output by the motor controller to the motor. The alternating-current output interface mounting hole and the three input copper bars are all located on an outer side of the motor end cover. The wiring terminal of the motor winding and one end of the motor shaft extend from the motor accommodating cavity to the motor end cover. The wiring cover can be configured to cover the alternating-current output interface mounting hole, the three input copper bars, the wiring terminal of the motor winding, and an end part of the motor shaft. The alternating-current output interface mounting hole, the three input copper bars, and the wiring terminal of the motor winding are electrically connected. The wiring cover can be disposed to prevent the electrical connection relationship from being affected by the outside. The wiring cover can further prevent a foreign matter from entering the motor shaft, to ensure normal working of the motor.

In an embodiment, the integrated housing further includes a coolant inlet and a coolant outlet. The coolant inlet is configured to provide a coolant for the motor controller. The coolant outlet is configured to output the coolant. The coolant inlet, the power interface mounting hole, and the alternating-current output interface mounting hole are arranged on the side along the first direction. The coolant inlet and the power interface mounting hole are adjacently arranged along the second direction. A projection of the coolant outlet overlaps a projection of the controller accommodating cavity and does not overlap the projection of the motor shaft along the third direction.

In this embodiment of this application, the coolant enters a liquid cooling passage below the controller accommodating cavity through the coolant inlet. The motor controller generates much heat during working. In this solution, the coolant inlet and the liquid cooling passage are disposed, so that the coolant can cool and dissipate heat for the motor controller, to help reduce a temperature of the motor controller in a stable working condition. The coolant inlet and the direct-current input interface mounting hole are arranged relative to each other along the first direction, to help reduce operation difficulty of an electrical connection and a mechanical connection, thereby avoiding adverse impact of the coolant on the direct-current input interface and improving safety performance of the motor controller and the powertrain. In addition, an axial direction of the coolant inlet is the same as the first direction. In other words, a flow direction of the coolant is opposite to a flow direction of a power flow in the motor controller, to help improve heat dissipation efficiency of the coolant. The liquid cooling passage is located below the controller accommodating cavity along the second direction, to appropriately use internal space of the motor controller.

In an embodiment, the integrated housing further includes the coolant outlet. The coolant inlet communicates with the coolant outlet through the liquid cooling passage. An axial direction of the coolant outlet is perpendicular to both the first direction and the second direction. The coolant outlet, the controller accommodating cavity, and the motor shaft are arranged along the axial direction of the coolant outlet. The coolant outlet is configured to communicate with a heat exchanger. The heat exchanger and the wiring terminal of the motor are disposed relative to each other along the first direction.

In this embodiment of this application, the axial direction of the coolant outlet is the third direction, and the coolant outlet and the direct-current input interface mounting hole are provided on different sides. This can avoid negative impact of the coolant on the direct-current input interface, to help improve safety performance. The heat exchanger and the wiring terminal of the motor are disposed relative to each other along the first direction. In other words, the heat exchanger is closer to the coolant outlet than to the coolant inlet. This helps shorten a transmission path of the coolant on an outer side the motor controller and improve cooling efficiency of the coolant.

In an embodiment, the heat exchanger is located above the reducer along the second direction. The heat exchanger is further configured to communicate with the reducer accommodating cavity and the motor accommodating cavity. The reducer accommodating cavity is configured to accommodate the reducer. The motor accommodating cavity is configured to accommodate the motor. Neither the reducer accommodating cavity nor the motor accommodating cavity communicates with the liquid cooling passage.

In this embodiment of this application, the heat exchanger is disposed in the powertrain, and the heat exchanger communicates with the reducer accommodating cavity and the motor accommodating cavity, so that the reducer and the motor can also be cooled, to ensure that the reducer and the motor work at an appropriate temperature. The heat exchanger is located above the reducer along the second direction, so that a cooling path between the heat exchanger and the reducer is short, to reduce thermal resistance of a heat dissipation path. The liquid cooling passage does not communicate with either of the reducer accommodating cavity and the motor accommodating cavity, so that the coolant in the liquid cooling passage does not flow into the reducer and the motor.

According to a second aspect, an embodiment of this application provides an electric vehicle, including a vehicle body, a battery pack, and the powertrain according to any one of the foregoing implementations. The powertrain is fastened to the vehicle body. The battery pack is connected to a motor controller through a direct-current input interface mounting hole. A wheel drive terminal in the powertrain is connected to a wheel of the vehicle in a transmission manner and is configured to provide power for the wheel. Various design requirements such as miniaturization, power density, reliability, heat dissipation performance, and power performance need to be comprehensively considered for the powertrain provided in this application, to improve overall performance of the electric vehicle.

### BRIEF DESCRIPTION OF DRAWINGS

To describe technical solutions in embodiments of this application more clearly, the following describes the accompanying drawings used in embodiments of this application.
FIG. 1 is a diagram of a structure of a vehicle according to an embodiment of this application;
FIG. 2 is a diagram of a structure of a powertrain according to an embodiment of this application;
FIG. 3 is a diagram of a partial structure of a powertrain according to an embodiment of this application;
FIG. 4 is a diagram of a partial structure of a powertrain according to an embodiment of this application;
FIG. 5 is a locally exploded diagram of a powertrain according to an embodiment of this application;
FIG. 6 is a locally enlarged diagram of an M1 part of the powertrain shown in FIG. 5;
FIG. 7 is a diagram of a partial structure of a powertrain according to an embodiment of this application;
FIG. 8 is a diagram of a structure of a powertrain according to an embodiment of this application;
FIG. 9 is a top view of a powertrain according to an embodiment of this application;
FIG. 10 is a locally exploded diagram of a powertrain according to an embodiment of this application;
FIG. 11 is a diagram of a structure of a powertrain according to an embodiment of this application;
FIG. 12 is a sectional view of the powertrain shown in FIG. 11 along AA;
FIG. 13 is a locally exploded diagram of a powertrain according to an embodiment of this application;
FIG. 14 is a locally enlarged diagram of an M2 part of the powertrain shown in FIG. 12;
FIG. 15 is a diagram of structures of a reducer input shaft and a motor shaft according to an embodiment of this application;
FIG. 16 is a sectional view of the reducer input shaft and the motor shaft shown in FIG. 15 along BB;
FIG. 17 is a diagram of a structure of an oil passing pipe according to an embodiment of this application;
FIG. 18 is a locally enlarged diagram of an M3 part of the powertrain shown in FIG. 13;
FIG. 19 is a diagram of a structure of a reducer end cover according to an embodiment of this application;
FIG. 20 is a diagram of a structure of an oil guide part according to an embodiment of this application;
FIG. 21 is a locally exploded diagram of a powertrain according to an embodiment of this application;
FIG. 22 is a diagram of a structure of a motor according to an embodiment of this application;
FIG. 23 is a sectional view of the motor shown in FIG. 22 along CC;
FIG. 24 is a locally enlarged diagram of an M4 part of the motor shown in FIG. 23;
FIG. 25 is a locally exploded diagram of a powertrain according to an embodiment of this application;
FIG. 26 is a locally enlarged diagram of an M5 part of the powertrain shown in FIG. 25;
FIG. 27 is a diagram of a structure of a motor end cover according to an embodiment of this application;
FIG. 28 is a diagram of a structure of a powertrain according to an embodiment of this application;
FIG. 29 is a sectional view of the powertrain shown in FIG. 28 along DD;
FIG. 30 is a locally enlarged diagram of an M6 part of the powertrain shown in FIG. 29;
FIG. 31 is a locally enlarged diagram of an M7 part of the motor end cover shown in FIG. 27;
FIG. 32 is a diagram of a structure of a powertrain according to an embodiment of this application;
FIG. 33 is a sectional view of the powertrain shown in FIG. 32 along EE;
FIG. 34 is a locally enlarged diagram of an M8 part of the powertrain shown in FIG. 33;
FIG. 35 is a locally enlarged diagram of an M9 part of the powertrain shown in FIG. 32;
FIG. 36 is a locally enlarged diagram of an M10 part of the motor end cover shown in FIG. 27;
FIG. 37 is a diagram of a structure of a powertrain according to an embodiment of this application;
FIG. 38 is a sectional view of the powertrain shown in FIG. 37 along FF;
FIG. 39 is a locally enlarged diagram of an M11 part of the powertrain shown in FIG. 38;
FIG. 40 is a locally enlarged diagram of an M12 part of the motor end cover shown in FIG. 27;
FIG. 41 is a locally enlarged diagram of an M13 part of the powertrain shown in FIG. 39;
FIG. 42 is a sectional view of the motor shown in FIG. 37 along FF;
FIG. 43 is a locally enlarged diagram of an M14 part of the motor shown in FIG. 42; and
FIG. 44 is a diagram of a structure of a motor end cover according to an embodiment of this application.

### DESCRIPTION OF EMBODIMENTS

The following describes the technical solutions in embodiments of this application with reference to the accompanying drawings in embodiments of this application. Apparently, the described embodiments are merely a part rather than all of embodiments of this application.

In this specification, terms such as "first" and "second" are merely intended for a purpose of description, and shall not be understood as an indication or implication of relative importance or an implicit indication of a quantity of indicated technical features. Therefore, a feature limited by "first" or "second" may explicitly or implicitly include one or more features. In the descriptions of this application, unless otherwise stated, "a plurality of" means two or more than two.

In addition, in this specification, orientation terms such as "up", and "down" are defined relative to orientations of schematic placement of structures in the accompanying drawings. It should be understood that these directional terms are relative concepts that are used for relative description and clarification and may correspondingly change according to a change in an orientation in which a structure is placed.

For ease of understanding, the following first explains and describes technical terms related to embodiments of this application.

Parallel: Parallel defined in this application is not limited to absolute parallel. A definition of parallel may be understood as basically parallel. This allows a non-absolute parallel case caused by factors such as an assembly tolerance, a design tolerance, and a structural flatness.

Perpendicular: Perpendicular defined in this application is not limited to an absolute perpendicular intersection (an included angle is 90 degrees) relationship. This allows a non-absolute perpendicular intersection relationship caused by factors such as an assembly tolerance, a design tolerance, and a structural flatness, and an error within a small angle range. For example, a relationship may be understood as a perpendicular relationship in an assembly error range in a range of 80 degrees to 100 degrees.

Surface roughness means unevenness of a surface with small distances and small peaks and valleys.

A first direction Y is parallel to a motor axial direction. The motor axial direction is an axial direction of a motor shaft.

A second direction Z is perpendicular to the first direction Y and a third direction X.

The third direction X is perpendicular to the first direction Y and the second direction Z.

To improve overall performance of an electric vehicle, various design requirements such as miniaturization, power density, reliability, heat dissipation performance, and power performance need to be comprehensively considered for a powertrain. A problem existing in a layout design of components in the powertrain and a structure design of the components not only affects miniaturization or heat dissipation performance of the powertrain, but also affects energy conversion efficiency and therefore reduce power density of the powertrain. In addition, this further affects an energy transmission path, thereby reducing reliability and power performance of the powertrain.

An embodiment of this application provides a powertrain arranged along a power flow. The powertrain includes an integrated housing, a motor, and a motor controller. The integrated housing includes a motor accommodating cavity, a controller accommodating cavity, a direct-current input interface mounting hole, and an alternating-current output interface mounting hole. The motor includes a motor shaft and a motor winding. The direct-current input interface mounting hole and the alternating-current output interface mounting hole are arranged relative to each other along a first direction. The alternating-current output interface mounting hole and a wiring terminal of the motor winding are arranged on one side along the first direction. The direct-current input interface mounting hole and an output end of the motor shaft are arranged on the other side along the first direction. In this way, an alternating current output from the alternating-current output interface mounting hole is input to the motor winding through the wiring terminal that is of the motor winding and that is arranged on the same side, so that an alternating-current energy input path is short.

A projection of the controller accommodating cavity partially overlaps a projection of the motor accommodating cavity along a second direction. A projection of the direct-current input interface mounting hole, a projection of the alternating-current output interface mounting hole, and a projection of the motor shaft do not overlap along a third direction. Any two of the first direction, the second direction, and third direction are perpendicular to each other. The powertrain provided in this embodiment of this application has a compact layout and complies with a flow direction of a power flow, to help shorten an energy transmission path, reduce an energy loss, and implement miniaturization and high power density of the powertrain.

The powertrain provided in this embodiment of this application is used in an electric vehicle, to improve overall performance of the electric vehicle.

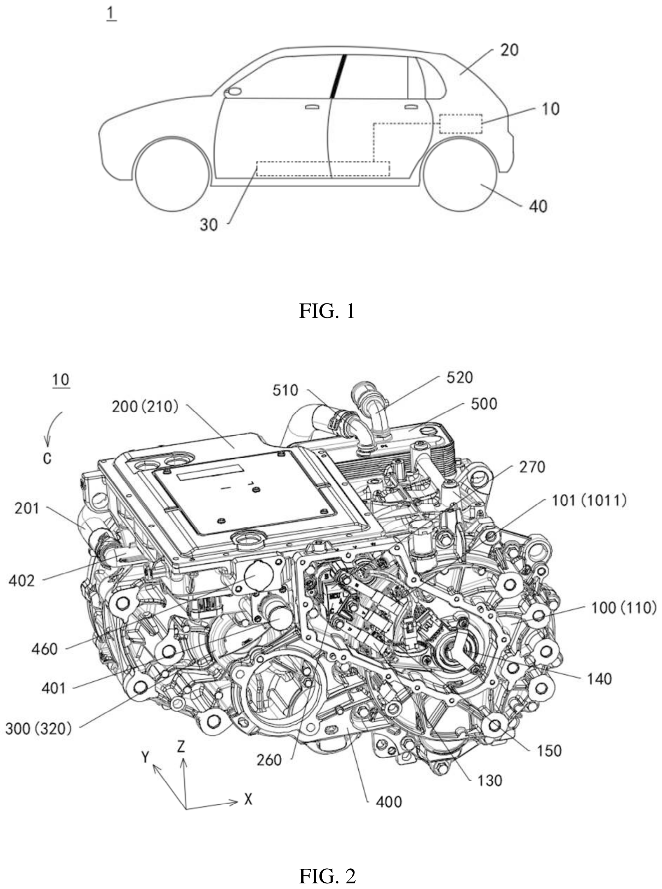

With reference to FIG. 1, FIG. 1 is a diagram of a structure of an electric vehicle 1 according to an embodiment of this application. In this embodiment of this application, the electric vehicle 1 includes a powertrain 10, a vehicle body 20, a battery pack 30, and wheels 40. The powertrain 10 and the battery pack 30 are fastened to the vehicle body 20. The powertrain 10 is configured to receive power supplied by the battery pack 30, and is configured to drive the wheels 40.

In this embodiment of this application, the battery pack 30 may be referred to as a power battery.

In this embodiment of this application, the electric vehicle 1 is a wheel-type device driven or pulled by a power apparatus. In an implementation, the electric vehicle 1 includes special-purpose vehicles such as a passenger vehicle, a commercial vehicle, an engineering rescue vehicle, a watering truck, a suction sewage truck, a cement mixer truck, a crane, and a medical vehicle. For example, the electric vehicle 1 includes an electric vehicle (Electric Vehicle, EV), a pure electric vehicle (Pure Electric Vehicle/Battery Electric Vehicle, PEV/BEV), a hybrid electric vehicle (Hybrid Electric Vehicle, HEV for short), a range-extended electric vehicle (Range-Extended Electric Vehicle, REEV), a plug-in hybrid electric vehicle (Plug-in Hybrid Electric Vehicle, PHEV), a new energy vehicle (New Energy Vehicle), and the like.

In this embodiment of this application, the electric vehicle 1 includes one or more powertrains 10. In an embodiment, the electric vehicle 1 is a front-wheel-drive or rear-wheel-drive vehicle. The electric vehicle 1 includes one powertrain 10. The powertrain 10 is configured to connect to front wheels or rear wheels of the electric vehicle 1 in a transmission manner. In an embodiment, the electric vehicle 1 is a front and rear dual drive vehicle. The electric vehicle 1 includes two powertrains 10. One of the two powertrains 10 is configured to connect to front wheels of the electric vehicle 1 in a transmission manner, and the other one of the two powertrains 10 is configured to connect to rear wheels of the electric vehicle 1 in a transmission manner. In an embodiment, the electric vehicle 1 is a four-wheel drive vehicle. The electric vehicle 1 includes four powertrains 10. The four powertrains 10 are respectively configured to connect to four wheels of the electric vehicle 1 in a transmission manner.

The following describes in detail the powertrain 10 provided in this embodiment of this application.

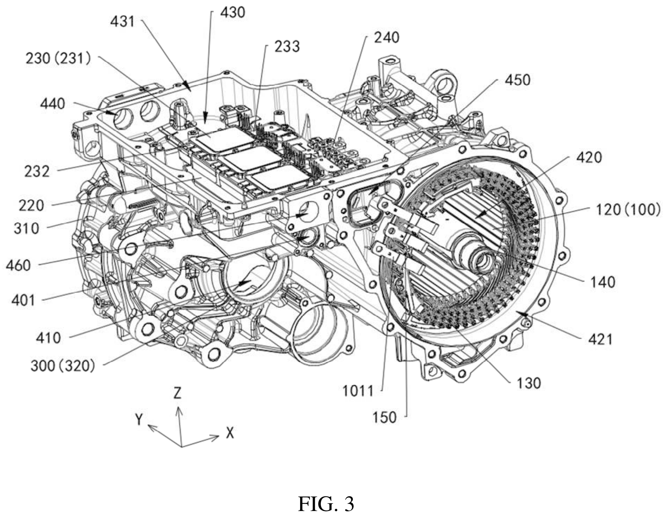

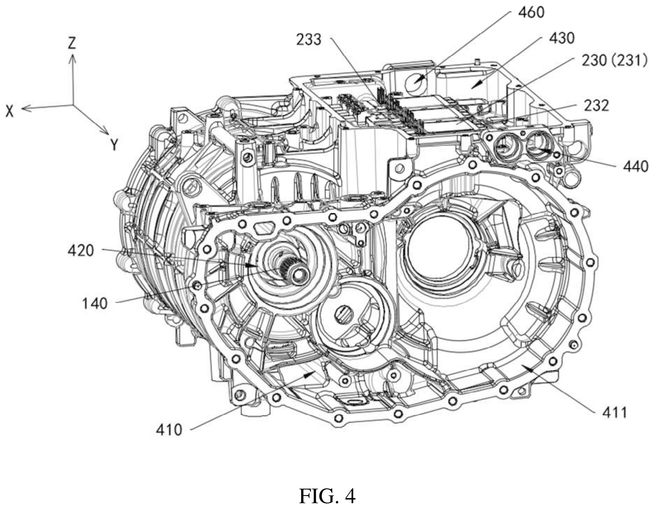

With reference to FIG. 2 to FIG. 4, FIG. 2 is a diagram of a structure of a powertrain 10 according to an embodiment of this application, FIG. 3 is a diagram of a partial structure of a powertrain 10 according to an embodiment of this application, and FIG. 4 is a diagram of a partial structure of a powertrain 10 according to an embodiment of this application.

As shown in FIG. 2, the powertrain 10 includes a motor 100, a motor controller 200, and a reducer 300 (as shown in FIG. 3). The motor controller 200 is configured to receive a direct current of the battery pack 30, and is configured to output an alternating current to the motor 100. The motor 100 is configured to receive the alternating current output by the motor controller 200, and is configured to drive the wheels 40 of the electric vehicle 1. The reducer 300 is configured to transmit power of the motor 100 to the wheels 40.

As shown in FIG. 3, the motor 100 includes a motor stator 120, a motor winding 130, a motor shaft 140, and a motor rotor (not shown). An alternating flux generated by the motor winding 130 Interacts with a permanent flux generated by the motor rotor, so that the motor rotor rotates relative to the motor stator 120. The motor rotor is fixedly connected to the motor shaft 140, so that the motor shaft 140 rotates with the rotor. The motor stator 120 is rotationally connected to the motor shaft 140, so that the motor shaft 140 can rotate relative to the motor stator 120. In this way, electric energy is converted into mechanical energy. An output end of the motor shaft 140 is configured to transmit the mechanical energy.

With reference to FIG. 3 and FIG. 4, an integrated housing 400 includes a reducer accommodating cavity 410, a motor accommodating cavity 420, and a controller accommodating cavity 430.

In this embodiment of this application, the motor accommodating cavity 420 is configured to accommodate the motor 100. As shown in FIG. 4, the motor accommodating cavity 420 penetrates the integrated housing 400 along the first direction Y. The motor stator 120 is fixedly nested in the motor accommodating cavity 420.

In this embodiment of this application, the reducer accommodating cavity 410 is configured to accommodate the reducer 300, the reducer accommodating cavity 410 communicates with the motor accommodating cavity 420, and the motor shaft 140 of the motor 100 is fastened to a reducer input shaft of the reducer 300.

In this embodiment of this application, the controller accommodating cavity 430 is configured to accommodate the motor controller 200. With reference to FIG. 3 and FIG. 4, the controller accommodating cavity 430 and the motor accommodating cavity 420 are arranged along the second direction Z. In this embodiment of this application, the motor controller 200 is configured to receive the direct current of the battery pack 30, and is configured to output the alternating current to the motor 100.

In this embodiment of this application, the integrated housing 400 is configured to accommodate the motor 100, the motor controller 200, and the reducer 300. The motor 100 is located in the motor accommodating cavity 420 of the integrated housing 400. The motor controller 200 is located in the controller accommodating cavity 430 of the integrated housing 400, and the reducer 300 is located in the reducer accommodating cavity 410 of the integrated housing 40.

In an embodiment, the motor 100 and the motor controller 200 share the integrated housing 400. The integrated housing 400 includes a motor housing. The motor housing encloses and forms the motor accommodating cavity 42. In other words, a part that is of the integrated housing 400 and that encloses and forms the motor accommodating cavity 420 forms the motor housing of the motor 100. The integrated housing 400 includes a controller housing. The controller housing encloses and forms the controller accommodating cavity 430. In other words, a part that is of the integrated housing 400 and that encloses and forms the controller accommodating cavity 430 forms the controller housing of the motor controller 200.

In an embodiment, the motor 100, the motor controller 200, and the reducer 300 share the integrated housing 400. The integrated housing 400 includes a motor housing, a controller housing, and a reducer housing. The motor housing encloses and forms the motor accommodating cavity 420. The controller housing encloses and forms the controller accommodating cavity 430. The reducer housing encloses and forms the reducer accommodating cavity 410. In an embodiment, the motor housing and the controller housing are an integrally formed structure, or the integrated housing 400 is an integrally formed structure. In an embodiment, the motor housing and the controller housing share adjacent parts of the housing. In an embodiment, the motor housing, the controller housing, and the reducer housing are an integrally formed structure.

In the powertrain 10 provided in this embodiment of this application, the integrated housing 400 is configured to accommodate the motor 100, the motor controller 200, and the reducer 300. In comparison with a split powertrain 10, integration of the powertrain 10 can be improved. In this way, space utilization of the powertrain 10 is increased, and costs are reduced. In addition, in the integrated housing 400 of the powertrain 10 provided in this embodiment of this application, the controller accommodating cavity 430 and the motor accommodating cavity 420 are arranged in the second direction Z, and the controller accommodating cavity 430 and the motor accommodating cavity 420 partially overlap in the third direction X, to help reduce space occupied by the powertrain 10 in the second direction Z.

With reference to FIG. 2, FIG. 3, FIG. 4, and FIG. 5, in an embodiment, the integrated housing 400 further includes a direct-current input interface mounting hole 440 and an alternating-current output interface mounting hole 450.

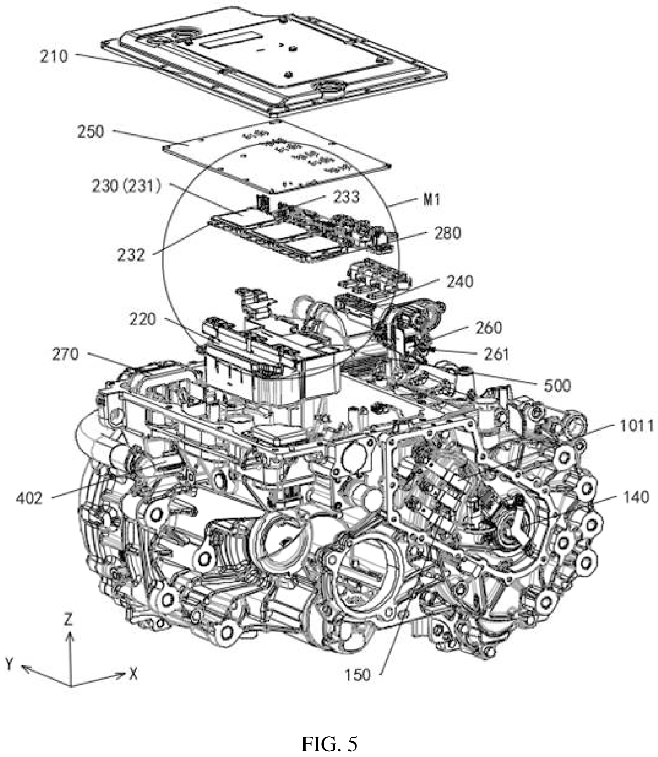

As shown in FIG. 5, the motor controller 200 further includes a direct-current input interface 270. The direct-current input interface mounting hole 440 is configured to fasten the direct-current input interface 270. The direct-current input interface 270 is configured to electrically connect to the battery pack 30 to receive the direct current.

As shown in FIG. 2 and FIG. 5, the motor controller 200 further includes an alternating-current output interface 260. The alternating-current output interface mounting hole 450 is configured to fasten the alternating-current output interface 260.

In this embodiment of this application, the alternating-current output interface is configured to electrically connect to a wiring terminal of the motor winding 130 through an input copper bar 1011. The input copper bar 1011, the alternating-current output interface mounting hole 450, and the wiring terminal of the motor winding 130 are arranged on the side along the first direction Y. A length direction of the input copper bar 1011 intersects the first direction Y, the second direction Z, and the third direction X.

As shown in FIG. 5, the alternating-current output interface 260 is configured to electrically connect a copper bar assembly 240 to three input copper bars 1011. In this embodiment of this application, the alternating-current output interface 260 includes three wiring ports 261. The three wiring ports 261 are electrically connected to the wiring terminal of the motor winding 130 respectively through three input copper bars 1011. The three input copper bars 1011 are spaced and arranged. An arrangement direction of the three input copper bars 1011 intersects both the first direction and the second direction.

In this embodiment of this application, the motor controller 200 receives, through the direct-current input interface 270, power supplied by the battery pack 30, and outputs the alternating current to the motor winding 130 of the motor 100 through the alternating-current output interface 260. The motor winding 130 of the motor 100 generates an alternating flux after the alternating current is supplied.

With reference to FIG. 3 and FIG. 4, the wiring terminal of the motor winding 130 and the output end of the motor shaft 140 are arranged relative to each other along the first direction Y. The direct-current input interface mounting hole 440 and the alternating-current output interface mounting hole 450 separately penetrate the integrated housing 400 along the first direction Y and communicate with the controller accommodating cavity 430.

In this embodiment of this application, the direct-current input interface mounting hole 440 and the alternating-current output interface mounting hole 450 are arranged relative to each other along the first direction Y. Along the first direction Y, the alternating-current output interface mounting hole 450 and the wiring terminal of the motor winding 130 are arranged on one side along the first direction Y. Along the first direction Y, the direct-current input interface mounting hole 440 and the output end of the motor shaft 140 are arranged on the other side along the first direction Y. A projection of the direct-current input interface mounting hole 440 and a projection of the alternating-current output interface mounting hole 450 do not overlap a projection of the motor shaft 140 along the third direction X.

Still with reference to FIG. 3, in this embodiment of this application, energy transmission sequentially passes through the direct-current input interface 270 in the direct-current input interface mounting hole 440, the motor controller 200, the alternating-current output interface 260 in the alternating-current output interface mounting hole 450, the wiring terminal of the motor winding 130, and the output end of the motor shaft 140.

In this embodiment of this application, the direct-current input interface mounting hole 440 and the alternating-current output interface mounting hole 450 are provided relative to each other along the first direction Y, and are respectively located at two ends of the controller accommodating cavity 430 along the first direction Y. The direct-current input interface 270 configured to transmit the direct current to the motor controller 200 is mounted in the direct-current input interface mounting hole 440 and extends to an inner side of the controller accommodating cavity 430. In other words, the motor controller 200 is electrically connected to the battery pack 30 through the direct-current input interface 270. In an embodiment, the direct-current input interface 270 (as shown in FIG. 5) of the motor controller 200 is installed in the direct-current input interface mounting hole 440. The alternating-current output interface 260 configured to transmit the alternating current to the motor 100 may be mounted in the alternating-current output interface mounting hole 450 and extends to an outer side of the controller accommodating cavity 430. In other words, the motor controller 200 is electrically connected to the motor 100 through the alternating-current output interface 260. In this embodiment of this application, the direct-current input interface mounting hole 440 and the alternating-current output interface mounting hole 450 are provided relative to each other along the first direction Y, to avoid electrical interference generated in a transmission process of the direct current and the alternating current, thereby improving security performance. In this way, the alternating-current output interface mounting hole 450 and the motor 100 are adjacently provided, to help shorten a distance between the motor controller 200 and the wiring terminal of the motor 100.

In this embodiment of this application, the motor winding 130 is connected to the motor controller 200 through an electrical connecting piece 150 (as shown in FIG. 5). The wiring terminal of the motor winding 130 is configured to receive the alternating current transmitted by the motor controller 200. The wiring terminal of the motor winding 130 and the alternating-current output interface mounting hole 450 are adjacently provided and are located on a same side of the controller accommodating cavity 430. In this way, a transmission path of energy between the motor controller 200 and the motor 100 is short, and impedance becomes smaller. This helps reduce an energy loss on the transmission path and improve energy transmission efficiency. In addition, a layout of the motor controller 200 and the motor 100 is compact and orderly, to help reduce a volume of the powertrain 10 and optimize a layout of a whole vehicle. The wiring terminal of the motor winding 130 and the output end of the motor shaft 140 are disposed relative to each other along the first direction Y. The output end of the motor shaft 140 and the direct-current input interface mounting hole 440 are provided on a same side. In other words, an axial direction of the motor shaft 140 is parallel to an arrangement direction of the direct-current input interface mounting hole 440 and an alternating-current output interface 260, to help reduce a volume of the powertrain 10.

In the powertrain 10 provided in this embodiment of this application, the motor 100 and the motor controller 200 are both disposed in the integrated housing 400, to increase integration of the powertrain 10 and reduce the volume and costs. This helps implement a lightweight design of the powertrain 10 and improve power density. In addition, in the powertrain 10 provided in this embodiment of this application, a layout design of the direct-current input interface mounting hole 440, the alternating-current output interface mounting hole 450, the wiring terminal of the motor winding 130, and the output end of the motor shaft 140 complies with a flow direction of a power flow, to shorten an energy transmission path in the powertrain 10 and help reduce an energy loss in a transmission process.

With reference to FIG. 5, FIG. 5 is a locally exploded diagram of a powertrain 10 according to an embodiment of this application. In an embodiment, the motor controller 200 includes a capacitor module 220, a power module 230, and the copper bar assembly 240 (as shown in FIG. 5). The power module 230 and the capacitor module 220 are configured to receive the direct current. The power module 230 is configured to output the alternating current through the copper bar assembly 240. The controller accommodating cavity 430 is configured to accommodate the capacitor module 220, the power module 230, and the copper bar assembly 240 (as shown in FIG. 5).

In this embodiment of this application, the capacitor module 220 and the power module 230 are stacked along the second direction Z. The copper bar assembly 240 and the power module 230 are adjacently arranged along the third direction X. A distance between the power module 230 and the motor shaft 140 is greater than a distance between the copper bar assembly 240 and the motor shaft 140 along a radial direction of the motor 100.

The capacitor module 220 is configured to transmit the direct current, and adjust the direct current. In an embodiment, the capacitor module 220 is configured to smooth a voltage, so that the voltage is still smooth in the power module 230. The capacitor module 220 may further reduce an inductance parameter, weaken a peak voltage, absorb a high pulse current, avoid impact of voltage overcharge and a transient voltage on the motor controller 200, and the like.

The power module 230 is a combination of power electronic devices that can implement a power conversion function. The power electronic devices include an insulated gate bipolar transistor (Insulated Gate Bipolar Transistor, IGBT), a silicon carbide power tube, a silicon tube, a metal-oxide semiconductor field-effect transistor (Metal-Oxide-Semiconductor Field-Effect Transistor, MOSFET), a diode, and the like. The copper bar assembly 240 is configured to transmit the alternating current output by the power module 230.

Still with reference to FIG. 3, in an embodiment, a projection of the direct-current input interface mounting hole 440 at least partially overlaps a projection of the capacitor module 220 along the first direction Y. In this embodiment of this application, energy transmission sequentially passes through the direct-current input interface mounting hole 440, the capacitor module 220, the power module 230, and the alternating-current output interface mounting hole 450. The direct-current input interface mounting hole 440 and the alternating-current output interface mounting hole 450 are provided relative to each other along the first direction Y. In other words, a flow direction of a power flow between the direct-current input interface mounting hole 440 and the alternating-current output interface mounting hole 450 is the first direction Y. In this solution, the projection of the direct-current input interface mounting hole 440 is set to at least partially overlap the projection of the capacitor module 220. In this way, an energy transmission path between the direct-current input interface mounting hole 440 and the capacitor module 220 is short, to help reduce an energy loss in the motor controller 200.

It should be noted that a projection along the first direction Y is a projection on a projection surface perpendicular to the first direction Y along the first direction Y in this embodiment of this application. The projection surface of the projection along the first direction Y is perpendicular to the first direction Y. A projection along the second direction Z is a projection on a projection surface perpendicular to the second direction Z along the second direction Z. The projection surface of the projection along the second direction Z is perpendicular to the second direction Z. A projection along the third direction X is a projection on a projection surface perpendicular to the third direction X along the third direction X. The projection surface of the projection along the third direction X is perpendicular to the third direction X.

In an embodiment, a projection surface of a projection of the direct-current input interface mounting hole 440 along the first direction Y is the same as a projection surface of a projection of the capacitor module 220 along the first direction Y. The projection of the direct-current input interface mounting hole 440 along the first direction Y is a projection of a region enclosed by a hole wall of the direct-current input interface mounting hole 440 along the first direction Y.

In an embodiment, the projection of the direct-current input interface mounting hole 440 at least partially overlaps a projection of the power module 230 (as shown in FIG. 3). This solution helps shorten an energy transmission path between the direct-current input interface mounting hole 440 and the power module 230, thereby reducing an energy loss in the motor controller 200.

In an embodiment, the projection of the direct-current input interface mounting hole 440 at least partially overlaps both a projection of the capacitor module 220 and a projection of the power module 230 (as shown in FIG. 3). This solution helps shorten an energy transmission path among the direct-current input interface mounting hole 440, the capacitor module 220, and the power module 230, thereby reducing an energy loss in the motor controller 200.

In an embodiment, the projection of the alternating-current output interface mounting hole 450 at least partially overlaps a projection of the capacitor module 220 along the first direction Y. The projection of the alternating-current output interface mounting hole 450 along the first direction Y is a projection of a region enclosed by a hole wall of the alternating-current output interface mounting hole 450 along the first direction Y. In this solution, the projection of the alternating-current output interface mounting hole 450 is set to at least partially overlap the projection of the capacitor module 220. In this way, an energy transmission path between the alternating-current output interface mounting hole 450 and the capacitor module 220 is short, to help reduce an energy loss in the motor controller 200.

In an embodiment, the projection of the alternating-current output interface mounting hole 450 at least partially overlaps a projection of the power module 230. This solution helps shorten an energy transmission path between the alternating-current output interface mounting hole 450 and the power module 230, thereby reducing an energy loss in the motor controller 200.

In an embodiment, the projection of the alternating-current output interface mounting hole 450 at least partially overlaps both a projection of the capacitor module 220 and a projection of the power module 230. This solution helps shorten an energy transmission path among the alternating-current output interface mounting hole 450, the capacitor module 220, and the power module 230, thereby reducing an energy loss in the motor controller 200.

In an embodiment, the projection of the alternating-current output interface mounting hole 450 does not overlap a projection of the power module 230 or the capacitor module 220. The alternating-current output interface mounting hole 450 is provided close to the motor shaft 140, to help provide installation space for a connection between the power module 230 and the copper bar assembly 240.

In an embodiment, the capacitor module 220 and the power module 230 are stacked along the second direction Z (as shown in FIG. 3), and the copper bar assembly 240 and the power module 230 are adjacently arranged along the third direction X (as shown in FIG. 3 or FIG. 5). The third direction X is perpendicular to the first direction Y and the second direction Z. In this embodiment of this application, the capacitor module 220 and the power module 230 are stacked along the second direction Z, and the copper bar assembly 240 and the power module 230 are adjacent along the third direction X. In comparison with a case in which the capacitor module 220, the power module 230, and the copper bar assembly 240 are laid along the first direction Y, this solution helps reduce a dimension value of the motor controller 200 in the first direction Y, thereby reducing a volume of the powertrain 10. This helps connect the capacitor module 220 and the power module 230 along the second direction Z, shorten a connection path, and reduce energy consumption of power transmission, to implement a smooth power flow between the capacitor module 220 and the power module 230.

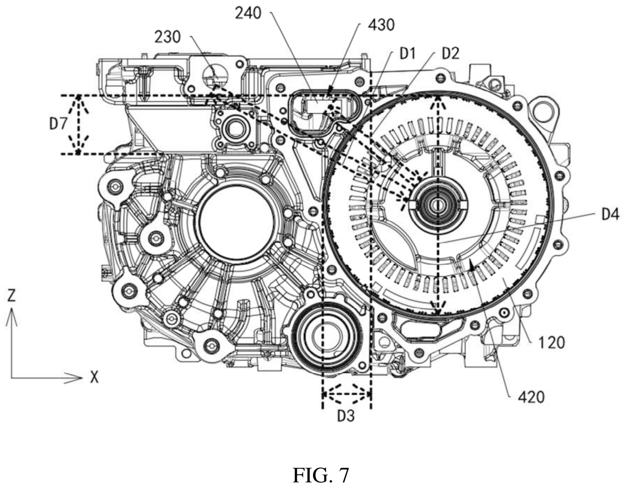

With reference to FIG. 7, FIG. 7 is a diagram of a partial structure of a powertrain 10 according to an embodiment of this application. In an embodiment, the distance between the power module 230 and the motor shaft 140 is greater than the distance between the copper bar assembly 240 and the motor shaft 140 along the motor radial direction R. The motor radial direction R is a radial direction of the motor shaft 140. In this embodiment of this application, along the motor radial direction R, the distance between the power module 230 and the motor shaft 140 is D1, and the distance between the copper bar assembly 240 and the motor shaft 140 is D2. D1>D2 is set. In other words, the copper bar assembly 240 is closer to the motor shaft 140 than the power module 230, to help shorten a distance between the copper bar assembly 240 and the wiring terminal of the motor winding 130. Because there is an electrical connection relationship between the copper bar assembly 240 and the wiring terminal of the motor winding 130, the distance between the copper bar assembly 240 and the wiring terminal of the motor winding 130 is set to be small, so that the layout complies with a flow direction of a power flow, thereby reducing an energy loss. This solution further helps reduce a space volume occupied by the motor controller 200 and the motor 100 and improve integration and power density of the powertrain 10.

It should be understood that FIG. 7 and related description content of FIG. 7 schematically describe a layout design, for example, positions of and distances between main components such as the motor shaft 140, the power module 230, and the copper bar assembly 240 in the powertrain 10; and a structural design, for example, shapes and dimensions of the main components. For a layout design and a structural design of another component in the powertrain 10, refer to the figures in embodiments of this application. Details are not described.

Still with reference to FIG. 5, in an embodiment, the motor controller 200 further includes a circuit board 250. The circuit board 250 is electrically connected to the power module 230. Along the second direction Z, the circuit board 250, the capacitor module 220, and the power module 230 are stacked, a projection of any one of the capacitor module 220, the power module 230, and the circuit board 250 does not overlap the copper bar assembly 240, and a projection of the motor shaft 140 does not overlap the projection of any one of the capacitor module 220, the power module 230, and the circuit board 250.

In this embodiment of this application, because a surface of the circuit board 250 usually has a large area, in comparison with a case in which the capacitor module 220, the power module 230, and the circuit board 250 are laid along the third direction X or the first direction Y, this solution helps reduce a space volume occupied by the motor controller 200 by sequentially stacking the circuit board 250, the power module 230, and the capacitor module 220 along the second direction Z.

In this embodiment of this application, the projection of the copper bar assembly 240 does not overlap the projection of any one of the capacitor module 220, the power module 230, and the circuit board 250 in the second direction Z. In other words, the copper bar assembly 240 is not stacked with the capacitor module 220, the power module 230, and the circuit board 250 along the second direction Z, to reduce interference caused by power transmitted by the copper bar assembly 240 to signal quality of the circuit board 250.

The copper bar assembly 240 is electrically connected to the power module 230. The copper bar assembly 240 is configured to transmit the alternating current output by the power module 230. The copper bar assembly 240 may be disposed on a side that is of the power module 230 and that is close to the motor shaft 140 along the third direction X. Components in the motor controller 200 are appropriately arranged, to avoid an excessively large dimension value of the motor controller 200 in the second direction Z. This further helps an electrical connection between the copper bar assembly 240 and the motor 100 configured to receive the alternating current, to comply with the flow direction of the power flow. In this embodiment of this application, the projection of the motor shaft 140 does not overlap the projection of any one of the capacitor module 220, the power module 230, and the circuit board 250 in the second direction Z, to help reduce a dimension value of the powertrain 10 in the second direction Z.

In an embodiment, the motor controller 200 further includes a radiator 280, the capacitor module 220, , the power module 230, and the circuit board 250 that are stacked along the second direction Z. The radiator 280 is configured to dissipate heat for the power module 230. In this embodiment of this application, according to a layout design of each component in the motor controller 200, lengths of the first direction Y and the third direction X can be reduced, to shorten a connection path between the capacitor module 220 and the power module 230, thereby reducing energy consumption of power transmission.

With reference to FIG. 3 and FIG. 7, in an embodiment, the projection of the motor shaft 140 does not overlap the projection of any one of the capacitor module 220, the power module 230, and the circuit board 250 (as shown in FIG. 3 and FIG. 7) along the third direction X, and the controller accommodating cavity 430 at least partially overlaps the motor accommodating cavity 420 in the third direction X (as shown in FIG. 3 and FIG. 7). A length of an overlapping part between the controller accommodating cavity 430 and the motor accommodating cavity 420 in the third direction X is less than an outside diameter of the motor stator 120 (as shown in FIG. 7). In this embodiment of this application, the projection of the motor shaft 140 does not overlap the projection of any one of the capacitor module 220, the power module 230, and the circuit board 250 in the third direction X, to help reduce a dimension value of the powertrain 10 in the third direction X. The controller accommodating cavity 430 and the motor accommodating cavity 420 are arranged along the second direction Z and partially overlap along the third direction X, to reduce a total dimension value of the motor controller 200 and the motor 100 in the second direction Z. A dimension value of the overlapping part between the controller accommodating cavity 430 and the motor accommodating cavity 420 in the third direction X is D3. The outside diameter of the motor stator 120 is D4. The motor stator 120 is fixedly nested in the motor accommodating cavity 420. D3<D4 is set in this solution. Therefore, the projection of the controller accommodating cavity 430 does not fully overlap the projection of the motor accommodating cavity 420 in the third direction X, to provide space for disposing another component or apparatus below the controller accommodating cavity 430, thereby improving space utilization of the powertrain 10. In an embodiment, D3<0.5D4.

In an embodiment, the controller accommodating cavity 430 at least partially overlaps the motor accommodating cavity 420 in the second direction Z (as shown in FIG. 3 and FIG. 7). A length D7 of an overlapping part between the controller accommodating cavity 430 and the motor accommodating cavity 420 in the second direction Z is less than the outside diameter D4 of the motor stator 120. In an embodiment, D7<0.5D4.

Still with reference to FIG. 5, in an embodiment, the power module 230 includes a plurality of bridge arm components 231. The plurality of bridge arm components 231 are configured to form an inverter circuit to convert a direct current into an alternating current. Along the first direction Y, the plurality of bridge arm components 231 are sequentially and adjacently arranged, projections of the plurality of bridge arm components 231 do not overlap a projection of the alternating-current output interface mounting hole 450, and the projections of the plurality of bridge arm components 231 overlap a projection of the direct-current input interface mounting hole 440. A projection of the capacitor module 220 covers projections of the plurality of bridge arm components 231 along the second direction Z.

In this embodiment of this application, the projections of the direct-current input interface mounting hole 440 and the alternating-current output interface mounting hole 450 at most partially overlap in the first direction Y. The capacitor module 220 is electrically connected to the battery pack 30 through the direct-current input interface mounting hole 440. The capacitor module 220 and the power module 230 are stacked. In this solution, the projections of the plurality of bridge arm components 231 are set to overlap the projection of the direct-current input interface mounting hole 440 along the first direction Y. In this way, an energy transmission path from the direct-current input interface 270 in the direct-current input interface mounting hole 440 to the bridge arm components 231 is short, to help reduce an energy loss.

In this embodiment of this application, the copper bar assembly 240 transmits the alternating current through the alternating-current output interface 260 in the alternating-current output interface mounting hole 450. The projection of the copper bar assembly 240 does not overlap the projections of the bridge arm components 231 in the second direction Z. In this solution, the projections of the plurality of bridge arm components 231 are set to not overlap the projection of the alternating-current output interface mounting hole 450 along the first direction Y, to provide a precondition for reducing an energy loss between the copper bar assembly 240 and the alternating-current output interface 260 in the alternating-current output interface mounting hole 450. The capacitor module 220 and the power module 230 are stacked along the second direction Z. The projection of the capacitor module 220 in the second direction Z covers the projections of the plurality of bridge arm components 231 along the second direction Z, so that the capacitor module 220 can support the bridge arm components 231.

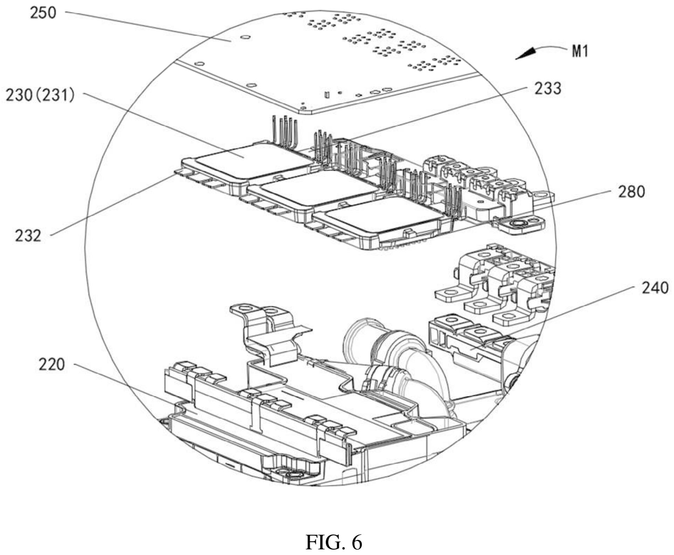

Still with reference to FIG. 3, FIG. 5, and FIG. 6, FIG. 6 is a locally enlarged diagram of an M1 part of the powertrain 10 shown in FIG. 5. The direct-current input interface mounting hole 440 is configured to fasten the direct-current input interface 270. The direct-current input interface 270 is configured to connect to the battery pack 30 to receive the direct current. In an embodiment, two ends of the three bridge arm components 231 are respectively configured to electrically connect to a positive electrode and a negative electrode of the direct-current input interface 270 through two first connecting pieces 232. A bridge arm midpoint of each bridge arm component 231 is configured to connect to the copper bar assembly 240 through a second connecting piece 233. The three bridge arm components 231 output the three phases of alternating currents to the copper bar assembly 240 through the three second connecting pieces 233. The two first connecting pieces 232 are spaced and arranged in the controller accommodating cavity 430 along the first direction Y. Projections of the two first connecting pieces 232 at least partially overlap the projection of the direct-current input interface mounting hole 440 along the first direction Y. The three second connecting pieces 233 are spaced and arranged in the controller accommodating cavity 430 along the first direction Y. Projections of the three second connecting pieces 233 at least partially overlap the projection of the alternating-current output interface mounting hole 450 along the first direction Y.

In this embodiment of this application, the power module 230 includes the three bridge arm components 231. Each bridge arm component 231 includes two first connecting pieces 232 and one second connecting piece 233. The first connecting pieces 232 and the second connecting piece 233 are respectively located on two sides of the bridge arm component 231 along the third direction X. The battery pack 30 transmits the direct current to the first connecting pieces 232 of the three bridge arm components 231 through the direct-current input interface 270 and the capacitor module 220. After converting the direct current into the alternating current, the three bridge arm components 231 sequentially transmit the alternating current to the copper bar assembly 240 and the alternating-current output interface 260 in the alternating-current output interface mounting hole 450 through the second connecting pieces 233.

In this embodiment of this application, the two first connecting pieces 232 of each bridge arm component 231 are spaced and arranged along the first direction Y, and a projection of the first connecting piece 232 at least partially overlaps a projection of the direct-current input interface 270 in the first direction Y. Because there is an electrical connection relationship between the first connecting piece 232 and the direct-current input interface 270, this solution helps shorten an energy transmission path between the first connecting piece 232 and the direct-current input interface 270. The three second connecting pieces 233 of the three bridge arm components 231 are spaced and arranged along the first direction Y. A projection of the second connecting piece 233 at least partially overlaps a projection of the alternating-current output interface 260 in the first direction Y. Because the second connecting piece 233 is directly electrically connected to the copper bar assembly 240, the alternating current is transmitted from the second connecting piece 233 to the alternating-current output interface 260 in the alternating-current output interface mounting hole 450 through the copper bar assembly 240. This solution further helps reduce an energy loss between the second connecting piece 233 and the alternating-current output interface 260 in the alternating-current output interface mounting hole 450.

In this embodiment of this application, the integrated housing 400 further includes a power interface mounting hole 460. The power interface mounting hole 460 is configured to fasten a power interface. The power interface is configured to electrically connect to an external power supply.

In this embodiment of this application, the motor controller 200 and the motor 100 in the powertrain 10 may form a voltage conversion circuit. The voltage conversion circuit may receive power supplied by the external power supply through the power interface and charge the battery pack 30. In an embodiment, a voltage of the external power supply is greater than a charging voltage of the battery pack 30, and the voltage conversion circuit including the motor controller 200 and the motor 100 is configured to perform step-down conversion. In an embodiment, a voltage of the external power supply is less than a charging voltage of the battery pack 30, and the voltage conversion circuit including the motor controller 200 and the motor 100 is configured to perform step-up conversion.

In an embodiment, a positive electrode of the power interface is configured to electrically connect one phase of the copper bar assembly 240 to a positive electrode of the external power supply, and a negative electrode of the power interface is configured to electrically connect to a positive electrode of the battery pack 30 through the direct-current input interface mounting hole 440. In an embodiment, a negative electrode of the power interface is configured to electrically connect one phase of the copper bar assembly 240 to a negative electrode of the external power supply, and a positive electrode of the power interface is configured to electrically connect to a positive electrode of the battery pack 30 through the direct-current input interface 270 in the direct-current input interface mounting hole 440.

In this embodiment of this application, the power interface mounting hole 460 penetrates the integrated housing 400 along the first direction Y and communicates with the controller accommodating cavity 430. The power interface mounting hole 460 and the direct-current input interface mounting hole 440 are arranged relative to each other along the first direction Y. Along the first direction Y, the power interface mounting hole 460, the alternating-current output interface mounting hole 450, and the wiring terminal of the motor winding 130 are arranged on one side along the first direction Y. The power interface mounting hole 460 and the alternating-current output interface mounting hole 450 are adjacently arranged along the third direction X. A distance between the alternating-current output interface mounting hole 450 and the motor shaft 140 is greater than a distance between the power interface mounting hole 460 and the motor shaft 140 along the radial direction of the motor 100.

In an embodiment, the external power supply charges the battery pack 30 through the power interface, the motor controller 200, and the direct-current input interface 270 in the direct-current input interface mounting hole 440, and the power interface mounting hole 460 and the direct-current input interface mounting hole 440 are arranged relative to each other along the first direction Y, to help shorten a transmission path between the power interface mounting hole 460 and the direct-current input interface 270 in the direct-current input interface mounting hole 440, thereby reducing an energy loss in a charging process. In an embodiment, the power interface mounting hole 460 and the direct-current input interface mounting hole 440 are arranged relative to each other along the first direction Y, and the power interface mounting hole 460 and the alternating-current output interface mounting hole 450 are spaced and arranged along the third direction X, to facilitate electrical isolation.

Still with reference to FIG. 3 and FIG. 7, in an embodiment, the alternating-current output interface mounting hole 450 is located between the power interface mounting hole 460 and the motor shaft 140 along the second direction Z, and the alternating-current output interface mounting hole 450 is located between the power interface mounting hole 460 and the motor shaft 140 along the third direction X. The third direction X is perpendicular to the first direction Y and the second direction Z. In this embodiment of this application, the alternating-current output interface mounting hole 450 is closer to the motor 100 than the power interface mounting hole 460 in the second direction Z and the third direction X. Because there is an electrical connection relationship between the alternating-current output interface 260 in the alternating-current output interface mounting hole 450 and the wiring terminal of the motor winding 130, this solution helps shorten an energy transmission path. A layout of the motor controller 200 and the motor 100 is more compact, to help reduce a space volume of the powertrain 10 and improve power density.

Still with reference to FIG. 3, in an embodiment, the alternating-current output interface 260 is electrically connected to the input copper bar 1011 through the alternating-current output interface 260 in the alternating-current output interface mounting hole 450, the input copper bar 1011 is configured to electrically connect to the wiring terminal of the motor winding 130, and the input copper bar 1011 and the direct-current input interface mounting hole 440 are arranged relative to each other along the first direction Y. Along the second direction Z, a height of an end that is of the input copper bar 1011 and that is close to the alternating-current output interface mounting hole 450 is greater than a height of an end that is of the input copper bar 1011 and that is connected to the wiring terminal of the motor winding 130. An extension direction of the input copper bar 1011 is perpendicular to the first direction Y. An angle value of an included angle between the extension direction of the input copper bar 1011 and the second direction Z is less than 90°.

In this embodiment of this application, the alternating-current output interface 260, the input copper bar 1011, and the wiring terminal of the motor winding 130 are sequentially electrically connected. The alternating-current output interface mounting hole 450 and the input copper bar 1011 are arranged relative to each other along the first direction Y, so that the alternating current output by the motor controller 200 is transmitted to the input copper bar 1011. The input copper bar 1011 includes a first end and a second end that are disposed relative to each other. The first end of the input copper bar 1011 is configured to electrically connect to the alternating-current output interface 260, and the second end of the input copper bar 1011 is configured to electrically connect to the wiring terminal of the motor winding 130. In the second direction Z, a distance between the first end of the input copper bar 1011 and the alternating-current output interface mounting hole 450 is less than a distance between the first end of the input copper bar 1011 and the wiring terminal of the motor winding 130, and a distance between the second end of the input copper bar 1011 and the wiring terminal of the motor winding 130 is less than a distance between the second end of the input copper bar 1011 and the alternating-current output interface mounting hole 450. In other words, the extension direction of the input copper bar 1011 complies with a direction of a power flow in the alternating-current output interface mounting hole 450, the input copper bar 1011, and the wiring terminal of the motor winding 130. Specifically, the angle value of the included angle between the extension direction of the input copper bar 1011 and the second direction Z is less than 90°. In this case, a loss of the alternating current is small in a process of transmission between the motor controller 200 and the motor 100, so that the motor 100 can more efficiently drive wheels to rotate, to enhance power performance of the vehicle.

In an embodiment of this application, the reducer 300 is connected to the output end of the motor shaft 140 in a transmission manner. The reducer 300 and the alternating-current output interface mounting hole 450 are arranged relative to each other along the first direction Y. The reducer 300 and the direct-current input interface mounting hole 440 are arranged on the other side along the first direction Y.

The reducer 300 includes a wheel drive terminal 320 (as shown in FIG. 2). The wheel drive terminal 320 is located below the direct-current input interface mounting hole 440 and the alternating-current output interface mounting hole 450 along the second direction Z (as shown in FIG. 2 and FIG. 3). An axis of the wheel drive terminal 320 is parallel to the motor shaft 140. The wheel drive terminal 320 and the motor shaft 140 are arranged in a direction perpendicular to the first direction Y.

In this embodiment of this application, the reducer 300 is configured to receive mechanical energy transmitted by the motor 100, and drive the wheels 40 to rotate by using wheel drive terminals 320. The controller accommodating cavity 430 and the motor accommodating cavity 420 are arranged along the second direction Z and partially overlap in the third direction X. In this way, there is installation space below the controller accommodating cavity 430 along the second direction Z. Because the wheel drive terminals 320 of the reducer 300 need to be connected to the wheels, this solution helps provide installation space for the connection between the reducer 300 and each wheel 40. The axis of the wheel drive terminal 320 is parallel to the motor shaft 140. An arrangement direction of the axis of the wheel drive terminal 320 and the motor shaft 140 is perpendicular to the first direction Y. In this way, a layout of the motor 100 and the reducer 300 is compact and orderly.

In this embodiment of this application, a power flow direction of the motor controller 200 and an energy flow direction of the motor 100 are opposite to each other, and approximately present a U shape; and an energy flow direction from the motor 100 to the reducer 300 and that from the reducer 300 to the wheel drive terminal 320 are also opposite to each other, and approximately present a U shape. A U-shaped opening in the U-shaped energy flow direction of the motor controller 200 and the motor 100 is opposite to a U-shaped opening in the U-shaped energy flow direction from the motor 100 to the reducer 300 and then to the wheel drive terminal 320. The wheel drive terminal 320 is located below the motor controller 200. In this way, an entire energy flow of the powertrain 10 is smooth, and an energy path is short, to help implement a small volume, space saving, higher integration, and miniaturization of the powertrain 10.

Still with reference to FIG. 4, in an embodiment, the reducer accommodating cavity 410 and the motor accommodating cavity 420 communicate with each other along the axial direction of the motor shaft 140, and the controller accommodating cavity 430 does not communicate with the reducer accommodating cavity 410 or the motor accommodating cavity 420. In this embodiment of this application, there is a transmission relationship between the reducer 300 and the motor 100, and the reducer accommodating cavity 410 is set to communicate with the motor accommodating cavity 420, so that a part of the motor shaft 140 extends into the reducer accommodating cavity 410, to implement mechanical transmission between the motor 100 and the reducer 300. The controller accommodating cavity 430 does not communicate with either of the reducer accommodating cavity 410 and the motor accommodating cavity 420, so that a cooling oil medium in the motor accommodating cavity 420 and the reducer accommodating cavity 410 cannot flow into the controller accommodating cavity 430 and does not further cause electrical interference to an electrical component in the motor controller 200, thereby ensuring normal working of the motor controller 200.

In an embodiment, the integrated housing 400 further includes a reducer housing. The reducer housing encloses and forms the reducer accommodating cavity 410. In other words, a part that is of the integrated housing 400 and that encloses and forms the reducer accommodating cavity 410 is the reducer housing.

In this embodiment of this application, the controller accommodating cavity 430, the motor accommodating cavity 420, and the reducer accommodating cavity 410 each include an opening. In an embodiment, the openings of the controller accommodating cavity 430, the motor accommodating cavity 420, and the reducer accommodating cavity 410 are all configured to connect to the outside and are respectively configured to install components of the motor controller 200, the motor 100, and the reducer 300 into the accommodating cavities. Along the first direction Y, an orientation of the opening of the motor accommodating cavity 420 is opposite to an orientation of the opening of the reducer accommodating cavity 410, and a length of the opening of the controller accommodating cavity 430 is less than a sum of lengths of the motor accommodating cavity 420 and the reducer accommodating cavity 410. An orientation of the opening of the controller accommodating cavity 430 is perpendicular to the first direction Y and the third direction X.

With reference to FIG. 3 and FIG. 4, the orientation of the opening of the motor accommodating cavity 420 is opposite to the orientation of the opening of the reducer accommodating cavity 410 along the first direction Y, the opening of the controller accommodating cavity 430 is located between the opening of the motor accommodating cavity 420 and the opening of the reducer accommodating cavity 410 along the first direction Y, and the orientation of the opening of the controller accommodating cavity 430 is the second direction Z.

In an embodiment, the opening of the controller accommodating cavity 430 is denoted as a motor controller opening 431 (as shown in FIG. 3), the opening of the motor accommodating cavity 420 is denoted as a motor opening 421, and the opening of the reducer accommodating cavity 410 is denoted as a reducer opening 411 (as shown in FIG. 4). The orientation of the motor controller opening 431 is the second direction Z. The orientations of the motor opening 421 and the reducer opening 411 are opposite to each other along the first direction Y. In this embodiment of this application, the motor controller opening 431 is located between the motor opening 421 and the reducer opening 411 along the first direction Y, and the controller accommodating cavity 430 is located between the opening of the motor accommodating cavity 420 and the opening of the reducer accommodating cavity 410 along the first direction Y. In this way, the controller accommodating cavity 430, the motor accommodating cavity 420, and the reducer accommodating cavity 410 at least partially overlap in the first direction Y, to reduce a dimension value of the powertrain 10 in the first direction Y and help implement a miniaturization design of the powertrain 10.

In an embodiment, the direct-current input interface mounting hole 440 is located between the motor controller opening 431 and the reducer opening 411 along the second direction Z (as shown in FIG. 3 and FIG. 4), and the alternating-current output interface mounting hole 450 is located between the motor opening 421 and the motor controller opening 431 along the second direction Z (as shown in FIG. 3). In this embodiment of this application, the direct-current input interface mounting hole 440 and the reducer opening 411 are provided on a same side, and the alternating-current output interface mounting hole 450 and the motor opening 421 are provided on a same side, so that two ends of the integrated housing 400 are basically aligned along the first direction Y. An internal layout of the powertrain 10 is compact and orderly, to shorten an energy transmission path.

In this embodiment of this application, the powertrain 10 further includes a motor end cover 110, a reducer end cover 310, and a motor controller cover 210. The motor end cover 110, the reducer end cover 310, and the motor controller cover 210 are respectively configured to cover the opening of the motor accommodating cavity 420, the opening of the reducer accommodating cavity 410, and the opening of the controller accommodating cavity 430. Along the first direction Y, a length of the motor controller cover 210 is less than a distance between the motor end cover 110 and the reducer end cover 310, and a length of the controller accommodating cavity 430 is less than a distance between the motor end cover 110 and the reducer end cover 310.

In this embodiment of this application, the powertrain 10 further includes a wiring cover 102. Along the first direction Y, the wiring cover 102 and the reducer end cover 310 are arranged relative to each other, the motor end cover 110 is arranged between the motor stator and the wiring cover 102, a gap between the wiring cover 102 and the motor end cover 110 is used to accommodate the input copper bar 1011, and a projection of the wiring cover 102 covers projections of the alternating-current output interface mounting hole 450, the three input copper bars 1011, the wiring terminal of the motor winding 130, and the motor shaft 140.

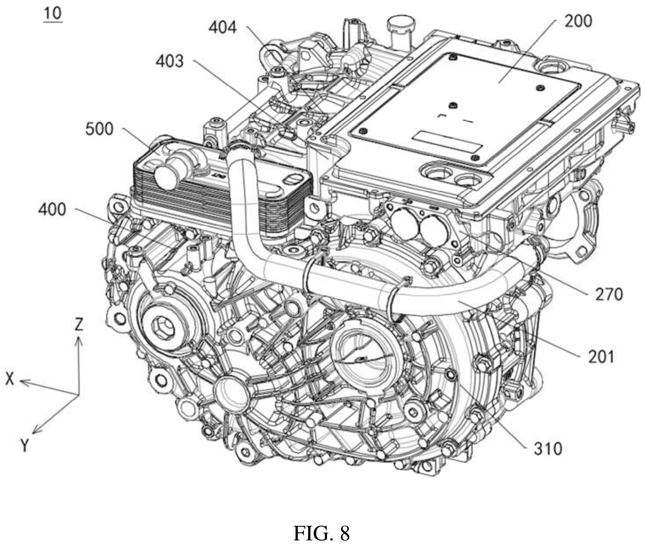

With reference to FIG. 2, FIG. 3, and FIG. 8, FIG. 8 is a diagram of a structure of a powertrain 10 according to an embodiment of this application. In an embodiment, the powertrain 10 further includes the motor end cover 110, the reducer end cover 310, and the motor controller cover 210 (as shown in FIG. 2 and FIG. 8). The motor end cover 110, the reducer end cover 310, and the motor controller cover 210 are respectively configured to cover the openings of the controller accommodating cavity 430, the motor accommodating cavity 420, and the reducer accommodating cavity 410 (as shown in FIG. 2, FIG. 3, and FIG. 8). In this embodiment of this application, the motor end cover 110, the reducer end cover 310, and the motor controller cover 210 can respectively protect components in the motor 100, the reducer 300, and the motor controller 200, to prevent a foreign matter from entering the controller accommodating cavity 430, the motor accommodating cavity 420, and the reducer accommodating cavity 410.

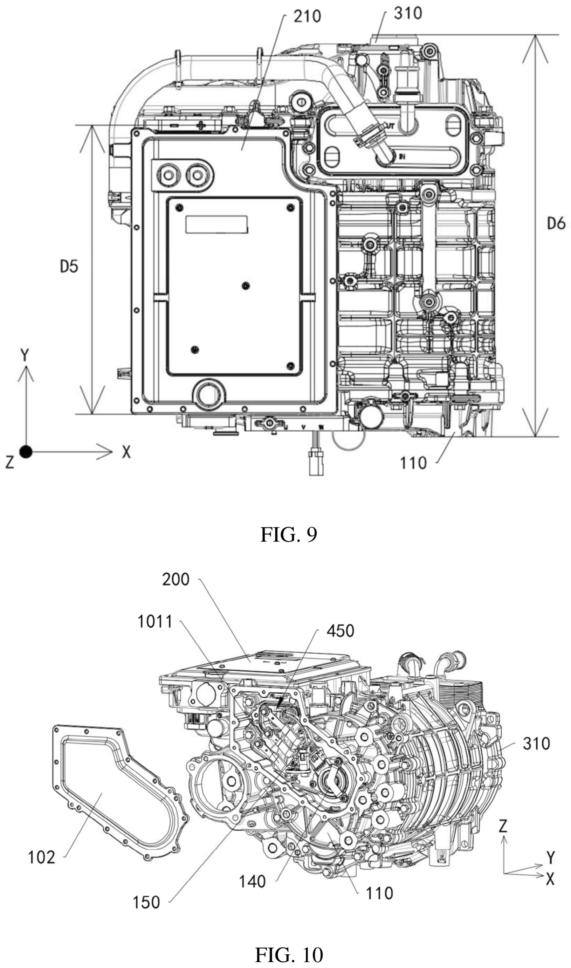

With reference to FIG. 9, FIG. 9 is a top view of a powertrain 10 according to an embodiment of this application. In an embodiment, the motor end cover 110 and the reducer end cover 310 are arranged relative to each other along the first direction Y (as shown in FIG. 9). The length of the motor controller cover 210 along the first direction Y is less than a length between the motor end cover 110 and the reducer end cover 310 along the first direction Y (as shown in FIG. 9). The motor controller cover 210 is located between the motor end cover 110 and the reducer end cover 310 along the first direction Y. The length of the controller accommodating cavity 430 along the first direction Y is less than the distance between the motor end cover 110 and the reducer end cover 310 along the first direction Y. In this embodiment of this application, the distance between the motor end cover 110 and the reducer end cover 310 along the first direction Y is a maximum distance between the motor end cover 110 and the reducer end cover 310 along the first direction Y, or is a distance along the first direction Y between an end face that is of the motor end cover 110 and that is away from the reducer end cover 310 and an end face that is of the reducer end cover 310 and that is away from the motor end cover 110.

In this embodiment of this application, the motor controller cover 210 covers the opening of the controller accommodating cavity 430 along the second direction Z, and the motor end cover 110 and the reducer end cover 310 respectively cover the opening of the motor 100 and the opening of the reducer 300 along the first direction Y. A position relationship of the motor controller cover 210, the motor end cover 110, and the reducer end cover 310 is similar to a position relationship of the motor controller opening 431, the motor opening 421, and the reducer opening 411. A value of the length of the motor controller cover 210 along the first direction Y is D5 (as shown in FIG. 9). A value of the length between the motor end cover 110 and the reducer end cover 310 along the first direction Y is D6. D5<D6 is set. In other words, the motor controller cover 210 is located between the motor end cover 110 and the reducer end cover 310 along the first direction Y, to help reduce a total dimension value of the motor controller 200, the motor 100, and the reducer 300 in the first direction Y, thereby reducing a space volume occupied by the powertrain 10 in the electric vehicle 1. The length of the controller accommodating cavity 430 along the first direction Y is less than the distance between the motor end cover 110 and the reducer end cover 310 along the first direction Y. This also reduces the volume of the powertrain 10.

With reference to FIG. 10, FIG. 10 is a locally exploded diagram of a powertrain 10 according to an embodiment of this application. In an embodiment, the motor controller 200 is connected to each of the three input copper bars 1011 through the alternating-current output interface 260 in the alternating-current output interface mounting hole 450. The three input copper bars 1011 each are configured to connect to the wiring terminal of the motor winding 130. The three input copper bars 1011 are located on an outer side of the motor end cover 110. The arrangement direction of the three input copper bars 1011 intersects both the first direction Y and the second direction Z. The powertrain 10 further includes the wiring cover 102. The wiring cover 102 and the reducer end cover 310 are disposed relative to each other along the first direction Y. The wiring cover 102 covers the alternating-current output interface mounting hole 450, the three input copper bars 1011, the wiring terminal of the motor winding 130, and an end part of the motor shaft 140 along the first direction Y.

In this embodiment of this application, two ends of the input copper bar 1011 are respectively connected to the alternating-current output interface 260 and the wiring terminal of the motor winding 130, and the input copper bar 1011 is configured to transmit the alternating current output by the motor controller 200 to the motor 100. The alternating-current output interface mounting hole 450 and the three input copper bars 1011 are all located on the outer side of the motor end cover 110. The wiring terminal of the motor winding 130 and one end of the motor shaft 140 extend from the motor accommodating cavity 420 to the motor end cover 110. The wiring cover 102 can be configured to cover the alternating-current output interface mounting hole 450, the three input copper bars 1011, the wiring terminal of the motor winding 130, and the end part of the motor shaft 140. The alternating-current output interface mounting hole 450, the three input copper bars 1011, and the wiring terminal of the motor winding 130 are electrically connected. The wiring cover 102 can be disposed to prevent the electrical connection relationship from being affected by the outside. The wiring cover 102 can further prevent a foreign matter from entering the motor shaft 140, to ensure normal working of the motor 100.

In this embodiment of this application, the integrated housing 400 further includes a coolant inlet 401 and a coolant outlet 402. The coolant inlet 401 is configured to provide a coolant for the motor controller 200. The coolant outlet 402 is configured to output the coolant. The coolant inlet 401, the power interface mounting hole 460, and the alternating-current output interface mounting hole 450 are arranged on the side along the first direction Y. The coolant inlet 401 and the power interface mounting hole 460 are adjacently arranged along the second direction Z. A projection of the coolant outlet 402 overlaps the projection of the controller accommodating cavity 430 and does not overlap the projection of the motor shaft along the third direction X.

Still with reference to FIG. 3, in an embodiment, the integrated housing 400 further includes the coolant inlet 401 and a liquid cooling passage. The coolant inlet 401 is configured to transmit the coolant to the liquid cooling passage. The coolant inlet 401 and the direct-current input interface mounting hole 440 are arranged relative to each other along the first direction Y. An axial direction of the coolant inlet 401 is the same as the first direction Y. The liquid cooling passage is located below the controller accommodating cavity 430 along the second direction Z.

In this embodiment of this application, the coolant enters the liquid cooling passage below the controller accommodating cavity 430 through the coolant inlet 401. The motor controller 200 generates much heat during working. In this solution, the coolant inlet 401 and the liquid cooling passage are disposed, so that the coolant can cool and dissipate heat for the motor controller 200, to help reduce a temperature of the motor controller 200 in a stable working condition. The coolant inlet 401 and the direct-current input interface mounting hole 440 are arranged relative to each other along the first direction Y, to help reduce operation difficulty of an electrical connection and a mechanical connection, thereby avoiding adverse impact of the coolant on the direct-current input interface 270 and improving safety performance of the motor controller 200 and the powertrain 10. In addition, the axial direction of the coolant inlet 401 is the same as the first direction Y. In other words, a flow direction of the coolant is opposite to a flow direction of a power flow in the motor controller 200, to help improve heat dissipation efficiency of the coolant. The liquid cooling passage is located below the controller accommodating cavity 430 along the second direction Z, to appropriately use internal space of the motor controller 200.

In an embodiment, a type of the coolant includes water, a glycol coolant, a propanediol coolant, and the like. For example, the coolant is water.

Still with reference to FIG. 2 and FIG. 5, in an embodiment, the integrated housing 400 further includes the coolant outlet 402 (as shown in FIG. 2). The axial direction of the coolant outlet 402 is perpendicular to both the first direction Y and the second direction Z. The coolant outlet 402, the circuit board 250, and the motor shaft 140 are arranged along the axial direction of the coolant outlet 402 (as shown in FIG. 5). The coolant outlet 402 communicates with a heat exchanger 500 by using a conduit (as shown in FIG. 2 and FIG. 5). The heat exchanger 500 and the wiring terminal of the motor 100 are disposed relative to each other along the first direction Y (as shown in FIG. 5). In this embodiment of this application, the axial direction of the coolant outlet 402 is the third direction X, and the coolant outlet 402 and the direct-current input interface mounting hole 440 are provided on different sides. This can avoid negative impact of the coolant on the direct-current input interface 270, to help improve safety performance. The heat exchanger 500 and the wiring terminal of the motor 100 are disposed relative to each other along the first direction Y. In other words, the heat exchanger 500 is closer to the coolant outlet 402 than to the coolant inlet 401. This helps shorten a transmission path of the coolant on an outer side of the motor controller 200 and improve cooling efficiency of the coolant.

The heat exchanger 500 is located above the reducer 300 along the second direction Z (as shown in FIG. 2). The heat exchanger 500 is further configured to communicate with the reducer accommodating cavity 410 and the motor accommodating cavity 420. The reducer accommodating cavity 410 is configured to accommodate the reducer 300. The motor accommodating cavity 420 is configured to accommodate the motor 100. Neither the reducer accommodating cavity 410 nor the motor accommodating cavity 420 communicates with the liquid cooling passage. In this embodiment of this application, the heat exchanger 500 is disposed in the powertrain 10, and the heat exchanger 500 communicates with the reducer accommodating cavity 410 and the motor accommodating cavity 420, so that the reducer 300 and the motor 100 can also be cooled, to ensure that the reducer 300 and the motor 100 work at an appropriate temperature. The heat exchanger 500 is located above the reducer 300 along the second direction Z, so that a cooling path between the heat exchanger 500 and the reducer 300 is short, to reduce thermal resistance of a heat dissipation path. The liquid cooling passage does not communicate with either of the reducer accommodating cavity 410 and the motor accommodating cavity 420, so that the coolant in the liquid cooling passage does not flow into the reducer 300 and the motor 100.

In an embodiment, the heat exchanger 500 includes a liquid cooling inlet 510 and a liquid cooling outlet 520. The liquid cooling inlet 510 is connected to the coolant outlet 402 through a conduit 201. The liquid cooling outlet 520 is configured to communicate with a cooling system. For example, the liquid cooling outlet 520 is configured to communicate with the cooling system in the vehicle. The cooling system is configured to dissipate heat for the motor controller 200 when the heated coolant in the heat exchanger 500 is cooled and then enter the liquid cooling passage from the coolant inlet 401.

In an embodiment, the heat exchanger 500 includes a first heat exchange chamber and a second heat exchange chamber (not shown in the figure) that are spaced and disposed. The first heat exchange chamber and the second heat exchange chamber are heat-conductively connected. A coolant in the second heat exchange chamber is different from a coolant in the first heat exchange chamber. For example, a type of the coolant in the first heat exchange chamber is cooling water, and a type of the coolant in the second heat exchange chamber is cooling oil. The first heat exchange chamber communicates with the coolant outlet 402. In this way, the cooling water flowing out of the liquid cooling passage flows into the first heat exchange chamber. The second heat exchange chamber communicates with the motor accommodating cavity 420 and the reducer accommodating cavity 410. Cooling oil used to cool the motor 100 and the reducer 300 enters the second heat exchange chamber. Cooling water in the first heat exchange chamber cools the cooling oil in the second heat exchange chamber. In this way, the cooled cooling oil enters the motor accommodating cavity 420 and the reducer accommodating cavity 410 again. The cooling water in the first heat exchange chamber absorbs heat of the cooling oil in the second heat exchange chamber to be heated and then is discharged from the coolant outlet.

Still with reference to FIG. 8, in an embodiment, the controller housing includes a notch part 403. The notch part 403 is located between the motor shaft 140 and the direct-current input interface 270. The notch part 403 and the alternating-current output interface 260 are disposed relative to each other along the first direction Y. A part of the heat exchanger 500 is located in avoidance space formed by the notch part 403. In this solution, a dimension of the powertrain 10 in the third direction X can be reduced, to help reduce a volume of the powertrain 10.

Still with reference to FIG. 8, in an embodiment, a reinforcing rib 404 is disposed between the motor 100 and a side that is of the motor controller 200 and that is close to the motor 100 along the third direction X. The reinforcing rib 404 extends along the third direction X. The motor controller 200, the reinforcing rib 404, and the motor 100 are integrally formed. This solution helps improve structural strength of the powertrain 10.

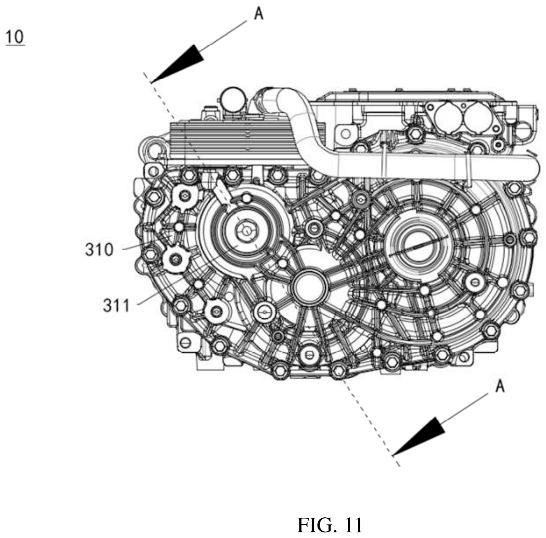

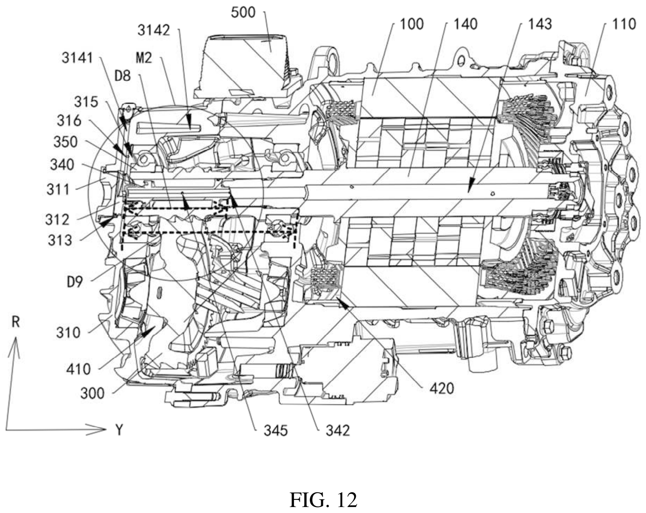

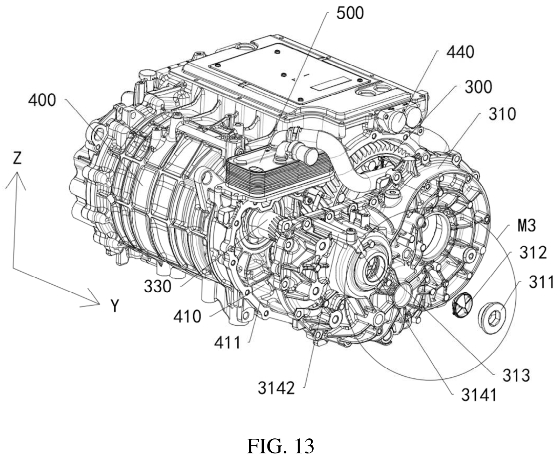

With reference to FIG. 11 to FIG. 13, FIG. 11 is a diagram of a structure of a powertrain 10 according to an embodiment of this application, FIG. 12 is a sectional view of the powertrain 10 shown in FIG. 11 along AA, and FIG. 13 is a partial exploded diagram of a powertrain 10 according to an embodiment of this application.

In an embodiment, the heat exchanger 500 is configured to input the cooling oil to the reducer 300. The reducer 300 includes a reducer input shaft 330 (as shown in FIG. 12 and FIG. 13). The reducer end cover 310 includes a sealing member 311, an oil guide part 312, and a fastening hole 313 that penetrates the reducer end cover 310 along the first direction Y (as shown in FIG. 12 and FIG. 13). The sealing member 311 and the oil guide part 312 are located in the fastening hole 313 (as shown in FIG. 12 and FIG. 13). The sealing member 311 is fastened in the fastening hole 313 (as shown in FIG. 12 and FIG. 13). The reducer input shaft 330 is located in the reducer accommodating cavity 410 and is configured to be fastened to the motor shaft 140 of the motor 100 (as shown in FIG. 12). The sealing member 311, the oil guide part 312, and the reducer input shaft 330 are sequentially arranged along the first direction Y (as shown in FIG. 12). The sealing member 311 and the oil guide part 312 are spaced and arranged along the first direction Y (not shown in the figure). The oil guide part 312 is configured to transmit the cooling oil to the reducer input shaft 330.

In an embodiment, the oil guide part 312 is configured to guide the cooling oil from the outer side of the reducer accommodating cavity 410 into the inner side of the reducer accommodating cavity 410. In an embodiment, a type of the cooling oil includes glycol cooling oil, synthetic oil, mineral oil, and the like. For example, the cooling oil is glycol cooling oil. The first direction Y is parallel to the axial direction of the motor shaft 140 and an axial direction of the reducer input shaft 330.

In this embodiment of this application, the sealing member 311 and the oil guide part 312 in the reducer end cover 310 are located in the fastening hole 313, and the sealing member 311, the oil guide part 312, and the reducer input shaft 330 are sequentially arranged along the first direction Y. In other words, the sealing member 311 is closer to the outer side of the reducer 300 than the oil guide part 312. The sealing member 311 fastened to the fastening hole 313 can prevent the oil guide part 312 from having a large offset in the first direction Y, to ensure that the oil guide part 312 can stably guide the cooling oil. The oil guide part 312 communicates with the reducer accommodating cavity 410. The cooling oil flows into the reducer accommodating cavity 410 through the oil guide part 312, to cool and dissipate heat for the reducer 300 in the reducer accommodating cavity 410, thereby ensuring that components in the powertrain 10 work in an appropriate temperature range.

In an embodiment, there is a gap between the sealing member 311 and the oil guide part 312, to allow a small degree of fluttering between the sealing member 311 and the oil guide part 312 along the first direction Y, thereby effectively avoiding fracturing.

In this embodiment of this application, a combination of the sealing member 311 and the oil guide part 312 can introduce the cooling oil into the reducer 300. If the sealing member 311 and the oil guide part 312 are combined into an integrated structure, for example, a structure used for flow guiding is processed in the sealing member 311, a structure of the sealing member 311 is excessively complex, and processing difficulty is increased. When the sealing member 311 is fastened to the reducer end cover 310, large pre-tightening force usually needs to be applied. As a result, the flow guide structure in the sealing member 311 is easily deformed under force, thereby affecting flow guiding effect. However, in this embodiment of this application, the structure used for flow guiding is disposed as the sealing member 311 and the oil guide part 312, which helps reduce processing difficulty and manufacturing costs of components. In addition, the sealing member 311 and the oil guide part 312 are two separate independent components and are spaced and arranged, to effectively reduce acting force and abrasion on the oil guide part 312, thereby prolonging a service life and ensuring flow guiding effect of the oil guide part 312.

In this embodiment of this application, the oil guide part 312 can introduce the cooling oil into the powertrain 10, to reduce a temperature of the powertrain 10 in a stable working condition. This helps improve working efficiency and prolong a service life of the powertrain 10. The sealing member 311 and the oil guide part 312 are separately disposed components. In comparison with an integrated structure, this design is featured by a simplified structure and simpler and more convenient processing of the sealing member 311 and the oil guide part 312, which helps reduce processing difficulty and costs. The sealing member 311 and the oil guide part 312 are separately disposed, to effectively reduce the acting force and the abrasion on the oil guide part 312, thereby prolonging the service life and ensuring the flow guiding effect of the oil guide part 312.

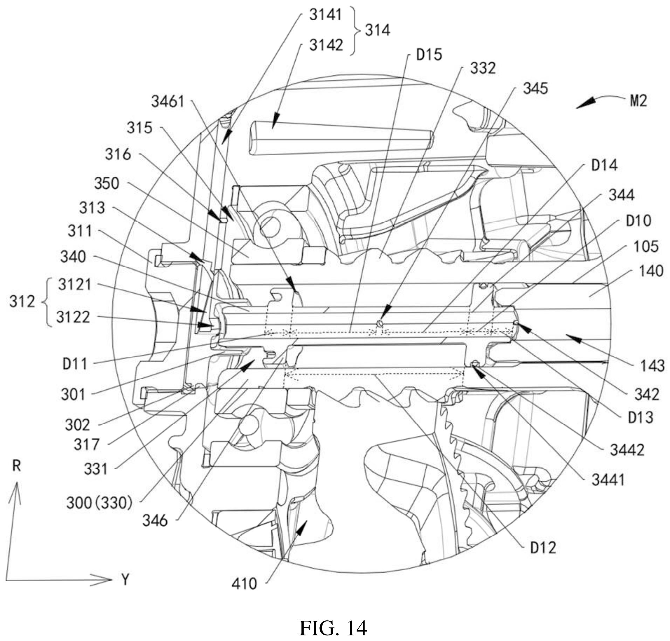

With reference to FIG. 12 and FIG. 14, FIG. 14 is a locally enlarged diagram of an M2 part of the powertrain 10 shown in FIG. 12. In an embodiment, the oil guide part 312 includes an oil guide part radial oil passage 3121 and an oil guide part axial oil passage 3122 that communicate with each other (as shown in FIG. 14). An extension direction of the oil guide part radial oil passage 3121 intersects that of the oil guide part axial oil passage 3122 (as shown in FIG. 14). The oil guide part radial oil passage 3121 is configured to communicate with the heat exchanger 500 (as shown in FIG. 12 and FIG. 14). The oil guide part axial oil passage 3122 is configured to communicate with the reducer accommodating cavity 410 through the reducer input shaft 330 (as shown in FIG. 14). The extension direction of the oil guide part radial oil passage 3121 is parallel to a radial direction R of the reducer input shaft 330. The extension direction of the oil guide part axial oil passage 3122 is parallel to the axial direction of the reducer input shaft 330. The oil guide part axial oil passage 3122 and the reducer input shaft 330 are spaced and arranged along the first direction Y.

In this embodiment of this application, the heat exchanger 500 is configured to input the cooling oil to the powertrain 10. The cooling oil sequentially flows through the oil guide part radial oil passage 3121, the oil guide part axial oil passage 3122, and the reducer input shaft 330, and then flows to the reducer accommodating cavity 410. The oil guide part 312 communicates with the reducer input shaft 330 through the oil guide part axial oil passage 3122. The extension direction of the oil guide part axial oil passage 3122 is parallel to the axial direction of the reducer input shaft 330. In other words, the oil guide part axial oil passage 3122 extends along the first direction Y, to help reduce flow resistance of the cooling oil in the oil guide part 312 and the reducer input shaft 330, thereby improving cooling efficiency.

In this embodiment of this application, the oil guide part axial oil passage 3122 and the reducer input shaft 330 are spaced and arranged along the first direction Y, so that the reducer input shaft 330 is isolated from the oil guide part 312, to help rotation of the reducer input shaft 330 and reduce friction between the reducer input shaft 330 and the oil guide part 312.

Still with reference to FIG. 11 and FIG. 12, in an embodiment, the reducer input shaft 330 is fixedly connected to the motor shaft 140. The reducer input shaft 330 includes a reducer shaft cavity 331. The motor shaft 140 includes a motor shaft cavity 143. The reducer 300 further includes an oil passing pipe 340. The reducer shaft cavity 331 is configured to accommodate the oil passing pipe 340 and a part of the motor shaft 140. The oil passing pipe 340 is configured to communicate with the oil guide part 312 and the motor shaft cavity 143. The oil passing pipe 340 and the motor shaft 140 are arranged along a motor axial direction Y. The oil passing pipe 340 and the reducer input shaft 330 are fastened relative to each other. Along the first direction Y, the reducer shaft cavity 331 penetrates the reducer input shaft 330, and the motor shaft cavity 143 penetrates the motor shaft 140. The oil passing pipe 340, the oil guide part 312, and the sealing member 311 are spaced and arranged along the first direction Y.

In this embodiment of this application, both the reducer shaft cavity 331 and the motor shaft cavity 143 extend along the first direction Y. The oil passing pipe 340 is located in the reducer shaft cavity 331 and is located on a side that is of the oil guide part 312 and that is away from the sealing member 311 along the first direction Y. The oil passing pipe 340 communicates with the reducer accommodating cavity 410 through the reducer shaft cavity 331. The oil guide part 312 communicates with the reducer accommodating cavity 410 through the reducer input shaft 330. The oil guide part axial oil passage 3122 communicates with the motor shaft cavity 143 through the oil passing pipe 340. The cooling oil may sequentially cool the reducer shaft cavity 331 and the motor shaft cavity 143 through the oil guide part 312 and the oil passing pipe 340, to provide a precondition for subsequently cooling an inner structure of the motor 100, thereby expanding a cooling range of the cooling oil in the powertrain 10. The oil passing pipe 340 and the reducer input shaft 330 are fastened relative to each other. Even if the reducer input shaft 330 rotates at a high speed, the oil passing pipe 340 can stably transmit the cooling oil to the motor shaft cavity 143.

In this embodiment of this application, the sealing member 311, the oil guide part 312, and the oil passing pipe 340 are spaced and disposed in the first direction Y, and the sealing member 311 is fastened in the fastening hole 313. In this way, the oil guide part 312 and the oil passing pipe 340 can be slightly displaced in the first direction Y. This helps reduce abrasion between the sealing member 311 and the oil guide part 312 and between the oil guide part 312 and the oil passing pipe 340, to prolong a service life. In this way, the following case can be avoided: The oil guide part 312 is squeezed and therefore the oil guide part 312 is damaged when the sealing member 311 is sealed and fastened in the fastening hole 313.

In an embodiment, there is a gap between the oil guide part axial oil passage 3122 and the oil passing pipe 340 along the first direction Y. An inside diameter of the oil passing pipe 340 is greater than an inside diameter of the oil guide part axial oil passage 3122. A projection of the oil guide part axial oil passage 3122 along the first direction Y is located in a projection of the oil passing pipe 340 along the first direction Y. The projection of the oil guide part axial oil passage 3122 along the first direction Y is a projection, along the first direction Y, of a region enclosed by an inner wall of the oil guide part axial oil passage 3122. The projection of the oil passing pipe 340 along the first direction Y is a projection, along the first direction Y, of a region enclosed by a pipe wall of the oil passing pipe 340.

In this embodiment of this application, the oil guide part axial oil passage 3122 and the oil passing pipe 340 are spaced and disposed along the first direction Y. In this way, when the reducer input shaft 330 rotates at a high speed, the oil guide part 312 and the oil passing pipe 340 can implement non-contact oil guiding, to avoid abrasion between the oil guide part 312 and the oil passing pipe 340, thereby avoiding heat generated due to the abrasion. Therefore, the cooling oil can cool and dissipate heat for a heating component in the powertrain 10. This implementation can not only reduce a failure risk of the oil guide part 312 and the oil passing pipe 340, but also improve utilization of the cooling oil, to enhance heat dissipation effect. In this embodiment of this application, in this solution, an inside diameter of the oil passing pipe 340 is set to be greater than an inside diameter of the oil guide part axial oil passage 3122, and the projection of the oil passing pipe 340 along the first direction Y covers the projection of the oil guide part axial oil passage 3122 along the first direction Y. In this way, in a process in which the cooling oil flows from the oil guide part axial oil passage 3122 to the oil passing pipe 340, flow resistance is reduced, and a flow quantity is increased, to help improve cooling efficiency of the cooling oil.

It is assumed that the oil passing pipe 340 is not disposed in the reducer shaft cavity 331. In this case, even if the reducer shaft cavity 331 communicates with the motor shaft cavity 143, when the reducer input shaft 330 rotates, it is difficult for the cooling oil to accurately flow from reducer shaft cavity 331 to the motor shaft cavity 143 because there is still a distance along the motor axial direction Y between the motor shaft 140 and an end that is of the reducer input shaft 330 and that is close to the heat exchanger 500. In other words, a flow quantity of the cooling oil entering the motor 100 is small. As a result, the cooling effect of the cooling oil to the motor 100 is adversely affected, and control on a temperature rise of the powertrain 10 is interfered. The oil passing pipe 340 in this embodiment of this application is configured to communicate with the heat exchanger and the motor shaft 140, so that the cooling oil can enter the motor shaft 140 to cool components in the motor 100.

In this embodiment of this application, the oil passing pipe 340 is disposed in the reducer shaft cavity 331, and the oil passing pipe 340 communicates with the motor shaft cavity 143, so that the cooling oil can be accurately guided from the reducer shaft cavity 331 to the motor shaft cavity 143, to provide a precondition for subsequently cooling the inner structure of the motor 100. The oil passing pipe 340 and the reducer input shaft 330 are fastened relative to each other. When the reducer input shaft 330 rotates at a high speed, the oil passing pipe 340 can be used for stably transmitting the cooling oil, to help meet a cooling requirement of the powertrain 10 in a high-speed working condition.

Still with reference to FIG. 14, in an embodiment, the reducer 300 further includes a sleeve structure 301. The sleeve structure 301 is configured to be sleeved on an outer circumferential side of the oil passing pipe 340. The sleeve structure 301, the oil guide part 312, and the sealing member 311 are arranged along the first direction Y. The sleeve structure 301 is fastened to the oil guide part 312. The projection of the oil guide part axial oil passage 3122 along the first direction Y is located in a projection of the sleeve structure 301 along the first direction Y. Along the radial direction R of the reducer input shaft 330, there is a gap between an inner surface that is of the sleeve structure 301 and that faces the oil passing pipe 340 and an outer surface that is of the oil passing pipe 340 and that faces the sleeve structure 301.

In this embodiment of this application, the sleeve structure 301 is located on a surface that is of the oil guide part 312 and that faces the oil passing pipe 340 along the first direction Y. The sleeve structure 301 is sleeved on an outer side of the oil passing pipe 340. The sleeve structure 301 and the oil passing pipe 340 are spaced and disposed in the radial direction R of the reducer input shaft 330, to reduce abrasion between the sleeve structure 301 and the oil passing pipe 340, thereby prolonging service lives of the oil guide part 312 and the oil passing pipe 340.

Two ends of the sleeve structure 301 along the first direction Y respectively communicate with the oil guide part axial oil passage 3122 and the oil passing pipe 340. Because a dimension of the oil guide part axial oil passage 3122 in the first direction Y is relatively small, a guiding function for a flow direction of the cooling oil is limited, and the oil guide part axial oil passage 3122 and the oil passing pipe 340 are spaced and arranged in the first direction Y. The sleeve structure 301 is disposed on a side that is of the oil guide part axial oil passage 3122 and that is close to the oil passing pipe 340. In this way, when the reducer input shaft 330 rotates, a leaked part of the cooling oil from a gap between the oil guide part axial oil passage 3122 and the oil passing pipe 340 can be reduced. The sleeve structure 301 can guide a flow direction of the leaked cooling oil, so that the cooling oil finally enters the reducer shaft cavity 331. Therefore, a quantity of cooling oil entering the reducer shaft cavity 331 is increased, to increase a quantity of cooling oil entering the motor 100 from the reducer shaft cavity 331, thereby comprehensively improving cooling efficiency. In this solution, the sleeve structure 301 is disposed to further guide the flow direction of the cooling oil, to improve utilization of the cooling oil.

In an embodiment, the oil guide part 312 and the sleeve structure 301 are integrally formed. This solution helps improve structural reliability of the oil guide part 312, so that the oil guide part 312 can stably guide the flow direction of the cooling oil, to avoid leakage of the cooling oil.

Still with reference to FIG. 12 and FIG. 14, in an embodiment, a reducer end cover oil passage 314 is disposed in the reducer end cover 310 (as shown in FIG. 14), the reducer end cover oil passage 314 is configured to communicate with the heat exchanger 500 to transmit the cooling oil in the heat exchanger 500 (as shown in FIG. 12 and FIG. 14), and the oil guide part 312 is configured to communicate with the reducer end cover oil passage 314 (as shown in FIG. 14). A projection of the reducer end cover oil passage 314 at least partially overlaps the projection of the oil guide part radial oil passage 3121 in the radial direction R of the reducer input shaft 330.

In this embodiment of this application, two ends of the reducer end cover oil passage 314 respectively communicate with the heat exchanger 500 and the oil guide part 312. The heat exchanger 500 transmits the cooling oil to the reducer end cover oil passage 314. Because projections of the reducer end cover oil passage 314 and the oil guide part radial oil passage 3121 in the radial direction R of the reducer input shaft 330 at least partially overlap, the cooling oil can enter the oil guide part radial oil passage 3121 through the reducer end cover oil passage 314, and the reducer end cover oil passage 314 guides the cooling oil. The oil guide part 312 communicates with all of the reducer input shaft 330, the oil passing pipe 340, and the motor shaft 140. The reducer input shaft 330 and the motor shaft 140 are disposed in a hollow manner. The reducer end cover oil passage 314 further internally communicates with the motor shaft 140 through the reducer input shaft 330. The reducer input shaft 330 is configured to internally communicate with the reducer accommodating cavity 410. The motor shaft 140 is configured to internally communicate with the motor accommodating cavity 420. A part of the cooling oil output by the heat exchanger 500 enters the motor accommodating cavity 420 through the oil passing pipe 340 and the motor shaft cavity 143; and the other part enters the reducer accommodating cavity 410 through the oil passing pipe 340, the motor shaft 140, and the reducer shaft cavity 331.

Still with reference to FIG. 14, in an embodiment, the reducer end cover 310 further includes a reducer bearing lubricating oil hole 316. The reducer bearing lubricating oil hole 316 is configured to communicate with the reducer end cover oil passage 314 and a reducer bearing chamber 315. The reducer end cover oil passage 314, the reducer bearing lubricating oil hole 316, and the reducer bearing chamber 315 are arranged along the first direction Y. The reducer bearing lubricating oil hole 316 and the oil guide part radial oil passage 3121 are spaced along the radial direction R of the reducer input shaft 330.

The reducer input shaft 330 is rotationally connected to the reducer end cover 310 through a reducer bearing 350. The reducer bearing 350 is located in the reducer bearing chamber 315. The reducer bearing chamber 315 is concave in a direction away from the reducer input shaft 330 along the first direction Y.

The reducer bearing 350 is configured to bear a load from the reducer input shaft 330, reduce friction, and ensure that the reducer 300 runs stably in a high-speed working condition. If the reducer bearing 350 is not sufficiently lubricated, the reducer bearing 350 may be ablated or damaged. In this embodiment of this application, the reducer end cover oil passage 314 and the reducer bearing 350 are spaced and disposed. The reducer bearing lubricating oil hole 316 is provided along the first direction Y on a side wall that is of the reducer end cover oil passage 314 and that is close to the reducer bearing 350. The reducer end cover oil passage 314, the reducer bearing lubricating oil hole 316, and the reducer bearing chamber 315 are arranged along the first direction Y. In this way, when the cooling oil flows from the heat exchanger 500 and passes through the reducer end cover oil passage 314, a part of the cooling oil enters the reducer bearing chamber 315 through the reducer bearing lubricating oil hole 316 to lubricate the reducer bearing 350, to avoid damage to the reducer bearing 350, thereby prolonging a service life and ensuring long-term stable running of the reducer 300. The reducer bearing lubricating oil hole 316 and the oil guide part radial oil passage 3121 are spaced and provided in the radial direction R of the reducer input shaft 330, so that the cooling oil that has entered the oil guide part radial oil passage 3121 is not affected by the reducer bearing lubricating oil hole 316.

Still with reference to FIG. 14, in an embodiment, projections of the reducer bearing lubricating oil hole 316 and the reducer bearing chamber 315 at least partially overlap along the first direction Y. Along the radial direction R of the reducer input shaft 330, a distance between axes of the reducer bearing lubricating oil hole 316 and the reducer input shaft 330 is less than an outside diameter of the reducer bearing chamber 315. A length of the reducer bearing lubricating oil hole 316 along the first direction Y and a length of the reducer bearing lubricating oil hole 316 along the radial direction R of the reducer input shaft 330 are both less than a length of the reducer end cover oil passage 314 along the first direction Y.

In this embodiment of this application, the projection of the reducer bearing lubricating oil hole 316 in the first direction Y at least partially overlaps the projection of the reducer bearing chamber 315 in the first direction Y. In this way, the cooling oil can enter the reducer bearing chamber 315 through the reducer bearing lubricating oil hole 316, to lubricate the reducer bearing 350 in the reducer bearing chamber 315. In the radial direction R of the reducer input shaft 330, the distance between the axes of the reducer bearing lubricating oil hole 316 and the reducer input shaft 330 is less than the outside diameter of the reducer bearing chamber 315, to ensure that the cooling oil does not flow to a region other than the reducer bearing chamber 315 after flowing through the reducer bearing lubricating oil hole 316, thereby ensuring cooling effect of the cooling oil on the reducer bearing 350. The length of the reducer bearing lubricating oil hole 316 along the first direction Y and the length of the reducer bearing lubricating oil hole 316 along the radial direction R of the reducer input shaft 330 are both less than the length of the reducer end cover oil passage 314 along the first direction Y, to help appropriately allocate a flow quantity of the cooling oil. In this way, the following case is avoided: The cooling oil flowing into the reducer input shaft 330 and the motor shaft 140 is excessively small, thereby affecting cooling efficiency.

Still with reference to FIG. 12 to FIG. 14, in an embodiment, the heat exchanger 500 and the reducer end cover 310 are arranged along the second direction Z (as shown in FIG. 13). The reducer end cover 310, the heat exchanger 500, and the motor 100 are arranged along the first direction Y. The reducer end cover oil passage 314 includes a reducer end cover radial oil passage 3141 and a reducer end cover axial oil passage 3142 (as shown in FIG. 14). The reducer end cover radial oil passage 3141 extends along the radial direction R of the reducer input shaft 330. The reducer end cover axial oil passage 3142 extends along the axial direction of the reducer input shaft 330. The reducer end cover radial oil passage 3141 communicates with the reducer end cover axial oil passage 3142 (as shown in FIG. 14). The reducer end cover radial oil passage 3141 communicates with the heat exchanger 500 through the reducer end cover axial oil passage 3142 (as shown in FIG. 12 and FIG. 14). The reducer end cover radial oil passage 3141 is configured to connect to a radial flow guide passage (as shown in FIG. 14). The reducer end cover radial oil passage 3141 and the radial flow guide oil passage at least partially overlap along the radial direction R of the reducer input shaft 330.

In this embodiment of this application, the heat exchanger 500, the reducer end cover axial oil passage 3142, and the reducer end cover radial oil passage 3141 sequentially communicate. Because the reducer end cover radial oil passage 3141 is located at an edge of the reducer 300 along the first direction Y, if the reducer end cover axial oil passage 3142 is not disposed, the heat exchanger 500 needs to be disposed close to the edge of the reducer 300. This easily causes the heat exchanger 500 to fall. Therefore, this solution helps improve structural stability of the heat exchanger 500. The reducer end cover radial oil passage 3141 communicates with an oil guide passage in the oil guide part 312. The oil guide passage includes the oil guide part radial oil passage 3121 and the oil guide part axial oil passage 3122 that communicate with each other. Projections of the reducer end cover radial oil passage 3141 and the oil guide part radial oil passage 3121 in the oil guide passage at least partially overlap in the radial direction R of the reducer input shaft 330, so that the cooling oil can flow into the oil guide part radial oil passage 3121 through the reducer end cover radial oil passage 3141.

**In** an embodiment, the heat exchanger 500, the oil guide part 312, and the sealing member 311 are spaced and arranged along the first direction Y.

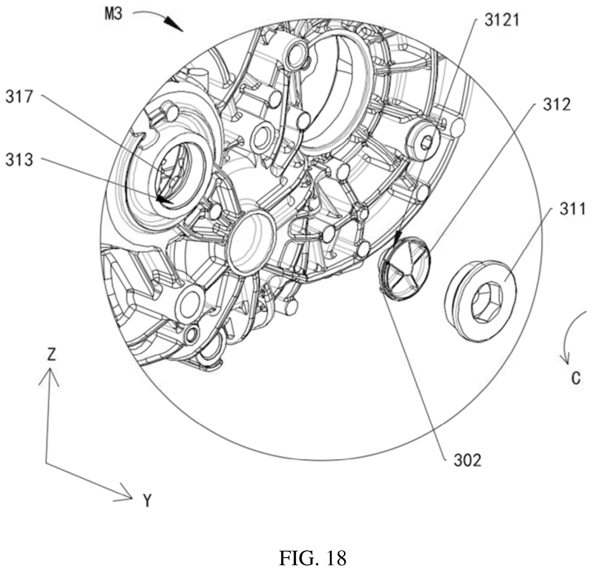

With reference to FIG. 14 and FIG. 18, FIG. 18 is a locally enlarged diagram of an M3 part of the powertrain 10 shown in FIG. 13. In an embodiment, the reducer end cover 310 further includes a first axial limiting boss 317 (as shown in FIG. 14 and FIG. 18). The first axial limiting boss 317 protrudes from an inner surface of the fastening hole 313 towards the oil guide part 312 along the radial direction R of the reducer input shaft 330 (as shown in FIG. 14 and FIG. 18). The reducer 300 further includes a second axial limiting boss 302 (as shown in FIG. 14 and FIG. 18). The second axial limiting boss 302 protrudes from an outer circumferential surface of the oil guide part 312 towards the hole wall of the fastening hole 313 along the radial direction R of the reducer input shaft 330 (as shown in FIG. 14 and FIG. 18).

The second axial limiting boss 302 is located between the sealing member 311 and the first axial limiting boss 317 along the first direction Y (as shown in FIG. 14 and FIG. 18). The first axial limiting boss 317 and the second axial limiting boss 302 are stacked along the first direction Y (as shown in FIG. 14). Therefore, the oil guide part 312 is limited between the sealing member 311 and the first axial limiting boss 317 along the first direction Y.

**In** this embodiment of this application, the sealing member 311 and the oil guide part 312 are both located in the fastening hole 313. The sealing member 311, the second axial limiting boss 302 of the oil guide part 312, and the first axial limiting boss 317 of the fastening hole 313 are sequentially arranged along the first direction Y. The first axial limiting boss 317 and the second axial limiting boss 302 overlap along the first direction Y. In this way, movement of the oil guide part 312 away from the sealing member 311 along the first direction Y is limited. In other words, the sealing member 311 and the first axial limiting boss 317 are combined to implement axial limiting on the oil guide part 312. When the powertrain 10 is affected by external force, a position of the oil guide part 312 in the reducer 300 does not change greatly. In an embodiment, the second axial limiting boss 302 and the oil guide part radial oil passage 3121 are spaced along a circumferential direction C of the oil guide part 312 (as shown in FIG. 18). In this embodiment of this application, the second axial limiting boss 302 and the oil guide part radial oil passage 3121 are spaced and disposed in the circumferential direction C of the oil guide part 312, so that circulation of the cooling oil is not interfered by the second axial limiting boss 302.

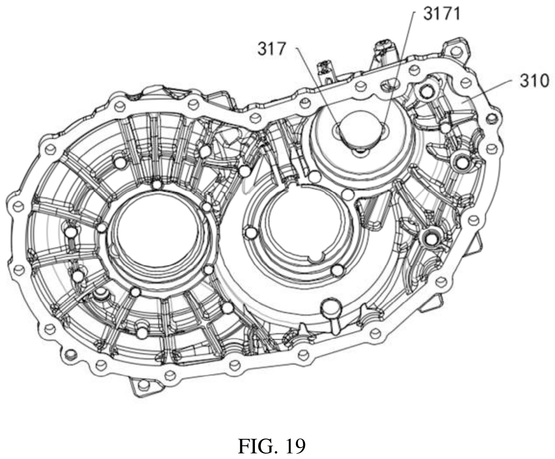

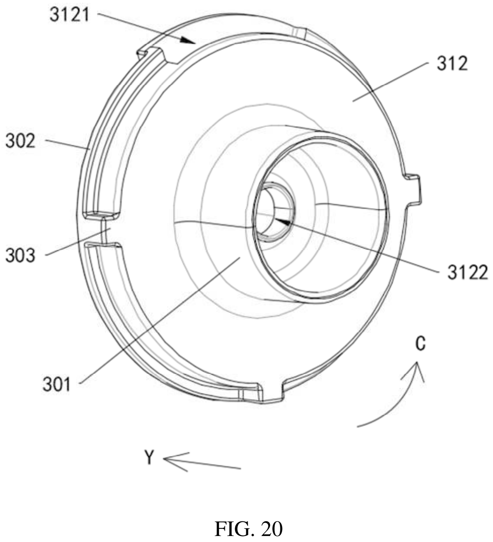

With reference to FIG. 19 and FIG. 20, FIG. 19 is a diagram of a structure of a reducer end cover 310 according to an embodiment of this application, and FIG. 20 is a diagram of a structure of an oil guide part 312 according to an embodiment of this application. In an embodiment, the first axial limiting boss 317 includes a circumferential limiting groove 3171 (as shown in FIG. 19). The circumferential limiting groove 3171 is concave from an outer circumferential surface of the first axial limiting boss 317 towards an inner surface of the fastening hole 313 along the radial direction R of the reducer input shaft 330 (as shown in FIG. 19). The reducer 300 further includes a circumferential limiting boss 303. The circumferential limiting boss 303 protrudes from an outer surface of the oil guide part 312 to the hole wall of the fastening hole 313 along the radial direction R of the reducer input shaft 330 (as shown in FIG. 20). The circumferential limiting boss 303 is located on a side that is of the second axial limiting boss 302 and that is close to the circumferential limiting groove 3171 along the first direction Y (as shown in FIG. 19 and FIG. 20). The circumferential limiting boss 303 is located on a side that is of the second axial limiting boss 302 and that is close to the reducer input shaft 330 along the first direction Y (as shown in FIG. 19 and FIG. 20). The circumferential limiting boss 303 is located in the circumferential limiting groove 3171 (as shown in FIG. 19 and FIG. 20).

In this embodiment of this application, a concave direction of the circumferential limiting groove 3171 is the same as a protrusion direction of the circumferential limiting boss 303. The circumferential limiting groove 3171 cooperates with the circumferential limiting boss 303, to circumferentially limit the oil guide part 312. Therefore, when the reducer 300 is in a high-speed working condition, the oil guide part 312 does not rotate greatly in a circumferential direction of the reducer input shaft 330. The circumferential limiting boss 303 is disposed close to the second axial limiting boss 302. When the circumferential limiting boss 303 is located in the circumferential limiting groove 3171, the first axial limiting boss 317 and the second axial limiting boss 302 are stacked along the first direction Y, to reduce amplitudes of displacement of the oil guide part 312 in the axial direction and the circumferential direction of the reducer input shaft 330, thereby ensuring normal and stable running of the reducer 300.

In an embodiment, a dimension value of a groove bottom of the circumferential limiting groove 3171 is greater than a dimension value of the circumferential limiting boss 303 in the circumferential direction of the reducer input shaft 330 (as shown in FIG. 19 and FIG. 20). In this embodiment of this application, the circumferential dimension value of the groove bottom of the circumferential limiting groove 3171 is greater than the circumferential dimension value of the circumferential limiting boss 303, to help install the circumferential limiting boss 303 in the circumferential limiting groove 3171 and reduce abrasion between the circumferential limiting boss 303 and the circumferential limiting groove 3171.

In an embodiment, a plurality of circumferential limiting grooves 3171 are spaced and provided on the first axial limiting boss 317, the oil guide part 312 includes a plurality of circumferential limiting bosses 303, and a quantity of circumferential limiting grooves 3171 is equal to that of circumferential limiting bosses 303. In this embodiment of this application, the plurality of circumferential limiting grooves 3171 cooperate with the plurality of circumferential limiting bosses 303, to help enhance stability of the oil guide part 312 in the circumferential direction of the reducer input shaft 330.

In an embodiment, the second axial limiting boss 302 and the circumferential limiting boss 303 are integrally formed. This solution helps enhance structural strength of the second axial limiting boss 302 and the circumferential limiting boss 303. In addition, because there is no gap between the second axial limiting boss 302 and the circumferential limiting boss 303 in the first direction Y, the second axial limiting boss 302 and the first axial limiting boss 317 are more closely stacked along the first direction Y, to help enhance limiting effect of the oil guide part 312 in the axial direction.

In an embodiment, a material of the sealing member 311 is different from that of the oil guide part 312. The material of the sealing member 311 is a metal material, and the material of the oil guide part 312 is a plastic material. In this embodiment of this application, the sealing member 311 and the oil guide part 312 have different functions. The sealing member 311 mainly performs sealing and axial limiting functions. The material of the sealing member 311 needs to have specific rigidity. The oil guide part 312 mainly performs a function of guiding the flow direction of the cooling oil. The material of the oil guide part 312 needs to be easy for processing. In this solution, the materials of the sealing member 311 and the oil guide part 312 are set to be different, so that the sealing member 311 and the oil guide part 312 meet different use requirements. Specifically, the metal material is used for the sealing member 311, to help improve rigidity of the sealing member 311. In this way, it is ensured that the cooling oil does not leak out of the powertrain 10 from the fastening hole 313. The plastic material is used for the oil guide part 312, to help reduce processing difficulty of the oil guide part radial oil passage 3121 and the oil guide part axial oil passage 3122 and reduce manufacturing costs of the oil guide part 312.

In an embodiment, a melting point of the oil guide part 312 is less than 80°C. This solution helps ensure stability of the oil guide part 312.

In an embodiment, the sealing member 311 and the inner wall of the fastening hole 313 in the reducer end cover 310 are fastened in a sealing manner through threads (not shown in the figure), so that the sealing member and the reducer end cover 310 are fastened in a sealing manner. In this embodiment of this application, the sealing member 311 can limit movement of the oil guide part 312 to the sealing member 311 along the first direction Y. In addition, because the sealing member 311 and the fastening hole 313 are connected in a sealing manner, the sealing member 311 can further seal the cooling oil, to prevent the cooling oil from leaking out of the powertrain 10 from the fastening hole 313. In this solution, a conventional complex structure of an end cover, a bolt, and a seal ring is simplified into the sealing member 311 and the oil guide part 312, to reduce assembly difficulty and reduce costs.

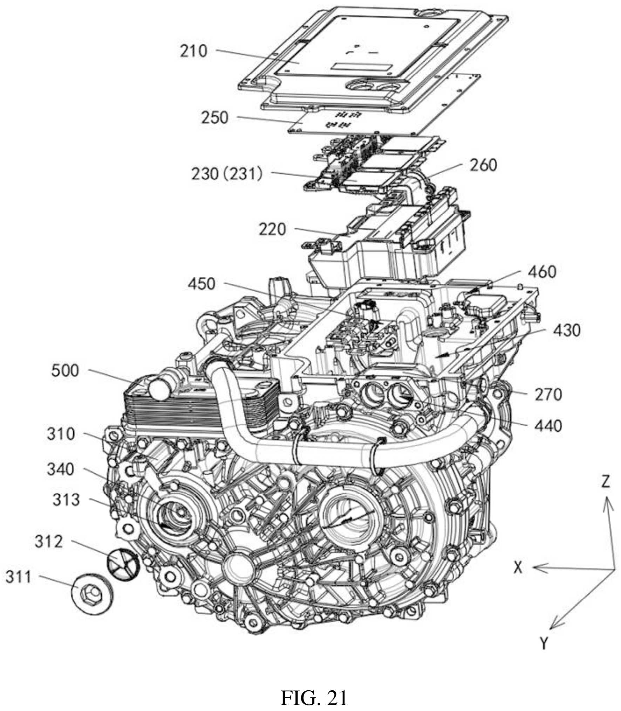

With reference to FIG. 3 and FIG. 21, FIG. 21 is a locally exploded diagram of a powertrain 10 according to an embodiment of this application. In an embodiment, the reducer end cover 310 and the alternating-current output interface mounting hole 450 are arranged relative to each other along the first direction Y (as shown in FIG. 3 and FIG. 21). The direct-current input interface mounting hole 440 and the reducer end cover 310 are arranged on a same side (as shown in FIG. 21).

In this embodiment of this application, the direct-current input interface mounting hole 440 and the alternating-current output interface mounting hole 450 are provided relative to each other along the first direction Y, to avoid electrical interference generated in a transmission process of the direct current and the alternating current, thereby improving security performance. In addition, a layout of the motor controller 200 and the motor 100 is compact and orderly, to help reduce the volume of the powertrain 10 and optimize a layout of the whole vehicle. In this embodiment of this application, a power transmission path among the motor controller 200, the motor 100, and the reducer 300 approximately presents a U shape. It is set that direct-current input interface mounting hole 440 and the reducer end cover 310 are arranged on a same side along the first direction Y, to comply with an energy transmission path, thereby helping reduce an energy loss.

Still with reference to FIG. 21, in an embodiment, the sealing member 311 and the oil guide part 312 are located below the direct-current input interface mounting hole 440 along the second direction Z. Along the first direction Y, a distance between the direct-current input interface mounting hole 440 and at least one of the sealing member 311 and the oil guide part 312 is less than a distance between the alternating-current output interface mounting hole 450 and at least one of the sealing member 311 and the oil guide part 312. In this embodiment of this application, the reducer 300 is located below the motor controller 200 in the second direction Z. The sealing member 311 and the oil guide part 312 are located below the direct-current input interface mounting hole 440. In the first direction Y, the sealing member 311 and the oil guide part 312 are closer to the direct-current input interface mounting hole 440 than the alternating-current output interface mounting hole 450. In consideration of the U-shaped power transmission path among the motor 100, the motor controller 200, and the reducer 300, components in the powertrain 10 are appropriately arranged in this solution, to help reduce the total volume of the powertrain 10 and improve power density.

Still with reference to FIG. 21, in an embodiment, the reducer end cover 310 and the controller accommodating cavity 430 are arranged along the first direction Y, and a projection of the sealing member 311 does not overlap a projection of either of the capacitor module 220 and the power module 230 along the first direction Y. In this embodiment of this application, if the projection of the sealing member 311 at least partially overlaps the projections of the capacitor module 220 and the power module 230 along the first direction Y, the sealing member 311 occupies an adjacent region of the capacitor module 220 and the power module 230 along the first direction Y, and further causes interference to energy transmission of the motor controller 200. In this solution, positions of the sealing member 311, the capacitor module 220, and the power module 230 are appropriately arranged, to ensure normal working of both the reducer 300 and the motor controller 200 without mutual impact.

Still with reference to FIG. 21, in an embodiment, a projection of either of the sealing member 311 and the oil guide part 312 and a projection of the power interface mounting hole 460 do not overlap along the first direction Y. The power interface mounting hole 460 and the oil passage of the reducer 300 are spaced, or the controller accommodating cavity in which the power interface mounting hole 460 is located is spaced from the oil guide part 312 and the sealing member 311. In this way, there is sufficient space around the power interface in the power interface mounting hole 460 to connect to a power cable, to facilitate a charging operation. In this solution, positions of the sealing member 311, the oil guide part 312, and the power interface mounting hole 460 are appropriately arranged, to ensure normal working of both the reducer 300 and the motor controller 200 without mutual impact.

Still with reference to FIG. 21, in an embodiment, either of the sealing member 311 and the oil guide part 312 and the power interface mounting hole 460 are spaced and arranged along the second direction Z and the third direction X. In this embodiment of this application, no energy is transmitted among the sealing member 311, the oil guide part 312, and the power interface mounting hole 460. The sealing member 311 and the oil guide part 312 are both spaced from the power interface mounting hole 460 in the second direction Z and the third direction X. Therefore, there is sufficient space around the power interface in the power interface mounting hole 460 to connect to the power cable, to facilitate a charging operation.

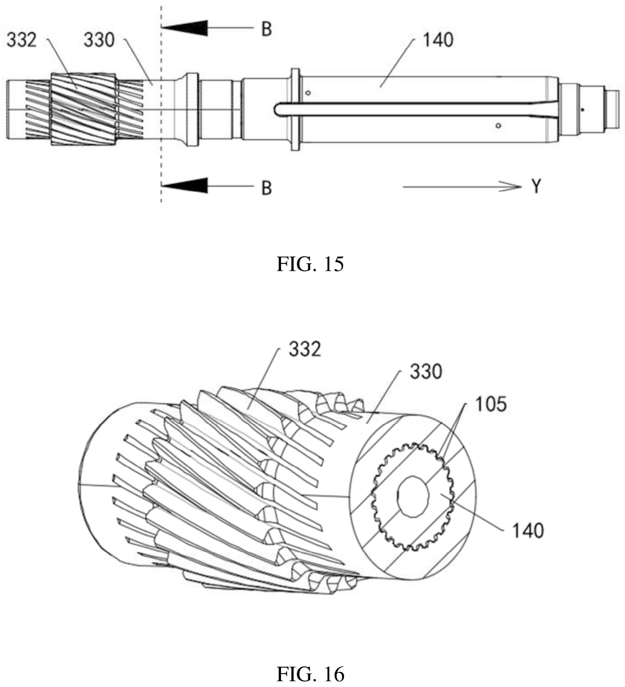

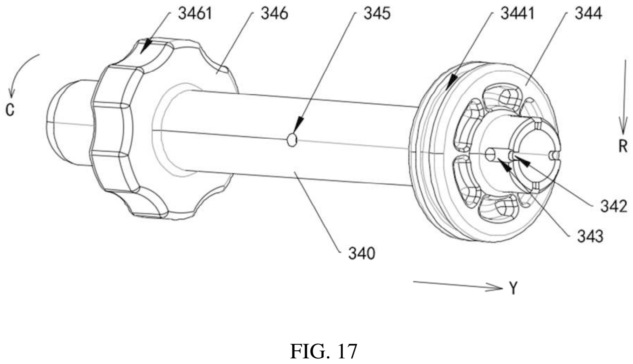

With reference to FIG. 12, and FIG. 15 to FIG. 17, FIG. 15 is a diagram of structures of a reducer input shaft 330 and a motor shaft 140 according to an embodiment of this application, FIG. 16 is a sectional view of the reducer input shaft 330 and the motor shaft 140 shown in FIG. 15 along BB, and FIG. 17 is a diagram of a structure of an oil passing pipe 340 according to an embodiment of this application.

In an embodiment, the motor shaft 140 and the reducer input shaft 330 are fixedly connected through a spline 105 along the motor radial direction R (as shown in FIG. 12, FIG. 15, and FIG. 16), and the oil passing pipe 340 includes at least one spline lubricating oil hole 342 (as shown in FIG. 17). The motor shaft cavity 143 is configured to accommodate a part of the oil passing pipe 340 (as shown in FIG. 12). Projections of the oil passing pipe 340, the motor shaft 140, and the reducer input shaft 330 partially overlap along the motor radial direction R (as shown in FIG. 12). The spline lubricating oil hole 342 penetrates the oil passing pipe 340 along the motor radial direction R (as shown in FIG. 17). Projections of the spline lubricating oil hole 342, the motor shaft 140, and the reducer input shaft 330 partially overlap along the motor radial direction R (as shown in FIG. 12 and FIG. 17). The motor radial direction R is the radial direction of the motor shaft 140.

In this embodiment of this application, the splines 105 are correspondingly disposed on an outer wall of a part of the motor shaft 140 and an inner wall of a part of the reducer shaft cavity 331. The spline of the motor shaft 140 cooperates with the spline of the reducer shaft cavity 331, so that the motor shaft 140 can transmit torque to the reducer input shaft 330 through the splines 105, to implement a connection between the motor shaft 140 and the reducer input shaft 330 in a transmission manner. In the following implementation, the spline 105 may be the spline of the motor shaft 140, or the spline of the reducer input shaft 330, or the spline of the motor shaft 140 and the spline of the reducer input shaft 330.

The spline 105 may be worn out during torque transmit. To avoid failure, the spline 105 needs to be appropriately lubricated. In this embodiment of this application, the oil passing pipe 340 includes at least one spline lubricating oil hole 342. The spline lubricating oil hole 342 is configured to transmit the cooling oil to the spline 105. The spline lubricating oil hole 342 penetrates the motor shaft 140 along the motor radial direction R. Projections of the spline lubricating oil hole 342, the motor shaft 140, and the reducer input shaft 330 partially overlap in the motor radial direction R. In this way, the cooling oil flowing into the oil passing pipe 340 can flow to the splines 105 of the motor shaft 140 and the reducer input shaft 330 through the spline lubricating oil hole 342, to lubricate the spline 105 and reduce abrasion.

It should be noted that, in this embodiment of this application, the projection along the motor radial direction R is a projection along the motor radial direction R on a projection surface perpendicular to the motor radial direction R. The projection surface of the projection along the motor radial direction R is perpendicular to the motor radial direction R. The projection along the motor axial direction Y is a projection along the motor axial direction Y on a projection surface perpendicular to the motor axial direction Y. The projection surface of the projection along the motor axial direction Y is perpendicular to the motor axial direction Y.

In this embodiment of this application, projection surfaces of projections of the oil passing pipe 340, the spline lubricating oil hole 342, the motor shaft 140, and the reducer input shaft 330 along the motor radial direction R are the same.

In an embodiment, the spline lubricating oil hole 342 is provided in a part of the oil passing pipe 340 located in the motor shaft cavity 143.

Still with reference to FIG. 14 and FIG. 17, in an embodiment, the oil passing pipe 340 includes at least one spline oil guide groove 343 (as shown in FIG. 17 and FIG. 14), and the spline oil guide groove 343 communicates with the spline lubricating oil hole 342 (as shown in FIG. 17). The spline oil guide groove 343 is concave from the outer circumferential surface of the oil passing pipe 340 in a direction away from the reducer input shaft 330 along the motor radial direction R (as shown in FIG. 17). The spline lubricating oil hole 342 communicates with an end surface of the oil passing pipe 340 along the motor axial direction Y (as shown in FIG. 17). Projections of the spline oil guide groove 343, the motor shaft 140, and the reducer input shaft 330 partially overlap along the motor radial direction R (as shown in FIG. 17 and FIG. 14). The spline 105, the spline lubricating oil hole 342, and the spline oil guide groove 343 are arranged along the motor axial direction Y (as shown in FIG. 17 and FIG. 14). The spline lubricating oil hole 342 and the spline oil guide groove 343 are adjacent along the motor axial direction Y (as shown in FIG. 17).

In this embodiment of this application, the spline lubricating oil hole 342 is located in the motor shaft cavity 143. A function of the spline lubricating oil hole 342 is mainly to guide the cooling oil to the outer side of the oil passing pipe 340. In this case, the flow direction of the cooling oil needs to be further guided, to enable the cooling oil flowing out of the spline lubricating oil hole 342 to flow to the spline 105 on an outer side of the motor shaft cavity 143. In this solution, the spline oil guide groove 343 is provided in the oil passing pipe 340. The spline oil guide groove 343 communicates with the spline lubricating oil hole 342. The spline lubricating oil hole 342 and the spline oil guide groove 343 are adjacently provided along the motor axial direction Y. The spline oil guide groove 343 is concave from the outer circumferential surface of the oil passing pipe 340 in the direction away from the reducer input shaft 330. In this way, the spline oil guide groove 343 can be used to transport the cooling oil flowing out of the spline lubricating oil hole 342 to the spline 105.

In this embodiment of this application, the spline lubricating oil hole 342 communicates with the end surface of the oil passing pipe 340 in the motor axial direction Y, and the spline lubricating oil hole 342 and the end surface of the oil passing pipe 340 form a groove. In some implementations, the spline lubricating oil hole 342 does not communicate with the end surface of the oil passing pipe 340 in the motor axial direction Y. In this case, the spline lubricating oil hole 342 is an independent through hole.

Still with reference to FIG. 17, in an embodiment, the oil passing pipe 340 includes a plurality of spline lubricating oil holes 342 and a plurality of spline oil guide grooves 343, and each spline lubricating oil hole 342 is adjacent to and communicates with one spline oil guide groove 343 along the motor axial direction Y. The plurality of spline lubricating oil holes 342 are spaced and arranged along the motor circumferential direction C, and the plurality of spline oil guide grooves 343 are spaced and arranged along the motor circumferential direction C. Along the motor axial direction Y, a hole diameter of the spline lubricating oil hole 342 is less than a length of the spline oil guide groove 343. Along the motor circumferential direction C, a hole diameter of the spline lubricating oil hole 342 is less than a width of the spline oil guide groove 343. The motor circumferential direction C is a circumferential direction of the motor shaft 140.

In this embodiment of this application, the plurality of spline lubricating oil holes 342 and the plurality of spline oil guide grooves 343 are correspondingly provided in the oil passing pipe 340. The plurality of spline lubricating oil holes 342 are spaced and arranged along the motor circumferential direction C. The plurality of spline oil guide grooves 343 are spaced and arranged along the motor circumferential direction C. In this way, the cooling oil can flow to the spline 105 of the motor shaft 140 and the spline 105 of the reducer input shaft 330 from different positions, to improve lubrication effect of the cooling oil on the splines 105 and avoid failure of the splines 105.

In this embodiment of this application, in the motor axial direction Y, the hole diameter of the spline lubricating oil hole 342 is set to be less than the length of the spline oil guide groove 343. The hole diameter of the spline lubricating oil hole 342 is relatively small. This can avoid an excessively large through hole provided on the end surface of the oil passing pipe 340, to improve structural strength of the oil passing pipe 340. However, the spline oil guide groove 343 has a relatively large length in the motor axial direction Y, to help the spline oil guide groove 343 guide a flow direction. If the length of the spline oil guide groove 343 is excessively short, it may be difficult for the cooling oil to flow to the spline 105. In the motor circumferential direction C, the width of the spline oil guide groove 343 is set to be greater than the hole diameter of the spline lubricating oil hole 342, to help reduce flow resistance of the cooling oil in the spline oil guide groove 343.

Still with reference to FIG. 14 and FIG. 17, in an embodiment, the powertrain 10 further includes a first fastening structure 344 (as shown in FIG. 14 and FIG. 17), and the oil passing pipe 340 is fastened to the inner wall of the reducer shaft cavity 331 in a sealing manner by using the first fastening structure 344. The oil passing pipe 340, the first fastening structure 344, and the reducer 300 are sequentially arranged along the motor radial direction R (as shown in FIG. 14). Along the motor axial direction Y, the motor shaft 140 and the first fastening structure 344 are spaced and arranged (as shown in FIG. 14), the spline 105 and the first fastening structure 344 are spaced and arranged (as shown in FIG. 14), and a distance between the motor shaft 140 and the first fastening structure 344 is less than a distance between the spline 105 and the first fastening structure 344. The spline lubricating oil hole 342, the spline oil guide groove 343, and the first fastening structure 344 are arranged along the motor axial direction Y (as shown in FIG. 17).

In this embodiment of this application, the first fastening structure 344 is located between the oil passing pipe 340 and the reducer shaft cavity 331 in the motor radial direction R, and the oil passing pipe 340 is fastened in the reducer shaft cavity 331 along the motor radial direction R by using the first fastening structure 344. In an embodiment, an interference fit is implemented between the first fastening structure 344 and the inner wall of the reducer shaft cavity 331, to help keep relative fastening between the oil passing pipe 340 and the reducer shaft cavity 331, so that the oil passing pipe 340 can stably transmit the cooling oil. In the motor axial direction Y, the spline lubricating oil hole 342, the spline oil guide groove 343, and the first fastening structure 344 are arranged along the motor axial direction Y. There are gaps between the first fastening structure 344 and the motor shaft 140, and between the first fastening structure 344 and the spline 105. In this way, the cooling oil flows to the spline 105 through the foregoing two gaps after flowing through the spline lubricating oil hole 342 and the spline oil guide groove 343.

Still with reference to FIG. 14, in an embodiment, a distance between the motor shaft 140 and the first fastening structure 344 is less than a distance between the spline 105 and the first fastening structure 344 in the motor axial direction Y. The distance between the motor shaft 140 and the first fastening structure 344 is a distance between the first fastening structure 344 and an end surface that is of the motor shaft 140 and that is close to the first fastening structure 344. In the motor axial direction Y, the spline 105 is located on a side that is of an end surface of the motor shaft 140 and that is away from the first fastening structure 344. A flow direction of the cooling oil flowing from the first fastening structure 344 to the spline 105 is the same as an arrangement direction of the reducer 300 and the motor 100. In this way, after the cooling oil flows through the spline 105, another component in the motor 100 can be further cooled and lubricated along the motor axial direction Y, to improve cooling effect for the motor 100.

In an embodiment, the oil passing pipe 340 and the first fastening structure 344 are integrally formed. This solution can enhance stability of a fixed connection between the oil passing pipe 340 and the reducer shaft cavity 331 in the motor radial direction R, to help the first fastening structure 344 stably guide the cooling oil to the spline 105.

Still with reference to FIG. 14 and FIG. 17, in an embodiment, the first fastening structure 344 includes a sealing groove 3441 (as shown in FIG. 17). The sealing groove 3441 is configured to accommodate a sealing ring 3442 (as shown in FIG. 14 and FIG. 17). The first fastening structure 344 is fastened to the reducer input shaft 330 in a sealing manner by using the sealing ring 3442. The sealing groove 3441 is concave from an outer circumferential surface of the first fastening structure 344 in a direction away from the reducer input shaft 330 along the motor radial direction R (as shown in FIG. 14 and FIG. 17). Along the motor circumferential direction C, both the sealing groove 3441 and the first fastening structure 344 both circle the oil passing pipe 340 (as shown in FIG. 17).

In this embodiment of this application, the sealing groove 3441 is concave towards the oil passing pipe 340 along the motor radial direction R. The sealing ring 3442 is placed in the sealing groove 3441. The sealing ring 3442 is located between the sealing groove 3441 and the inner wall of the reducer shaft cavity 331 in the motor radial direction R. If sealing effect between the first fastening structure 344 and the reducer shaft cavity 331 is not good, when the cooling oil flows to the first fastening structure 344, the cooling oil may flow away from the spline 105 through a gap between the first fastening structure 344 and the reducer shaft cavity 331, thereby adversely affecting lubrication effect of the spline 105 and causing a waste of the cooling oil. Two ends of the sealing groove 3441 along the motor axial direction Y are fastened with the reducer shaft cavity 331 in the motor radial direction R. The first fastening structure 344, the sealing groove 3441, and the sealing ring 3442 are jointly configured to implement sealing and fastening of the oil passing pipe 340 and the reducer input shaft 330, avoid relative displacement between the oil passing pipe 340 and the reducer input shaft 330, prevent the cooling oil from flowing in a direction away from the spline 105, and improve utilization of the cooling oil.

In this embodiment of this application, a region enclosed by the reducer shaft cavity 331 is approximately cylindrical, and the sealing groove 3441 and the first fastening structure 344 circle the oil passing pipe 340 along the motor circumferential direction C, to adapt to a structural feature of the reducer shaft cavity 331 and help strengthen sealing and fastening effect of the first fastening structure 344 and the reducer shaft cavity 331.

Still with reference to FIG. 14 and FIG. 17, in an embodiment, the oil passing pipe 340 includes a bearing lubricating oil hole 345 (as shown in FIG. 14 and FIG. 17). Along the motor radial direction R, the bearing lubricating oil hole 345 penetrates the oil passing pipe 340 (as shown in FIG. 14 and FIG. 17), and the bearing lubricating oil hole 345 and the inner wall of the reducer shaft cavity 331 are spaced and arranged (as shown in FIG. 14 and FIG. 17). The spline lubricating oil hole 342, the first fastening structure 344, and the bearing lubricating oil hole 345 are spaced and arranged along the motor axial direction Y (as shown in FIG. 17).

In this embodiment of this application, the bearing lubricating oil hole 345 is configured to transmit the cooling oil to the reducer bearing 350, to lubricate the reducer bearing 350. The reducer bearing 350 is configured to bear a load from the reducer input shaft 330. If the reducer bearing 350 is not sufficiently lubricated, the reducer bearing 350 is prone to ablation or damage, which interferes with normal running of the reducer 300. In the motor radial direction R, the bearing lubricating oil hole 345 penetrates the oil passing pipe 340, and there is a gap between the bearing lubricating oil hole 345 and the inner wall of the reducer shaft cavity 331. In this way, the cooling oil in the oil passing pipe 340 can flow through the bearing lubricating oil hole 345 to the gap between the bearing lubricating oil hole 345 and the inner wall of the reducer shaft cavity 331, to provide a precondition for the cooling oil flowing to the reducer bearing 350. The cooling oil sequentially flows to the bearing lubricating oil hole 345 and the spline lubricating oil hole 342 in the oil passing pipe 340. The bearing lubricating oil hole 345, the first fastening structure 344, and the spline lubricating oil hole 342 are spaced and arranged in the motor axial direction Y, to avoid crosstalk between the cooling oil flowing to the reducer bearing 350 and the cooling oil flowing to the spline 105, thereby improving lubrication effect of the reducer bearing 350 and the spline 105.

Still with reference to FIG. 14 and FIG. 17, in an embodiment, the powertrain 10 further includes a second fastening structure 346 (as shown in FIG. 14 and FIG. 17). The second fastening structure 346 includes at least one bearing lubricating oil groove 3461 (as shown in FIG. 14 and FIG. 17). The bearing lubricating oil hole 345 communicates with the bearing lubricating oil groove 3461. The oil passing pipe 340 is fastened to the inner wall of the reducer shaft cavity 331 by using the second fastening structure 346. The bearing lubricating oil groove 3461 is concave from an outer circumferential surface of the second fastening structure 346 towards the oil passing pipe 340 along the motor radial direction R (as shown in FIG. 17). The oil passing pipe 340, the second fastening structure 346, and the reducer input shaft 330 are sequentially arranged along the motor radial direction R (as shown in FIG. 14 and FIG. 17). Along the motor axial direction Y, the bearing lubricating oil groove 3461 penetrates the second fastening structure 346 (as shown in FIG. 17), and the spline lubricating oil hole 342, the first fastening structure 344, the bearing lubricating oil hole 345, and the second fastening structure 346 are spaced and arranged (as shown in FIG. 14 and FIG. 17).

In this embodiment of this application, the second fastening structure 346 is located between the oil passing pipe 340 and the reducer shaft cavity 331 in the motor radial direction R. The bearing lubricating oil groove 3461 is concave towards the oil passing pipe 340 along the motor radial direction R. A part of an outer circumferential surface of the second fastening structure 346 except the bearing lubricating oil groove 3461 is used to fasten the oil passing pipe 340 and the reducer shaft cavity 331. The bearing lubricating oil groove 3461 communicates with the bearing lubricating oil hole 345. The bearing lubricating oil groove 3461 penetrates the second fastening structure 346 along the motor axial direction Y, so that the bearing lubricating oil groove 3461 guides the flow direction of the cooling oil. Specifically, after the cooling oil flows out of the bearing lubricating oil hole 345 to a gap between the oil passing pipe 340 and the reducer shaft cavity 331, the cooling oil is guided to the reducer bearing 350 by using the bearing lubricating oil groove 3461, to lubricate the reducer bearing 350.

In an embodiment, the second fastening structure 346 and the oil passing pipe 340 are integrally formed. This solution can enhance stability of a fixed connection between the oil passing pipe 340 and the reducer shaft cavity 331 in the motor radial direction, to help the second fastening structure 346 stably guide the flow direction of the cooling oil.

Still with reference to FIG. 12 and FIG. 14, in an embodiment, along the motor axial direction Y, a length of the oil passing pipe 340 is less than a length of the reducer input shaft 330 (as shown in FIG. 12), and both lengths of the first fastening structure 344 and the second fastening structure 346 are less than a distance between the first fastening structure 344 and the second fastening structure 346 (as shown in FIG. 14).

In this embodiment of this application, in the motor axial direction Y, the length of the oil passing pipe 340 is denoted as D8 (as shown in FIG. 12), the length of the reducer input shaft 330 is denoted as D9, the length of the first fastening structure 344 is denoted as D10 (as shown in FIG. 14), the length of the second fastening structure 346 is denoted as D11, and the distance between the first fastening structure 344 and the second fastening structure 346 is denoted as D12.

Because both the oil passing pipe 340 and a part of the motor shaft 140 are located in the reducer shaft cavity 331, D8<D9 is set in this solution (as shown in FIG. 12), to provide space for accommodating the part of the motor shaft 140 in the reducer shaft cavity 331. In addition, a dimension of the oil passing pipe 340 along the motor axial direction Y is relatively small to help reduce costs. The first fastening structure 344 and the second fastening structure 346 perform similar functions in the reducer 300, and are both configured to fasten the oil passing pipe 340 and the reducer shaft cavity 331 and guide the flow direction of the cooling oil. An interference fit is implemented between the reducer shaft cavity 331 and each of the first fastening structure 344 and the second fastening structure 346 to implement mutual fastening. D10<D12 and D11<D12 are set in this solution (as shown in FIG. 14). In this way, assembly difficulty of the first fastening structure 344 and the second fastening structure 346 in the reducer shaft cavity 331 can be reduced, and manufacturing costs can be reduced. In addition, a length of the second fastening structure 346 in the motor axial direction Y is equivalent to a length of the bearing lubricating oil groove 3461 in the motor axial direction Y. Therefore, D11<D12 is set. In addition, a transmission path of the cooling oil in the bearing lubricating oil groove 3461 can be shortened, to help reduce a transmission loss of the cooling oil between the bearing lubricating oil hole 345 and the reducer bearing 350.

Still with reference to FIG. 14, along the motor axial direction Y, a distance between the first fastening structure 344 and the spline lubricating oil hole 342 is less than the distance between the first fastening structure 344 and the second fastening structure 346. Along the motor axial direction Y, a distance between the first fastening structure 344 and the bearing lubricating oil hole 345 is greater than the distance between the first fastening structure 344 and the spline lubricating oil hole 342. In this embodiment of this application, in the motor axial direction Y, the distance between the first fastening structure 344 and the spline lubricating oil hole 342 is denoted as D13, and the distance between the first fastening structure 344 and the bearing lubricating oil hole 345 is denoted as D14. D13<D12 and D13<D14 are set in this solution (as shown in FIG. 14). The distance between the first fastening structure 344 and the spline lubricating oil hole 342 is relatively small, to shorten a cooling path of the cooling oil between the spline lubricating oil hole 342 and the first fastening structure 344, thereby reducing a loss of the cooling oil. However, the distance between the first fastening structure 344 and the second fastening structure 346 and the distance between the first fastening structure 344 and the bearing lubricating oil hole 345 are relatively large, to avoid mutual interference between the cooling oil flowing to the spline 105 and the cooling oil flowing to the reducer bearing 350, thereby helping improve lubrication effect of the spline 105 and the reducer bearing 350.

In an embodiment, a distance between the second fastening structure 346 and the bearing lubricating oil hole 345 is greater than the distance between the first fastening structure 344 and the spline lubricating oil hole 342. In this embodiment of this application, the distance between the second fastening structure 346 and the bearing lubricating oil hole 345 in the motor axial direction Y is denoted as D15. D13<D15 is set in this solution (as shown in FIG. 14). The distance between the first fastening structure 344 and the spline lubricating oil hole 342 is relatively small, to shorten a cooling path of the cooling oil between the spline lubricating oil hole 342 and the first fastening structure 344, thereby reducing a loss of the cooling oil.

Still with reference to FIG. 17, in an embodiment, the second fastening structure 346 includes a plurality of bearing lubricating oil grooves 3461, and the plurality of bearing lubricating oil grooves 3461 are spaced and arranged along the motor circumferential direction C. A hole diameter of the bearing lubricating oil hole 345 is less than a length of each bearing lubricating oil groove 3461 along the motor axial direction Y. A hole diameter of the bearing lubricating oil hole 345 is less than a length of each bearing lubricating oil groove 3461 along the motor circumferential direction C.

In this embodiment of this application, the plurality of bearing lubricating oil grooves 3461 are spaced on the second fastening structure 346 along the motor circumferential direction C, so that the cooling oil can flow to the reducer bearing 350 from different positions through the plurality of bearing lubricating oil grooves 3461, to enhance lubrication effect of the reducer bearing 350. The hole diameter of the bearing lubricating oil hole 345 is less than the length of each bearing lubricating oil groove 3461 along the motor axial direction Y and the length of each bearing lubricating oil groove 3461 along the motor circumferential direction C. The hole diameter of the bearing lubricating oil hole 345 is relatively small, to avoid a through hole with an excessively large hole diameter in the oil passing pipe 340, thereby improving structural strength of the oil passing pipe 340. In addition, this helps limit a flow quantity of the cooling oil flowing through the bearing lubricating oil hole 345. In this way, the cooling oil in the oil passing pipe 340 is mainly used to cool heat-emitting components in the reducer 300 and the motor 100. The lengths of the bearing lubricating oil groove 3461 along the motor axial direction Y and along the motor circumferential direction C are relatively large, to ensure a flow guiding function of the bearing lubricating oil hole 345 for the cooling oil, so that the cooling oil flowing through the bearing lubricating oil hole 345 can specifically lubricate the reducer bearing 350.

Still with reference to FIG. 14 and FIG. 16, in an embodiment, the reducer 300 includes a deceleration gear 332 and a reducer bearing 350 (as shown in FIG. 14 and FIG. 16), the deceleration gear 332 is fastened to an outer circumferential surface of the reducer input shaft 330 along the motor radial direction R (as shown in FIG. 14 and FIG. 16), and the reducer bearing 350 is sleeved on the reducer input shaft 330 (as shown in FIG. 14). The motor shaft 140, the deceleration gear 332, and the reducer bearing 350 are spaced and arranged along the motor axial direction Y (as shown in FIG. 14). A projection of the bearing lubricating oil hole 345 along the motor radial direction R partially overlaps a projection of the deceleration gear 332 along the motor radial direction R (as shown in FIG. 14). A projection of the second fastening structure 346 along the motor radial direction R partially overlaps the projection of the reducer bearing 350 along the motor radial direction R (as shown in FIG. 14).

In this embodiment of this application, the deceleration gear 332 is configured to engage with a gear assembly in the reducer 300 and drive the gear assembly to rotate (not shown in the figure), and the gear assembly is configured to connect to the wheel in a transmission manner and drive the wheel to rotate (not shown in the figure).

In this embodiment of this application, the reducer bearing 350 is sleeved on the reducer input shaft 330, and the reducer bearing 350 is configured to bear a load applied by the reducer input shaft 330. The cooling oil can pass through the bearing lubricating oil hole 345 to lubricate the reducer bearing 350. This helps prolong a service life of the reducer bearing 350. The motor shaft 140, the deceleration gear 332, and the reducer bearing 350 are spaced and disposed in the motor axial direction Y, to avoid mutual interference in a mechanical transmission process and ensure normal running of the reducer 300 and the motor 100. The projection of the bearing lubricating oil hole 345 partially overlaps a projection of the deceleration gear 332 in the motor radial direction R. The projection of the second fastening structure 346 along the motor radial direction R partially overlaps the projection of the reducer bearing 350 along the motor radial direction R. This indicates that the reducer bearing 350 and the deceleration gear 332 are adjacently disposed in the motor axial direction Y. In an embodiment, there is a gap in the reducer bearing 350, and the cooling oil flowing into the reducer bearing 350 flows to the deceleration gear 332 through the gap in the reducer bearing 350. The cooling oil sequentially lubricates the reducer bearing 350 and the deceleration gear 332 to ensure normal working of the reducer 300.

A projection surface of the projection of the bearing lubricating oil hole 345 along the motor radial direction R is the same as a projection surface of the projection of the deceleration gear 332 along the motor radial direction R. A projection surface of the projection of the second fastening structure 346 along the motor radial direction R is the same as a projection surface of the projection of the reducer bearing 350 along the motor radial direction R.

In an embodiment, the reducer end cover 310 further includes the reducer bearing chamber 315 (as shown in FIG. 14). The reducer bearing chamber 315 is concave from the reducer end cover 310 in a direction away from the reducer input shaft 330 along the first direction Y. The reducer bearing 350 is sleeved on the reducer input shaft 330 and is located in the reducer bearing chamber 315. The reducer bearing chamber 315 communicates with the bearing lubricating oil groove 3461. In this embodiment of this application, the cooling oil in the oil passing pipe 340 sequentially flows through the bearing lubricating oil hole 345 and the bearing lubricating oil groove 3461, and then flows to the reducer bearing chamber 315 through a gap between the reducer input shaft 330 and the reducer end cover 310, to lubricate the reducer bearing 350 and avoid damage to the reducer bearing 350, thereby prolonging a service life and ensuring long-term stable running of the reducer 300. The reducer bearing chamber 315 can be further configured to temporarily store a liquid, to better lubricate the reducer bearing 350.

Still with reference to FIG. 14, in an embodiment, the reducer input shaft 330 and the reducer end cover 310 are spaced and arranged, and the oil passing pipe 340, the oil guide part 312, and the sealing member 311 are spaced and arranged. The deceleration gear 332, the reducer bearing 350, the oil guide part 312, and the sealing member 311 are spaced and arranged along the motor axial direction Y.

In this embodiment of this application, the reducer input shaft 330 and the reducer end cover 310 are spaced and disposed in the motor axial direction Y, to provide space for disposing the oil guide part 312 between the reducer end cover 310 and the reducer input shaft 330. The sealing member 311 and the oil guide part 312 are spaced and arranged along the motor axial direction Y, to effectively reduce acting force and abrasion on the oil guide part 312, thereby prolonging a service life and ensuring flow guiding effect of the oil guide part 312. The deceleration gear and the reducer bearing 350 are spaced and disposed in the motor axial direction Y, to avoid abrasion between the deceleration gear and the reducer bearing 350, thereby prolonging a service life. The deceleration gear 332 and the reducer bearing 350 are spaced from the oil guide part 312 and the sealing member 311. In this way, assembly of the foregoing structures is not affected even if there is a design tolerance, thereby reducing design and assembly difficulty.

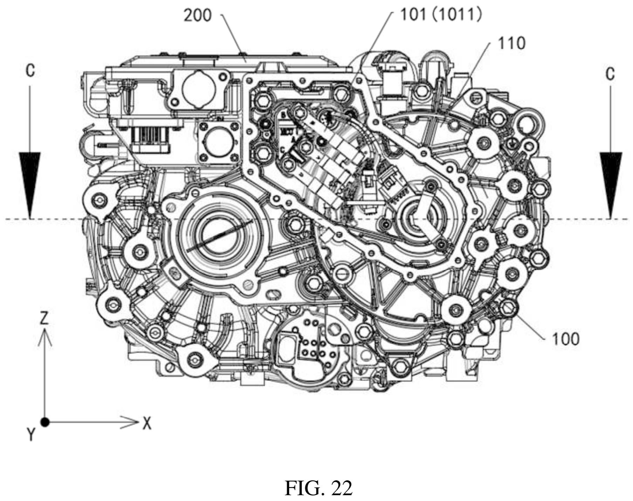

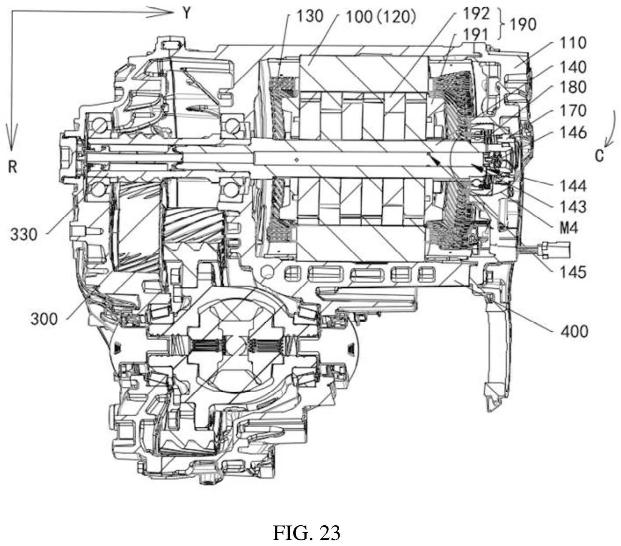

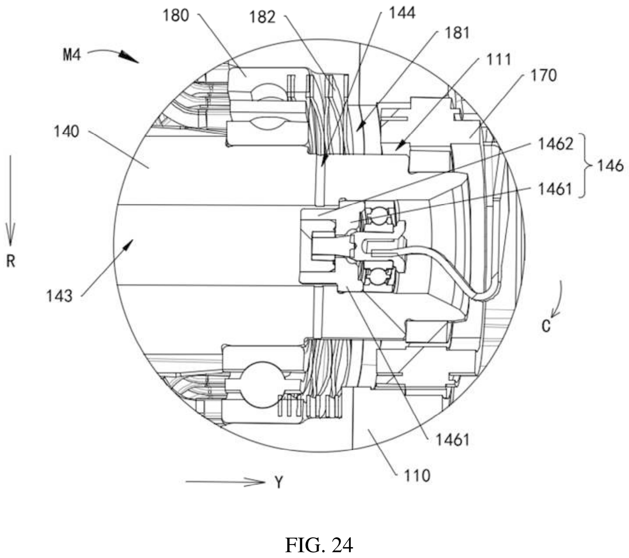

With reference to FIG. 22 to FIG. 24, FIG. 22 is a diagram of a structure of a powertrain 10 according to an embodiment of this application, FIG. 23 is a sectional view of the powertrain 10 shown in FIG. 22 along CC, and FIG. 24 is a locally enlarged diagram of an M4 part of the powertrain 10 shown in FIG. 23.

In an embodiment, the motor 100 includes a motor rotor 190 and a motor bearing 180 (as shown in FIG. 22 to FIG. 24), and the motor end cover 110 and the motor rotor 190 are spaced and arranged along the motor axial direction Y (as shown in FIG. 23). The motor end cover 110 includes a motor shaft hole 111 (as shown in FIG. 24). The motor shaft hole 111 is configured to accommodate the motor bearing 180 and a part of the motor shaft 140 (as shown in FIG. 23 and FIG. 24). The motor bearing 180 is sleeved on the motor shaft 140 (as shown in FIG. 23 and FIG. 24). The motor shaft 140 is rotationally connected to the motor end cover 110 through the motor bearing 180. The motor shaft 140 includes at least one motor bearing lubricating oil hole 144 (as shown in FIG. 24). The motor shaft hole 111 penetrates the motor end cover 110 along the motor axial direction Y. The motor bearing lubricating oil hole 144 penetrates the motor shaft 140 along the motor radial direction R (as shown in FIG. 24). The motor bearing lubricating oil hole 144, the motor bearing 180, and the motor rotor 190 are spaced and arranged along the motor axial direction Y (as shown in FIG. 23 and FIG. 24).

In this embodiment of this application, the motor rotor 190 is fixedly connected to the motor shaft 140 and is rotationally connected to the motor end cover 110, so that the motor shaft 140 rotates with the motor rotor 190 relative to the motor end cover 110. The motor stator 120 is rotationally connected to the motor shaft 140, so that the motor shaft 140 can rotate relative to the motor stator 120 to convert electric energy into mechanical energy. The output end of the motor shaft 140 is configured to transmit the mechanical energy. In this embodiment of this application, the motor winding 130 is a winding in the motor stator 120. In an embodiment, the motor winding 130 further includes a winding in the motor rotor, or a winding of the motor stator and a winding of the motor rotor.

In this embodiment of this application, the motor bearing 180 is sleeved on an outer side of the motor shaft 140, and space enclosed by an inner side of the motor shaft 140 forms the motor shaft cavity 143. The motor bearing 180 is configured to bear a load from the motor shaft 140, reduce friction, and ensure stable running of the motor 100 in a high-speed working condition. If the motor bearing 180 is not sufficiently lubricated, the motor bearing 180 may be ablated or damaged. In this embodiment of this application, the motor bearing lubricating oil hole 144 penetrates the motor shaft 140 along the motor radial direction R, and the motor bearing lubricating oil hole 144 communicates with the motor shaft cavity 143, so that cooling oil in the motor shaft cavity 143 can be transmitted to the motor bearing 180 on the outer side of the motor shaft 140 through the motor bearing lubricating oil hole 144. In an embodiment, the motor bearing 180 includes steel balls and a sleeve ring. The steel balls are movably disposed in the sleeve ring. The cooling oil enters a gap between the steel ball and the sleeve ring through the motor bearing lubricating oil hole 144. This helps reduce abrasion between the steel ball and the sleeve ring, to prolong a service life of the motor bearing 180.

In an embodiment, the motor shaft cavity 143 communicates with the heat exchanger 500 in the vehicle through the reducer shaft cavity 331. The heat exchanger is configured to transmit the cooling oil to the motor shaft cavity 143. The cooling oil enters the motor shaft cavity 143 through the oil passing pipe 340 in the reducer shaft cavity 331. Because the heat exchanger 500 is disposed on a side that is of the motor rotor 190 and that is away from the motor bearing 180 along the motor axial direction Y, if the motor bearing lubricating oil hole 144 is not provided on the motor shaft 140, to lubricate the motor bearing 180, a flow rate or a flow quantity of the cooling oil in the motor 100 needs to be increased. The cooling oil on a side that is of the motor bearing 180 and that is close to the motor rotor 190 along the motor axial direction Y is used for cooling and lubrication. Costs increase because a use quantity of the cooling oil is increased. In addition, it is difficult for the added cooling oil to accurately flow to the motor bearing 180. Lubrication effect is poor. In this embodiment of this application, the through motor bearing lubricating oil hole 144 is provided on the motor shaft 140, so that the cooling oil can be transmitted from the motor shaft cavity 143 on the inner side of the motor shaft 140 to the motor bearing 180 on the outer side of the motor shaft 140 through the motor bearing lubricating oil hole 144. The motor bearing 180 can be effectively lubricated without increasing the use quantity of the cooling oil, to avoid ablation or damage of the motor bearing 180 due to insufficient lubrication, thereby ensuring normal working of the motor 100.

In this embodiment of this application, the cooling oil can be transmitted to the motor bearing 180 through the motor bearing lubricating oil hole 144, to effectively lubricate the motor bearing 180, thereby prolonging a service life of the motor bearing 180 and improving working performance of the motor 100. A small quantity of cooling oil is used, which helps reduce costs. In addition, the cooling oil is used for both cooling and lubrication, which helps improve utilization of the cooling oil.

Still with reference to FIG. 24, in an embodiment, the motor 100 further includes a bearing corrugated gasket 182. The bearing corrugated gasket 182 is sleeved on the motor shaft 140. The bearing corrugated gasket 182 has a gap. The gap of the bearing corrugated gasket 182 is used to communicate with the motor bearing lubricating oil hole 144 and the motor bearing 180. The bearing corrugated gasket 182, the motor bearing 180, and the motor rotor 190 are arranged along the motor axial direction Y. The bearing corrugated gasket 182 is adjacent to the motor bearing 180. A projection of the motor bearing lubricating oil hole 144 along the motor radial direction R is located in a projection of the bearing corrugated gasket 182 along the motor radial direction R.

In this embodiment of this application, the bearing corrugated gasket 182 is a corrugated gasket, and the motor bearing 180 and the bearing corrugated gasket 182 are arranged along the motor axial direction Y, so that the bearing corrugated gasket 182 can bear axial force from the motor bearing 180 and eliminate noise and vibration, thereby improving performance of the motor. The bearing corrugated gasket 182 has the gap. In the motor radial direction R, a projection of the motor bearing lubricating oil hole 144 is located in a projection of the bearing corrugated gasket 182. In this way, after the cooling oil in the motor shaft cavity 143 flows out of the motor bearing lubricating oil hole 144, the cooling oil can sequentially flow to the gap of the bearing corrugated gasket 182 and the motor bearing 180. The projection of the motor bearing lubricating oil hole 144 is a projection of a region enclosed by the motor bearing lubricating oil hole 144. The bearing corrugated gasket 182 is disposed close to the motor bearing 180 along the motor axial direction Y, to help shorten a transmission path of the cooling oil between the motor bearing lubricating oil hole 144 and the motor bearing 180, thereby reducing a loss.

Still with reference to FIG. 24, in an embodiment, the motor shaft 140 includes a plurality of motor bearing lubricating oil holes 144, and the plurality of motor bearing lubricating oil holes 144 are spaced and arranged along the motor circumferential direction C. A hole diameter of each motor bearing lubricating oil hole 144 along the motor axial direction Y is less than a length of the bearing corrugated gasket 182 along the motor axial direction Y. Along the motor circumferential direction C, the hole diameter of each motor bearing lubricating oil hole 144 is less than a distance between two adjacent motor bearing lubricating oil holes 144.

In this embodiment of this application, a plurality of motor bearing lubricating oil holes 144 are spaced and provided on the motor shaft 140, to increase the cooling oil transmitted to the motor bearing 180 and lubricate different parts of the motor bearing 180, thereby avoiding insufficient local lubrication of the motor bearing 180. For example, a quantity of motor bearing lubricating oil holes 144 may be 2, 3, 4, or another positive integer greater than 1. The hole diameter of the motor bearing lubricating oil hole 144 is less than the length of the bearing corrugated gasket 182 along the motor axial direction Y, to ensure that the cooling oil flowing through the motor bearing lubricating oil hole 144 can flow into the gap of the bearing corrugated gasket 182, thereby improving utilization of the cooling oil. The hole diameter of the motor bearing lubricating oil hole 144 is less than the distance between two adjacent motor bearing lubricating oil holes 144 along the motor circumferential direction C. The hole diameter of the motor bearing lubricating oil hole 144 is set in a relatively small range, to avoid an excessively large through hole provided on the motor shaft 140, thereby improving structural strength of the motor shaft 140. The distance between two adjacent motor bearing lubricating oil holes 144 is set in a relatively large range. This is equivalent to limiting a quantity of the motor bearing lubricating oil holes 144. In this way, the following case can be avoided: Excessive cooling oil flows out of the motor shaft cavity 143 from the motor bearing lubricating oil holes 144. This ensures cooling and lubrication effect of the cooling oil on other components in the motor 100.

In an embodiment, the plurality of motor bearing lubricating oil holes 144 are evenly spaced and arranged along the motor circumferential direction C. This solution helps ensure dynamic balance performance of the motor shaft 140.

Still with reference to FIG. 23 and FIG. 24, in an embodiment, the motor 100 further includes a rotary sensor stator 170. The rotary sensor stator 170 and the motor bearing 180 are both sleeved on the motor shaft 140 and located in the motor shaft hole 111 (as shown in FIG. 23 and FIG. 24). The rotary sensor stator 170, the motor bearing 180, and the motor stator 120 are arranged along the axial direction of the motor shaft 140 (as shown in FIG. 23 and FIG. 24). The rotary sensor stator 170, the motor shaft 140, the motor bearing 180, and a hole wall of the motor shaft hole 111 enclose the motor bearing chamber 181 (as shown in FIG. 24). The motor bearing lubricating oil hole communicates with the motor bearing chamber 181 (as shown in FIG. 24).

In this embodiment of this application, the motor bearing 180 and the bearing corrugated gasket are located in the motor bearing chamber 181. The motor bearing lubricating oil hole communicates with the motor bearing chamber 181. The cooling oil can enter the motor bearing chamber 181 through the motor bearing lubricating oil hole to be in contact with the motor bearing 180, to lubricate the motor bearing 180 and avoid damage to the motor bearing 180, thereby prolonging a service life and ensuring long-term stable running of the motor 100. In addition, the motor bearing chamber 181 can be further configured to temporarily store a liquid, to better lubricate the motor bearing 180.

Still with reference to FIG. 23 and FIG. 24, in an embodiment, the motor shaft 140 further includes at least one rotor diverting hole 145 (as shown in FIG. 23). Along the motor radial direction R, the rotor diverting hole 145 penetrates the motor shaft 140, and a projection of the rotor diverting hole 145 at least partially overlaps a projection of the motor rotor 190 (as shown in FIG. 23). The motor bearing lubricating oil hole 144, the motor bearing 180, and the rotor diverting hole 145 are spaced and arranged along the motor axial direction Y (as shown in FIG. 23 and FIG. 24). A hole diameter of the rotor diverting hole 145 is greater than a hole diameter of the motor bearing lubricating oil hole 144 (as shown in FIG. 23 and FIG. 24).

In this embodiment of this application, the motor rotor 190 is sleeved on the outer side of the motor shaft 140, the rotor diverting hole 145 penetrates the motor shaft 140 along the motor radial direction R, and the rotor diverting hole 145 communicates with the motor shaft cavity 143. The projection of the rotor diverting hole 145 at least partially overlaps the projection of the motor rotor 190 in the motor radial direction R, so that the cooling oil in the motor shaft cavity 143 can be transmitted to the motor rotor 190 on the outer side of the motor shaft 140 through the rotor diverting hole 145 to cool the motor rotor 190. The projection of the rotor diverting hole 145 in the radial R of the motor is a projection, in the motor radial direction R, of a region enclosed by the rotor diverting hole 145. When the motor 100 rotates at a high speed, the motor rotor 190 generates a large amount of heat, and the motor rotor 190 needs to be cooled. In this solution, both the motor bearing lubricating oil hole 144 and the rotor diverting hole 145 are provided on the motor shaft 140, and a hole diameter of the rotor diverting hole 145 is greater than a hole diameter of the motor bearing lubricating oil hole 144. Therefore, when the motor 100 is in a high-speed working condition, the cooling oil mainly flows through the rotor diverting hole 145 to cool the motor rotor 190. When the motor 100 is in a low-speed working condition, a part of the cooling oil can pass through the motor bearing lubricating oil hole 144 to lubricate the motor bearing 180, to meet cooling and lubrication requirements of the motor 100 in different cases, thereby improving working performance of the motor 100.

Still with reference to FIG. 23, in an embodiment, the motor rotor 190 includes a rotor end plate 191 and a rotor iron core 192. Both the rotor end plate 191 and the rotor iron core 192 are sleeved on the motor shaft 140. Along the motor axial direction Y, the rotor end plate 191 is arranged on two sides of the rotor iron core 192. The rotor end plate 191 includes an end plate shaft hole (not shown) that penetrates the rotor end plate 191 along the motor axial direction Y. A rotor oil passage is disposed in the rotor iron core 192. The end plate shaft hole is configured to communicate with the rotor oil passage and the rotor diverting hole 145. A projection of the end plate shaft hole in the motor radial direction R covers a projection of the rotor diverting hole 145 in the motor radial direction R. In an embodiment, the end plate shaft hole is further configured to adjust dynamic balance of the motor rotor 190. The rotor end plate 191 may also be referred to as a dynamic balance end plate. In an embodiment, the rotor end plate 191 is configured to perform axial positioning on the rotor iron core 192.

Still with reference to FIG. 23 and FIG. 24, in an embodiment, the motor shaft 140 includes a plurality of motor bearing lubricating oil holes 144 and a plurality of rotor diverting holes 145 (as shown in FIG. 23 and FIG. 24), and the plurality of motor bearing lubricating oil holes 144 are spaced and arranged along the motor circumferential direction C (as shown in FIG. 24). A total length of hole diameters of the plurality of motor bearing lubricating oil holes 144 is less than a total length of hole diameters of the plurality of rotor diverting holes 145 (as shown in FIG. 23 and FIG. 24).

In this embodiment of this application, the plurality of rotor diverting holes 145 are provided on the motor shaft 140, to increase the cooling oil transmitted to the motor rotor 190 to cool different parts of the motor rotor 190, thereby avoiding local overheating of the motor rotor 190. The total length of the hole diameters of the plurality of motor bearing lubricating oil holes 144 is set to be less than the total length of the hole diameters of the plurality of rotor diverting holes 145, to appropriately allocate the cooling oil. In this way, the following case is avoided: Excessive cooling oil is used to lubricate the motor bearing 180, while the motor rotor 190 is insufficiently cooled.

In an embodiment, a ratio of a hole diameter of each rotor diverting hole 145 to a hole diameter of each motor bearing lubricating oil hole 144 is greater than or equal to 2 and less than or equal to 4.

In this embodiment of this application, the hole diameter of the rotor diverting hole 145 and the hole diameter of the motor bearing lubricating oil hole 144 are set to a range greater than or equal to 2 and less than or equal to 4. More cooling oil can flow out of the rotor diverting hole 145. When the motor 100 is in a high-speed working condition, the cooling oil mainly cools the motor rotor 190 through the rotor diverting hole 145. When the motor 100 is in a low-speed working condition, a small part of the cooling oil may lubricate the motor bearing 180 through the motor bearing lubricating oil hole 144.

Still with reference to FIG. 24, in an embodiment, the motor 100 further includes a shaft hole sealing member 146. The shaft hole sealing member 146 includes a radial sealing part 1461 and a lubricating oil circulation part 1462. Along the motor radial direction R, the radial sealing part 1461 is configured to be fastened to the inner wall of the motor shaft cavity 143 in a sealing manner. The radial sealing part 1461, the lubricating oil circulation part 1462, and the rotor diverting hole 145 are arranged along the motor axial direction Y. The lubricating oil circulation part 1462 is fastened on the radial sealing part 1461. Along the motor radial direction R, the lubricating oil circulation part 1462 is spaced from the inner wall of the motor shaft cavity 143. The projection of the motor bearing lubricating oil hole 144 along the motor radial direction R is located in the projection of the lubricating oil circulation part 1462 along the motor radial direction R.

In this embodiment of this application, the shaft hole sealing member 146 includes the radial sealing part 1461 and the lubricating oil circulation part 1462 that are fastened. In the motor axial direction Y, the radial sealing part 1461 is located on a side that is of the lubricating oil circulation part 1462 and that is away from the rotor diverting hole 145. The radial sealing part 1461 is fastened to the inner wall of the motor shaft cavity 143 in a sealing manner. The following case is avoided: The cooling oil flows out of the motor shaft cavity 143 along the motor axial direction Y and does not flow to the motor bearing lubricating oil hole 144. There is a gap between the lubricating oil circulation part 1462 and the inner wall of the motor shaft cavity 143 in the motor radial direction R. The projection of the lubricating oil circulation part 1462 along the motor radial direction R covers the projection of the motor bearing lubricating oil hole 144 along the motor radial direction R. In this way, when the cooling oil in the motor shaft cavity 143 can flow through the shaft hole sealing member 146, the cooling oil can flow to the motor bearing lubricating oil hole 144 through the gap between the lubricating oil circulation part 1462 and the inner wall of the motor shaft cavity 143. In this embodiment of this application, the shaft hole sealing member 146 is disposed in the motor shaft cavity 143, to increase flow resistance of the cooling oil flowing to the motor bearing lubricating oil hole 144 and reduce a hole diameter of the motor shaft 140 corresponding to the motor bearing lubricating oil hole 144 in the motor radial direction R, thereby controlling a flow quantity of the cooling oil used to lubricate the motor bearing 180 and preventing the cooling oil in the motor shaft cavity 143 from directly flowing out of the motor shaft cavity 143 along the motor axial direction Y. In addition, the shaft hole sealing member 146 can further prevent a foreign matter from entering the motor shaft cavity 143.

In an embodiment, the radial sealing part 1461 and the lubricating oil circulation part 1462 are integrally formed. This solution helps enhance structural strength of the shaft hole sealing member 146.

Still with reference to FIG. 23 and FIG. 24, in an embodiment, along the motor radial direction R, a distance between the lubricating oil circulation part 1462 and the inner wall of the motor shaft cavity 143 is less than the hole diameter of the motor bearing lubricating oil hole 144 (as shown in FIG. 24), and the distance between the lubricating oil circulation part 1462 and the inner wall of the motor shaft cavity 143 is less than the hole diameter of the rotor diverting hole 145 (as shown in FIG. 23 and FIG. 24). A length of the lubricating oil circulation part 1462 along the motor axial direction Y is greater than the hole diameter of the motor bearing lubricating oil hole 144 (as shown in FIG. 24).

In this embodiment of this application, the lubricating oil circulation part 1462 and the inner wall of the motor shaft cavity 143 are spaced and disposed in the motor radial direction R. The gap between the lubricating oil circulation part 1462 and the inner wall of the motor shaft cavity 143 in the motor radial direction R is less than the hole diameter of the motor bearing lubricating oil hole 144 and the hole diameter of the rotor diverting hole 145, so that the lubricating oil circulation part 1462 limits the cooling oil flowing to the motor bearing 180, to prevent excessive cooling oil from flowing through the motor bearing lubricating oil hole 144. The length of the lubricating oil circulation part 1462 along the motor axial direction Y is set to be greater than the hole diameter of the motor bearing lubricating oil hole 144. Therefore, before the cooling oil flows to the motor bearing lubricating oil hole 144, the cooling oil first fills the gap between the lubricating oil circulation part 1462 and the inner wall of the motor shaft cavity 143, and then flows into the motor bearing lubricating oil hole 144.

Still with reference to FIG. 23 and FIG. 24, in an embodiment, along the motor axial direction Y, a distance between the rotor diverting hole 145 and the lubricating oil circulation part 1462 is greater than the length of the lubricating oil circulation part 1462 (as shown in FIG. 23 and FIG. 24), and the distance between the rotor diverting hole 145 and the lubricating oil circulation part 1462 is greater than a distance between the lubricating oil circulation part 1462 and the motor bearing 180 (as shown in FIG. 23 and FIG. 24).

In this embodiment of this application, the length of the lubricating oil circulation part 1462 along the motor axial direction Y is set to be relatively small, to avoid a case in which the lubricating oil circulation part 1462 occupies an excessively large dimension in the motor axial direction Y. If the length of the lubricating oil circulation part 1462 is greater than the distance between the rotor diverting hole 145 and the lubricating oil circulation part 1462, it is difficult for the cooling oil to flow into the motor bearing lubricating oil hole 144 in both a high-speed working condition and a low-speed working condition, thereby affecting lubrication of the motor bearing 180. The distance between the lubricating oil circulation part 1462 and the motor bearing 180 along the motor axial direction Y is set to be relatively small, to shorten a transmission path of the cooling oil between the lubricating oil circulation part 1462 and the motor bearing 180 and help reduce a loss of the cooling oil on the transmission path.

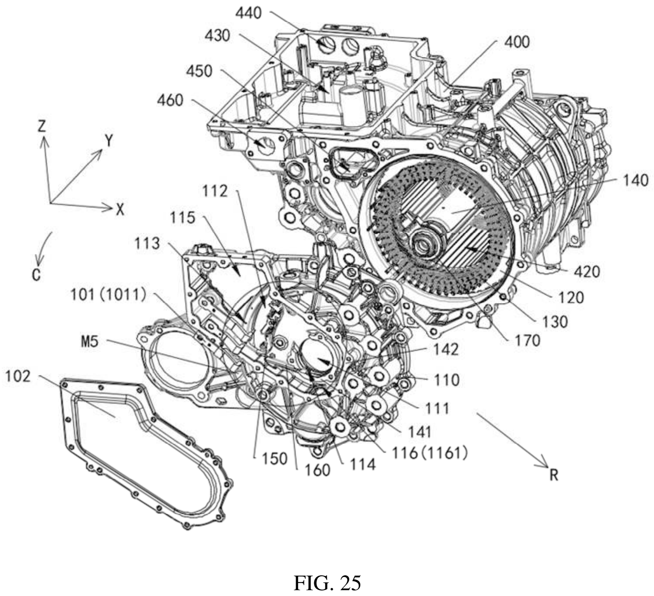

With reference to FIG. 2 and FIG. 25, FIG. 25 is a locally exploded diagram of a powertrain 10 according to an embodiment of this application. In an embodiment, the powertrain 10 further includes three phases of input copper bars 101 (as shown in FIG. 2), the motor end cover 110 further includes a winding wiring hole 112 (as shown in FIG. 25), the winding wiring hole 112 penetrates the motor end cover 110 along the motor axial direction Y (as shown in FIG. 25), and the motor winding 130 is accommodated in the motor accommodating cavity 420 (as shown in FIG. 25). The three phases of input copper bars 101 are electrically connected to the motor winding 130 and the motor controller 200 through the winding wiring hole 112 (as shown in FIG. 2 and FIG. 25). The three phases of input copper bars 101 include three input copper bars 1011 (as shown in FIG. 2 and FIG. 25), and the three input copper bars 1011 are spaced and arranged along the motor circumferential direction C (as shown in FIG. 2 and FIG. 25).

In this embodiment of this application, the motor controller 200 is electrically connected to the motor winding 130 of the motor 100 through the three phases of input copper bars 101, and the three input copper bars 1011 in the three phases of input copper bars 101 transmit the three phases of alternating currents to the motor winding 130. The three input copper bars 1011 are spaced and arranged along the motor circumferential direction C, to help reduce electrical interference among the three input copper bars 1011 and ensure stability of an electrical connection.

Still with reference to FIG. 25, the motor end cover 110 includes an alternating-current output interface communicating hole 115. Along the first direction Y, the direct-current input interface mounting hole 440 and the alternating-current output interface mounting hole 450 separately penetrate the integrated housing 400 and communicate with the controller accommodating cavity 430. The alternating-current output interface communicating hole 115 penetrates the motor end cover 110. A projection of the alternating-current output interface communicating hole 115 covers a projection of the alternating-current output interface mounting hole 450. Projections of the three phases of input copper bars 101 partially overlap the projection of the alternating-current output interface communicating hole 115.

In this embodiment of this application, the alternating-current output interface mounting hole 450 and the alternating-current output interface communicating hole 115 are jointly configured to accommodate the alternating-current output interface 260. In the first direction Y, the alternating-current output interface communicating hole 115 is located on a side that is of the alternating-current output interface mounting hole 450 and that is away from the direct-current input interface mounting hole 440, and the projection of the alternating-current output interface communicating hole 115 covers the projection of the alternating-current output interface mounting hole 450, so that the alternating-current output interface 260 can sequentially penetrate the alternating-current output interface mounting hole 450 and the alternating-current output interface communicating hole 115. In this embodiment of this application, the three phases of input copper bars 101 are separately connected to the alternating-current output interface 260 and the electrical connecting piece 150. In this solution, the projections of the three phases of input copper bars 101 are set to partially overlap a projection of the winding wiring hole 112 and the projection of the alternating-current output interface communicating hole 115, to reduce an energy loss on a transmission path.

It may be understood that, in this embodiment of this application, an extension direction of the alternating-current output interface communicating hole 115 is parallel to a projection direction (that is, the first direction Y), and the projection of the alternating-current output interface communicating hole 115 is a projection of a region enclosed by a hole wall of the alternating-current output interface communicating hole 115. The foregoing explanation is also applicable to a projection of another through hole in this embodiment of this application.

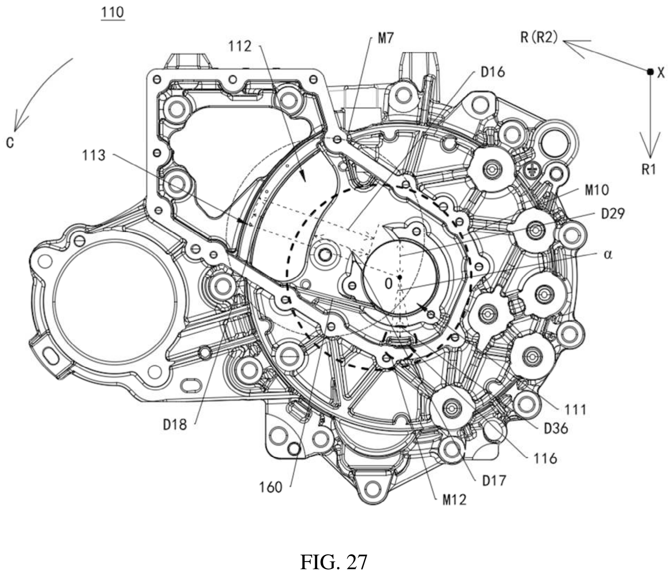

With reference to FIG. 25 to FIG. 27, FIG. 26 is a locally enlarged view of an M5 part of the powertrain 10 shown in FIG. 25, and FIG. 27 is a diagram of a structure of a motor end cover 110 according to an embodiment of this application.

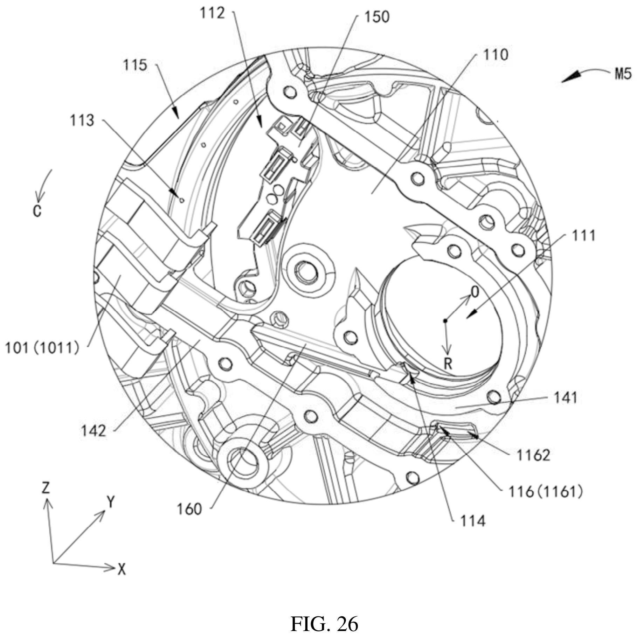

In an embodiment, the motor end cover 110 and the motor stator 120 are adjacently arranged along the motor axial direction Y (as shown in FIG. 25). The motor end cover 110 includes at least one cooling hole 113 (as shown in FIG. 25 and FIG. 26). The winding wiring hole 112 is configured to accommodate the electrical connecting piece 150 between the motor winding 130 and the motor controller 200 (as shown in FIG. 2, FIG. 25, and FIG. 26). The motor shaft hole 111 is configured to accommodate the motor shaft 140 (as shown in FIG. 25). Each cooling hole 113 is configured to communicate with two sides of the motor end cover 110 along the axial direction of the motor shaft 140 (as shown in FIG. 25 and FIG. 26).

The winding wiring hole 112, the motor shaft hole 111, and the at least one cooling hole 113 separately penetrate the motor end cover 110 along the motor axial direction Y (as shown in FIG. 25 and FIG. 26). Along the motor radial direction R, a distance between the at least one cooling hole 113 and the motor shaft hole 111 is greater than a distance between the winding wiring hole 112 and the motor shaft hole 111 (as shown in FIG. 27), and a distance between the winding wiring hole 112 and the at least one cooling hole 113 is less than a distance between the winding wiring hole 112 and the motor shaft hole 111 (as shown in FIG. 25 and FIG. 27). A projection of the at least one cooling hole 113 partially overlaps the projection of the winding wiring hole 112.

In this embodiment of this application, the winding wiring hole 112, the motor shaft hole 111, and the cooling hole 113 are integrated into the motor end cover 110, to reduce a volume of the motor end cover 110, thereby helping implement a miniaturization design and high power density of the motor 100.

One end of the motor shaft 140 is located in the motor shaft hole 111. The electrical connecting piece 150 is located in the winding wiring hole 112 of the motor end cover 110. The motor controller 200 is connected to the motor winding 130 through the electrical connecting piece 150. The electrical connecting piece 150 includes the input copper bar 1011.

The cooling hole 113 penetrates through the motor end cover 110 along the motor axial direction Y, so that the cooling hole 113 communicates with the two sides of the motor end cover 110 along the motor axial direction Y. Therefore, the cooling oil in the motor 100 can flow from the inner side of the motor 100 to the outer side of the motor 100 through the cooling hole 113. The inner side of the motor 100 is a side that is of the motor end cover 110 and that is close to the motor stator 120 along the motor axial direction Y. The outer side of the motor 100 is a side that is of the motor end cover 110 and that is away from the motor stator 120 along the motor axial direction Y. In an embodiment, after the cooling oil flows to the motor rotor 190 from the rotor diverting hole 145 in the motor shaft cavity 143, the cooling oil flows to the outer side of the motor end cover 110 through the cooling hole 113.

Still with reference to FIG. 27, a dimension value of a distance between the cooling hole 113 and the motor shaft hole 111 in the motor radial direction R is denoted as D16, a dimension value of a distance between the winding wiring hole 112 and the motor shaft hole 111 in the motor radial direction R is denoted as D17, and a dimension value of a distance between the winding wiring hole 112 and the cooling hole 113 in the motor radial direction R is denoted as D18. A connecting line of positions selected for measuring D16, D17, and D18 is parallel to the motor radial direction R. For example, the connecting line among the position of the cooling hole 113, the position of the winding wiring hole 112, and the position of the motor shaft hole 111 that are selected during measurement of D2 is a straight line, and an extension direction of the straight line passes through an axis of the motor shaft hole 111.

D16>D17>D18 is set. It indicates that the cooling hole 113 is a hole that is the farthest from a motor axis O along the motor radial direction R in the winding wiring hole 112, the motor shaft hole 111, and the cooling hole 113. The cooling hole 113 and the winding wiring hole 112 are adjacently provided. In this way, the cooling oil can cool the electrical connecting piece 150 in the winding wiring hole 112 through the cooling hole 113, and a cooling path of the cooling oil extends from the inner side of the motor 100 to the outer side of the motor 100, to enlarge a coverage range of the cooling path and help improve utilization of the cooling oil. The cooling hole 113 is closer to the winding wiring hole 112 than the motor shaft hole 111. A path on which the cooling oil flows from the cooling hole 113 to the electrical connecting piece 150 is relatively short. This helps reduce thermal resistance, improve cooling effect for the electrical connecting piece 150, and ensure that the electrical connecting piece 150 can stably transmit the alternating current. The motor axis O is an axis of the motor shaft 140.

In this embodiment of this application, the projection of the cooling hole 113 partially overlaps the projection of the winding wiring hole 112 in the motor radial direction R. Because the cooling hole 113 extends along the motor axial direction Y, and the motor axial direction Y is perpendicular to the motor radial direction R, the projection of the cooling hole 113 along the motor radial direction R is a projection of the hole wall of the cooling hole 113 along the motor radial direction R. In this embodiment of this application, the cooling hole 113 and the winding wiring hole 112 are provided along the motor radial direction R, so that the cooling oil flowing out of the cooling hole is in more contact with the electrical connecting piece 150 of the winding wiring hole 112, thereby improving cooling effect for the electrical connecting piece 150. In this way, the cooling hole 113 and the winding wiring hole 112 are more centrally provided on the motor end cover 110, and are arranged in a compact and orderly manner, to help implement miniaturization of the motor. If the cooling hole 113 and the winding wiring hole 112 are provided along the motor circumferential direction C, a volume occupied by the motor end cover 110 may be increased, and a quantity of the cooling oil flowing out of the cooling hole 113 to be in contact with the electrical connecting piece 150 may be reduced, thereby affecting cooling effect.

In an embodiment, at least one cooling hole 113 of the motor end cover 110 is higher than the motor shaft hole 111 along a gravity direction. It may be understood that the flow of the cooling oil is affected by gravity. In this embodiment of this application, the cooling oil flows from the cooling hole 113 to the electrical connecting piece 150 in the winding wiring hole 112, and the cooling hole 113, the winding wiring hole 112, and the motor shaft hole 111 are sequentially arranged along the motor radial direction R. When the motor 100 is used in a vehicle scenario, the cooling hole 113 needs to be set to be higher than the motor shaft hole 111 along the gravity direction, which is equivalent to a case in which the cooling hole 113 is higher than the winding wiring hole 112 along the gravity direction. Therefore, a flow path of the cooling oil between the cooling hole 113 and the winding wiring hole 112 conforms to the gravity direction, to help reduce flow resistance.

In this embodiment of this application, the cooling oil can flow from the inner side of the motor 100 to the outer side of the motor 100 through the cooling hole 113, so that the cooling oil can cool heat-emitting components on the outer side of the motor end cover 110, to enlarge a coverage range of the cooling path and help improve utilization of the cooling oil. The cooling oil flows from the cooling hole 113 to the winding wiring hole 112, so that cooling and heat dissipation can be implemented for the electrical connecting piece 150 in the winding wiring hole 112. Therefore, the electrical connecting works in an appropriate temperature range, to ensure stability of electrical transmission and improve working effect of the motor 100. In addition, because the cooling hole 113 and the winding wiring hole 112 are adjacently provided, thermal resistance of the cooling oil is reduced, and cooling efficiency is improved. The cooling hole 113, the winding wiring hole 112, and the motor shaft hole 111 are integrated into the motor end cover 110. The cooling hole 113 and the winding wiring hole 112 are provided along the motor radial direction R. This arrangement is compact and orderly. This helps reduce the volume of the motor end cover 110, further optimize a layout of the motor 100, and implement a lightweight design of the motor 100.

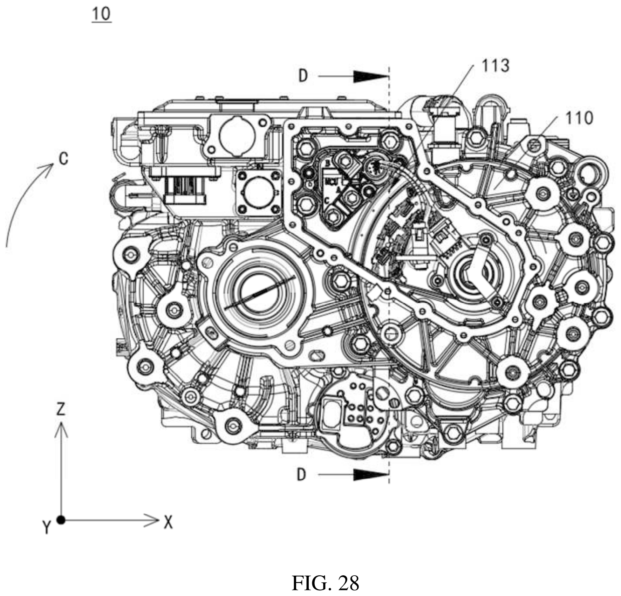

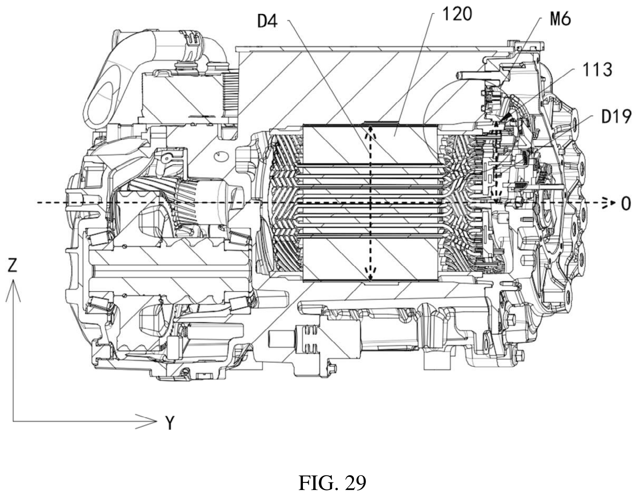

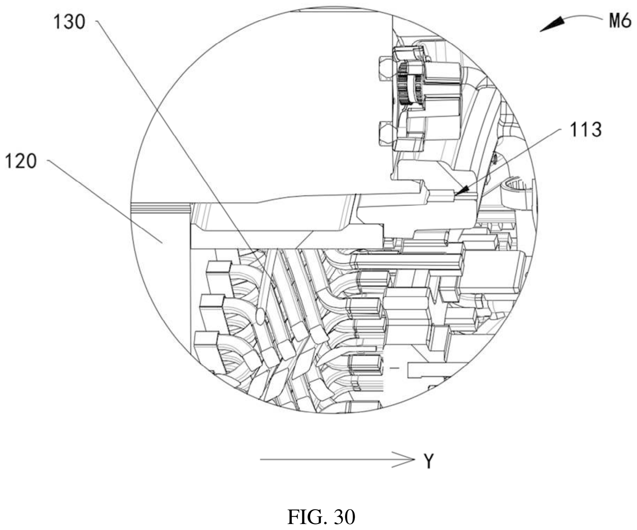

With reference to FIG. 25, and FIG. 28 to FIG. 30, FIG. 28 is a diagram of a structure of a powertrain 10 according to an embodiment of this application, FIG. 29 is a sectional view of the powertrain 10 shown in FIG. 28 along DD, and FIG. 30 is a locally enlarged diagram of an M6 part of the powertrain 10 shown in FIG. 29. In an embodiment, the motor end cover 110 includes a plurality of cooling holes 113 (as shown in FIG. 26 and FIG. 28). The plurality of cooling holes 113 are sequentially spaced and arranged along the motor circumferential direction C (as shown in FIG. 26 and FIG. 28). A hole diameter of each cooling hole 113 is less than a distance between two adjacent cooling holes 113 (as shown in FIG. 26 and FIG. 28). Along the motor axial direction Y, a hole diameter of an opening that is of each cooling hole 113 and that faces the motor stator 120 is greater than a hole diameter of an opening that is of the cooling hole 113 and that is away from the motor stator 120 (as shown in FIG. 29 and FIG. 30).

In this embodiment of this application, the plurality of spaced cooling holes 113 are provided on the motor end cover 110, to increase cooling paths on which the cooling oil flows to the outer side of the motor 100, enlarge a cooling coverage range of the cooling oil, and further improve utilization of the cooling oil. Because the cooling oil needs to cool the electrical connecting piece 150 in the winding wiring hole 112 through the cooling holes 113, the distance between two adjacent cooling holes 113 along the motor circumferential direction C is set to be greater than the hole diameter of each cooling hole 113, to help increase a range covered when the cooling oil is sprayed on the electrical connecting piece 150, enhance cooling effect for the electrical connecting piece 150, and reduce interference between the cooling oil flowing out of different cooling holes 113.

In this embodiment of this application, each cooling hole 113 has two openings along the motor axial direction Y (as shown in FIG. 30). The hole diameter of the opening facing the motor stator 120 is greater than the hole diameter of the opening away from the motor stator 120. The hole diameter of the opening facing the motor stator 120 is set to be relatively large, so that more cooling oil flows from the inner side of the motor 100 to the outer side of the motor 100 through the cooling hole 113. The hole diameter of the opening away from the motor stator 120 is set to be relatively small, to increase a flow rate of the cooling oil flowing out of the opening away from the motor stator 120. In this way, the cooling oil flowing out of the cooling hole 113 is sprayed to the electrical connecting piece 150, to enlarge a spraying range of the cooling oil flowing out of the cooling hole 113 and improve utilization of the cooling oil and cooling effect for the motor 100.

Still with reference to FIG. 29, in an embodiment, a distance between the at least one cooling hole 113 and the motor axis O is greater than half of an outside diameter of the motor stator 120.

In this embodiment of this application, a dimension value of a distance between one of the cooling holes 113 and the motor axis O is denoted as D19, and a dimension value of the outside diameter of the motor stator 120 is D4. Because the cooling hole 113 is provided on the motor end cover 110, D19>0.5D4 is set in this solution. In this way, the motor end cover 110 can fully cover the motor stator 120 along the motor axial direction Y, and the motor stator 120 does not block flowing of the cooling oil to the cooling hole 113.

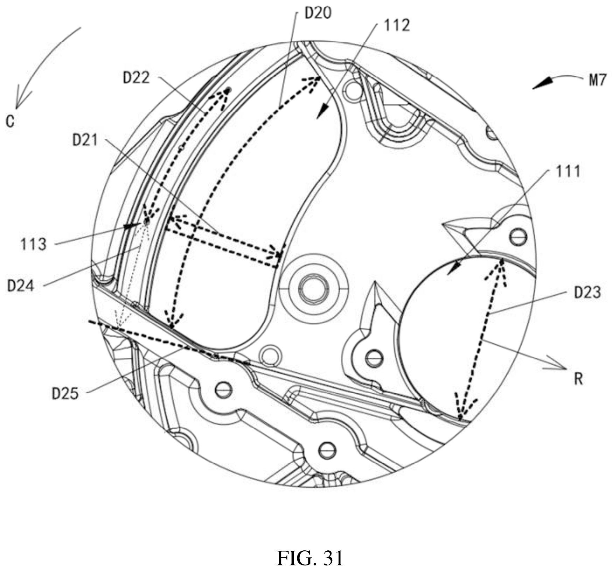

With reference to FIG. 31, FIG. 31 is a locally enlarged diagram of an M7 part of the motor end cover 110 shown in FIG. 27. In an embodiment, a width of the winding wiring hole 112 along the motor circumferential direction C is greater than a width of the winding wiring hole 112 along the motor radial direction R, is greater than a total length of a connecting line of the at least one cooling hole 113 along the motor circumferential direction C, and is greater than a diameter of the motor shaft hole 111.

In this embodiment of this application, a width value of the winding wiring hole 112 along the motor circumferential direction C is denoted as D20, a width value of the winding wiring hole 112 along the motor radial direction R is denoted as D21, a total length value of a connecting line of the cooling hole 113 along the motor circumferential direction C is denoted as D22, and a dimension value of the diameter of the motor shaft hole 111 is denoted as D23. D20>D21 is set in this solution. In this way, the winding wiring hole 112 can adapt to a structure form of the electrical connecting piece 150, and the winding wiring hole 112 can accommodate the electrical connecting piece 150. D20>D22 is set. It can be ensured that a large part of the cooling oil flowing out of the cooling hole 113 cools the electrical connecting piece 150, to improve utilization and cooling efficiency of the cooling oil. Because the cooling hole 113, the winding wiring hole 112, and the motor shaft hole 111 are sequentially arranged along the motor radial direction R, D20>D23 is set in this solution. The winding wiring hole 112 mainly occupies a specific dimension in the motor circumferential direction C instead of the motor radial direction R, to help reduce an overall dimension of the motor end cover 110 in the motor radial direction R. In addition, because a total dimension of the motor end cover 110 in the motor radial direction R is fixed, the winding wiring hole 112 occupies a small dimension in the motor radial direction R. Therefore, a distance between the cooling hole 113 and the winding wiring hole 112 is small, so that the cooling oil flows to the winding wiring hole 112 through the cooling hole 113.

Still with reference to FIG. 25 and FIG. 26, in an embodiment, the motor 100 includes an oil guide rib 160 (as shown in FIG. 25 and FIG. 26). The oil guide rib 160 is configured to transmit the cooling oil to the motor shaft hole 111. Along the motor axial direction Y, the oil guide rib 160 and the motor stator 120 are respectively arranged on two sides of the motor end cover 110 (as shown in FIG. 25). Along the motor circumferential direction C, the oil guide rib 160 is arranged on a same side of centers of the at least one cooling hole 113, the winding wiring hole 112, and the motor shaft hole 111 (as shown in FIG. 25 and FIG. 26). A length direction of the oil guide rib 160 intersects the motor radial direction R. One end of the oil guide rib 160 intersects the motor shaft hole 111 along the length direction of the oil guide rib 160.

In this embodiment of this application, in a rotation process, the motor rotor throws a part of the cooling oil to the outer side of the motor end cover 100 through the cooling hole 113 on the motor end cover 110. If the cooling oil flowing to the outer side of the motor 100 is not appropriately diverted, utilization and cooling effect of the cooling oil are reduced.

In this embodiment of this application, the oil guide rib 160 is located on the outer side of the motor 100, and the oil guide rib 160 is arranged on the same side of the centers of the cooling hole 113, the winding wiring hole 112, and the motor shaft hole 111 along the motor circumferential direction C. In this way, after the cooling oil flows to the electrical connecting piece 150 through the cooling hole 113, the cooling oil can further flow to the oil guide rib 160. One end of the oil guide rib 160 is connected to the motor shaft hole 111 along the length direction of the oil guide rib 160. Therefore, the cooling oil flowing on the oil guide rib 160 can flow back to an edge of the motor shaft hole 111 and enter the inner side of the motor 100, to implement recycling utilization of the cooling oil. The length direction of the oil guide rib 160 intersects the motor radial direction R, which is equivalent to a case in which the center of the motor shaft hole 111 is not on an extension line of the oil guide rib 160. In this way, the oil guide rib 160 can bear the cooling oil falling in a larger area, and more cooling oil can be guided into the motor shaft hole 111.

In this embodiment of this application, the cooling oil can flow from the outer side of the motor 100 to the inner side of the motor 100 through the oil guide rib 160 and the motor shaft hole 111. In this way, the cooling oil is reused, to improve heat dissipation efficiency of the cooling oil and reduce costs. The cooling oil flows to the inner side of the motor 100 through the motor shaft hole 111, so that cooling and heat dissipation can be implemented for components (for example, the motor stator 120) located in the motor 100. Therefore, the motor 100 works in an appropriate temperature range, to improve working effect of the motor 100 and ensure stability of power transmission.

In an embodiment, the oil guide rib 160 and the motor end cover 110 are integrally formed. This solution helps improve structural stability of the oil guide rib 160, so that the cooling oil can flow smoothly on the oil guide rib 160, to improve heat dissipation effect.

In an embodiment, the oil guide rib 160 includes a first end and a second end that are disposed relative to each other along the length direction of the oil guide rib 160. The first end of the oil guide rib 160 is connected to the motor shaft hole 111. A height of the first end of the oil guide rib 160 along the gravity direction is lower than a height of the second end of the oil guide rib 160. It may be understood that the flow of the cooling oil is affected by gravity. In this embodiment of this application, the cooling oil flows from the second end of the oil guide rib 160 to the first end of the oil guide rib 160, and the first end of the oil guide rib 160 is connected to the motor shaft hole 111. When the motor 100 is used in a vehicle scenario, the height of the second end of the oil guide rib 160 along the gravity direction needs to be set to be higher than the height of the first end of the oil guide rib 160. This is equivalent to a case in which the second end of the oil guide rib 160 along the gravity direction is higher than the first end of the oil guide rib 160. In this way, a path on which the cooling oil flows between the oil guide rib 160 and the motor shaft hole 111 complies with the gravity direction, to help reduce flow resistance.

Still with reference to FIG. 31, in an embodiment, a distance between the oil guide rib 160 and the cooling hole 113 is greater than a distance between the oil guide rib 160 and the winding wiring hole 112, and the distance between the oil guide rib 160 and the winding wiring hole 112 is greater than a distance between the oil guide rib 160 and the motor shaft hole 111.

In this embodiment of this application, because the oil guide rib 160 is approximately a cuboid, the distance between the cooling hole 113 and the oil guide rib 160 is a vertical distance from the cooling hole 113 to the oil guide rib 160, and the distance between the oil guide rib 160 and each of the winding wiring hole 112 and the motor shaft hole 111 is similar. The motor end cover 110 includes three cooling holes 113. The distance between the cooling hole 113 and the oil guide rib 160 is a minimum vertical distance from the cooling hole 113 to the oil guide rib 160. In this embodiment of this application, the distance between the oil guide rib 160 and the cooling hole 113 is denoted as D24, the distance between the oil guide rib 160 and the winding wiring hole 112 is denoted as D25, and the distance between the oil guide rib 160 and the motor shaft hole 111 is denoted as D26. In this embodiment of this application, the second end of the oil guide rib 160 intersects the motor shaft hole 111. Therefore, D26 is 0. D24>D25 is set in this solution. In this way, the cooling oil flowing out of the cooling hole 113 first flows through the electrical connecting piece 150, and then flows through the oil guide rib 160, to increase a coverage range of the cooling path and improve utilization of the cooling oil. Because the oil guide rib 160 mainly guides the cooling oil, the cooling oil is finally recycled to cool components in the motor 100. D25>D26 is set in this solution. Therefore, the motor shaft hole 111 is closer to the oil guide rib 160 than the winding wiring hole 112, to help reduce a loss of the cooling oil on a transmission path.

Still with reference to FIG. 25 and FIG. 26, in an embodiment, the motor 100 includes an arc-shaped protrusion structure 141 (as shown in FIG. 25 and FIG. 26). The arc-shaped protrusion structure 141 is configured to fasten the rotary sensor stator 170 (as shown in FIG. 25). The oil guide rib 160 and the arc-shaped protrusion structure 141 are fastened to one side of the motor end cover 110 (as shown in FIG. 25). One side of the motor end cover 110 is away from the motor stator 120 along the motor shaft 140 (as shown in FIG. 25). The arc-shaped protrusion structure 141 and the motor shaft hole 111 are coaxially arranged (as shown in FIG. 25). An inside diameter of the arc-shaped protrusion structure 141 is less than an inside diameter of the motor shaft hole 111. One end of the oil guide rib 160 is fixedly connected to one end of the arc-shaped protrusion structure 141 along the motor circumferential direction C (as shown in FIG. 25 and FIG. 26).

In this embodiment of this application, both the arc-shaped protrusion structure 141 and the oil guide rib 160 are located on the outer side of the motor 100. The arc-shaped protrusion structure 141 is configured to fasten the rotary sensor stator 170. The rotary sensor stator 170 is configured to detect a rotational speed of the motor 100. The arc-shaped protrusion structure 141 and the motor shaft hole 111 are coaxially provided. The motor shaft hole 111 is configured to accommodate the motor shaft 140. In this way, the rotary sensor stator 170 fastened to the arc-shaped protrusion structure 141 and the motor shaft 140 are coaxially disposed, to help the rotary sensor stator 170 detect the rotational speed. The end that is of the oil guide rib 160 and that intersects the motor shaft hole 111 is fixedly connected to an end of the arc-shaped protrusion structure 141 along the motor circumferential direction C. The inside diameter of the arc-shaped protrusion structure 141 is less than the inside diameter of the motor shaft hole 111. The cooling oil needs to flow to the motor shaft hole 111 through the oil guide rib 160. Therefore, when the cooling oil flows to a connection part between the oil guide rib 160 and the motor shaft hole 111, even if a small part of the cooling oil does not enter the motor shaft hole 111, the arc-shaped protrusion structure 141 can also guide this part of the cooling oil to the motor shaft hole 111.

In an embodiment, the inside diameter of the arc-shaped protrusion structure 141 is equal to the inside diameter of the motor shaft hole 111. The motor shaft hole 111 is configured to accommodate the motor bearing. The motor shaft 140 is rotationally connected to an inner wall of the motor shaft hole 111 through the motor bearing. In this solution, it is difficult for the motor bearing in the motor shaft hole 111 to be detached from the motor end cover 110.

Still with reference to FIG. 25 and FIG. 26, in an embodiment, one side of the motor end cover 110 includes an oil guide groove 114 (as shown in FIG. 25 and FIG. 26), and the oil guide groove 114 communicates with the motor shaft hole 111 (as shown in FIG. 25 and FIG. 26). Along the motor axial direction Y, a concave direction of the oil guide groove 114 is opposite to a protrusion direction of the arc-shaped protrusion structure 141 (as shown in FIG. 26). The concave direction of the oil guide groove 114 is away from the motor shaft 140 along the motor radial direction R (as shown in FIG. 26). The oil guide groove 114 is arranged between the motor shaft hole 111 and one end of the oil guide rib 160 along the motor axial direction Y (as shown in FIG. 26).

In this embodiment of this application, the oil guide groove 114, the oil guide rib 160, and the arc-shaped protrusion structure 141 are all located on a same side of the motor end cover 110.

Because a distance between the inner wall of the motor shaft hole 111 and the motor shaft 140 is usually small, it is very difficult to transmit the cooling oil located on the outer side of the motor 100 to the inner side of the motor 100. In this solution, the oil guide groove 114 is provided. The oil guide rib 160, the oil guide groove 114, and the motor shaft hole 111 are sequentially arranged in the motor axial direction Y. The concave direction of the oil guide groove 114 is opposite to the protrusion direction of the arc-shaped protrusion structure 141. Therefore, the oil guide groove 114 has an opening along the motor axial direction Y. The cooling oil on the oil guide rib 160 can flow into the oil guide groove 114 along the motor axial direction Y through the opening. In the motor radial direction R, the oil guide groove 114 is concave in a direction away from the motor shaft 140, so that the oil guide groove 114 further has another opening along the motor radial direction R. The cooling oil flowing into the oil guide groove 114 can flow into the motor shaft hole 111 along the motor radial direction R through the another opening, to cool the inner side of the motor 100. The oil guide groove 114 itself can further store oil. The oil guide groove 114 in this solution helps recycling utilization of the cooling oil, and transmits the recycled cooling oil to the inner side of the motor 100, to increase a liquid intake quantity of the cooling oil.

In an embodiment, along the motor axial direction Y, the oil guide groove 114 is arranged between the motor shaft hole 111 and one end of the arc-shaped protrusion structure 141. In this embodiment of this application, the arc-shaped protrusion structure 141, the oil guide groove 114, and the motor shaft hole 111 are sequentially arranged in the motor axial direction Y. The cooling oil flows to the oil guide groove 114 and the motor shaft hole 111 through the oil guide rib 160. The arc-shaped protrusion structure 141 can guide the cooling oil.

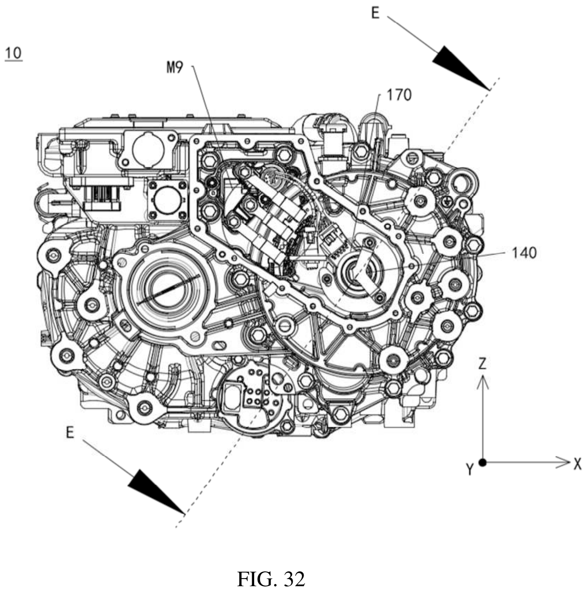

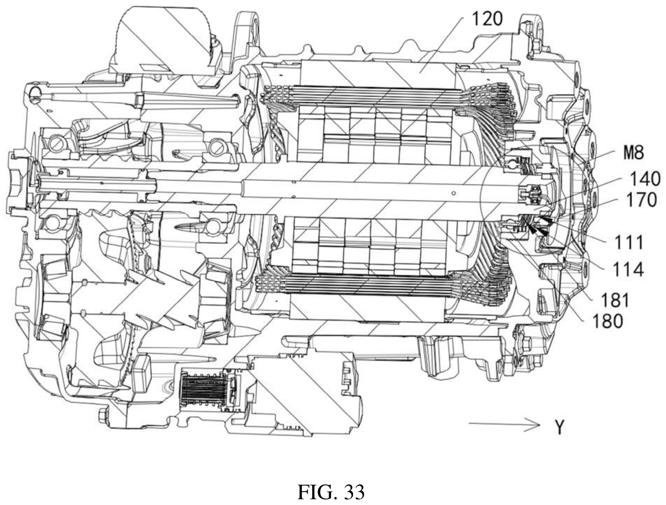

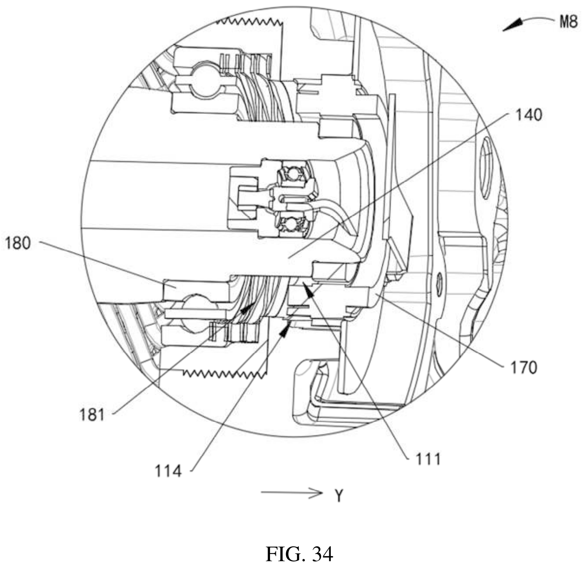

With reference to FIG. 32 to FIG. 34, FIG. 32 is a diagram of a structure of a powertrain 10 according to an embodiment of this application, FIG. 33 is a sectional view of the powertrain 10 shown in FIG. 32 along EE, and FIG. 34 is a locally enlarged diagram of an M8 part of the powertrain 10 shown in FIG. 33. In an embodiment, projections of the oil guide groove 114 and the rotary sensor stator 170 along the radial direction of the motor shaft 140 at least partially overlap. The oil guide groove 114 communicates with the motor bearing chamber 181.

In this embodiment of this application, the motor bearing 180 is located in the motor bearing chamber 181. The oil guide groove 114 communicates with the motor bearing chamber 181. The cooling oil can enter the motor bearing chamber 181 through the oil guide groove 114 to be in contact with the motor bearing 180, to lubricate the motor bearing 180 and avoid damage to the motor bearing 180, thereby prolonging a service life and ensuring long-term stable running of the motor 100. In addition, the motor bearing chamber 181 can be further configured to temporarily store a liquid, to better lubricate the motor bearing 180. In this embodiment of this application, the projections of the oil guide groove 114 and the rotary sensor stator 170 in the motor radial direction at least partially overlap, so that the cooling oil entering the oil guide groove 114 can further cool the rotary sensor stator 170, to enlarge a coverage range of the cooling oil and improve heat dissipation effect.

Still with reference to FIG. 25, in an embodiment, along the axial direction of the motor shaft 140, the motor 100 includes a wiring cover fastening structure 142. The wiring cover fastening structure 142 is configured to fasten the wiring cover 102 of the motor 100. Along the motor axial direction Y, the wiring cover fastening structure 142 is fastened on one side of the motor end cover 110. The wiring cover fastening structure 142 and the motor stator 120 are arranged on two sides of the motor end cover 110. A region enclosed by a projection of the wiring cover fastening structure 142 covers the motor shaft hole 111, the arc-shaped protrusion structure 141, the winding wiring hole 112, and the cooling hole 113. Along the motor radial direction, the projection of the wiring cover fastening structure 142 covers a projection of the arc-shaped protrusion structure 141.

In this embodiment of this application, the wiring cover 102, the cooling hole 113, the winding wiring hole 112, the motor shaft hole 111, and the arc-shaped protrusion structure 141 are all located on the outer side of the motor 100, and the region enclosed by the projection of the wiring cover fastening structure 142 covers the cooling hole 113, the winding wiring hole 112, the motor shaft hole 111, and the arc-shaped protrusion structure 141 along the motor axial direction Y. The wiring cover fastening structure 142 is configured to fasten the wiring cover 102. It is set in this solution that the wiring cover fastening structure 142 and the wiring cover 102 can prevent a foreign matter from being mixed with the cooling oil flowing out of the cooling hole 113, avoid external environment impact on an electrical connection relationship between the electrical connecting piece 150 and the motor controller 200, prevent a foreign matter from entering the motor shaft hole 111, and ensure a fixed connection between the arc-shaped protrusion structure 141 and the rotary sensor stator 170, to ensure normal working of the motor 100 in a plurality of aspects.

In this embodiment of this application, the projection of the wiring cover fastening structure 142 along the motor radial direction covers the projection of the arc-shaped protrusion structure 141 along the motor radial direction. This indicates that a dimension value of the wiring cover fastening structure 142 is greater than a dimension value of the arc-shaped protrusion structure 141 in the motor axial direction Y. In other words, a protruding height of the wiring cover 102 along the motor axial direction Y is greater than a protruding height of the arc-shaped protrusion structure 141 along the motor axial direction Y.

In this embodiment of this application, an arrangement direction of the alternating-current output interface communicating hole 115, the cooling hole 113, the winding wiring hole 112, and the motor shaft hole 111 is approximately parallel to the motor radial direction R, so that an electrical interface layout of the motor is more compact, to help reduce a volume of the wiring cover 102 and reduce costs.

In an embodiment, one end that is of the oil guide rib 160 and that is away from the motor shaft hole 111 intersects the wiring cover fastening structure 142. In this embodiment of this application, when the cooling oil flows from the cooling hole 113 and the electrical connecting piece 150 to the oil guide rib 160, even if a part of the cooling oil falls on a connection part between the wiring cover fastening structure 142 and the oil guide rib 160, the wiring cover fastening structure 142 can guide the cooling oil to the oil guide rib 160, to improve utilization of the cooling oil.

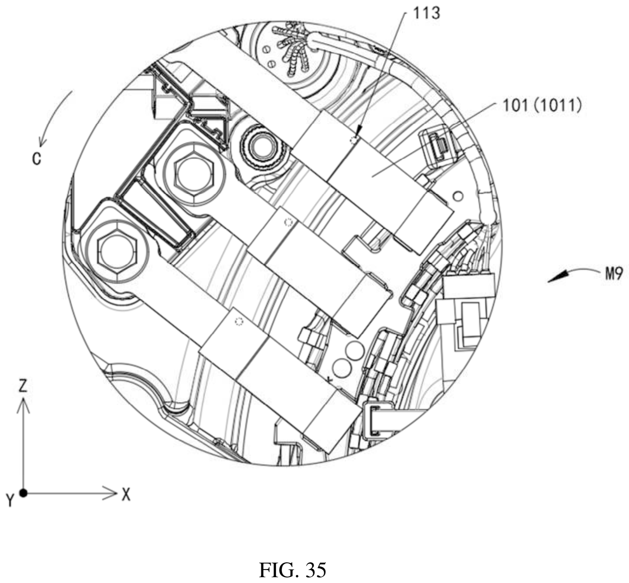

With reference to FIG. 35, FIG. 35 is a locally enlarged diagram of an M9 part of the powertrain 10 shown in FIG. 32. In an embodiment, the motor end cover 110 includes three cooling holes 113. A distance between two adjacent input copper bars 1011 is greater than a hole diameter of each cooling hole 113. A hole diameter of each cooling hole 113 along the circumferential direction of the motor shaft 140 is less than a width of each input copper bar 1011. Along a clockwise direction, three oil spraying holes are respectively arranged on sides of midpoints of the three input copper bars 1011. Distances between a midpoint of the input copper bar 1011 and two sides of the input copper bar 1011 along the motor circumferential direction C are equal.

In this embodiment of this application, along the motor axial direction Y, projections of the three cooling holes 113 do not overlap projections of the midpoints of the three input copper bars 1011. In other words, the three cooling holes 113 correspond to the three input copper bars 1011 and are disposed in a staggered manner. When the input copper bar 1011 transmits electric energy, a part of the electric power is converted into heat, which causes the input copper bar 1011 to emit heat. Therefore, cooling and heat dissipation need to be implemented for the input copper bar 1011. It may be understood that the motor 100 rotates at a high speed during working. The cooling oil flowing out of the cooling hole 113 is affected by centrifugal force. As a result, a movement path of the cooling oil on the outer side of the motor 100 is not parallel to the motor axial direction Y. To ensure that the cooling oil can be sprayed to the three phases of input copper bars 101 under the centrifugal force, in this solution, each cooling hole 113 is set to correspond to one input copper bar 1011, and each cooling hole 113 is set to be staggered with the corresponding input copper bar 1011, so that the cooling oil can effectively cool the three phases of input copper bars 101.

In this embodiment of this application, the distance between two adjacent input copper bars 1011 is set to be greater than a hole diameter of the cooling hole 113, to avoid electrical interference caused by an excessively small distance between input copper bars 1011. A width of each input copper bar 1011 in the motor circumferential direction C is set to be greater than the hole diameter of the cooling hole 113, to ensure that most cooling oil flows to the input copper bar 1011, thereby improving utilization of the cooling oil.

It should be noted that clockwise in this implementation is merely a relative concept. In this embodiment of this application, in a figure viewed from the outer side of the motor end cover, the three oil spraying holes are respectively arranged on the sides of the midpoints of the three input copper bars 1011 along the clockwise direction. In a figure viewed from the inner side of the motor end cover, the three oil spraying holes are respectively arranged on sides of the midpoints of the three input copper bars 1011 along an anticlockwise direction. At different observation angles or in different installation manners, the three cooling holes 113 and the three input copper bars 1011 may be in different position relationships, provided that it is ensured that the cooling oil can be sprayed to the input copper bars 1011 through the cooling holes 113 to cool the input copper bars 1011.

Still with reference to FIG. 25, in an embodiment, along the motor radial direction R, a distance between the alternating-current output interface communicating hole 115 and the motor shaft hole 111 is greater than a distance between the cooling hole 113 and the motor shaft hole 111. In this embodiment of this application, in the motor radial direction R, the alternating-current output interface communicating hole 115 is located on a side that is of the cooling hole 113 and that is away from the motor shaft hole 111. In other words, the alternating-current output interface communicating hole 115, the cooling hole 113, the winding wiring hole 112, and the motor shaft hole 111 are sequentially arranged along the motor radial direction R. A position relationship of the through holes reflects a layout feature of the alternating-current output interface 260, the input copper bar 1011, the electrical connecting piece 150, and the motor shaft 140, that is, complies with a flow direction of energy, to shorten a transmission path of energy in the powertrain 10. In addition, the alternating-current output interface communicating hole 115, the cooling hole 113, the winding wiring hole 112, and the motor shaft hole 111 are integrated into the motor end cover 110, to reduce the volume of the motor end cover 110 and help implement a miniaturization design and high power density of the motor 100.

Still with reference to FIG. 7 and FIG. 25, in an embodiment, the cooling hole 113 and the winding wiring hole 112 separately partially overlap the controller accommodating cavity 430 in the second direction Z (as shown in FIG. 25). In this embodiment of this application, the controller accommodating cavity 430 and the motor accommodating cavity 420 partially overlap in the second direction Z, to reduce a total dimension value of the motor controller 200 and the motor 100 in the second direction Z. This helps reduce the volume of the powertrain 10 and improve power density. Between the motor controller 200 and the motor 100, the alternating current sequentially passes through the power module 230, the copper bar assembly 240, the input copper bar 1011, and the electrical connecting piece 150 to be transmitted to the motor winding 130. The power module 230 and the copper bar assembly 240 are located in the controller accommodating cavity 430. The input copper bar 1011 and the cooling hole 113 are correspondingly disposed. The electrical connecting piece 150 is located in the winding wiring hole 112. Therefore, it is set in this solution that the cooling hole 113 and the winding wiring hole 112 at least separately partially overlap the controller accommodating cavity 430 in the second direction Z, so that a layout manner complies with the flow direction of the power flow, to shorten an energy transmission path and help reduce an energy loss between the motor controller 200 and the motor 100. Performance of the powertrain 10 is improved.

Still with reference to FIG. 25, in an embodiment, a length of the input copper bar 1011 is greater than a distance between the alternating-current output interface mounting hole 450 and the winding wiring hole 112. In this embodiment of this application, the alternating-current output interface mounting hole 450 is configured to fasten the alternating-current output interface 260, the winding wiring hole 112 is configured to accommodate the electrical connecting piece 150, and the alternating-current output interface 260 transmits the alternating current to the electrical connecting piece 150 through the input copper bar 1011. In other words, two ends of the input copper bar 1011 are respectively configured to electrically connect to the alternating-current output interface 260 and the electrical connecting piece 150. In this solution, the length of the input copper bar 1011 is set to be greater than the distance between the alternating-current output interface mounting hole 450 and the winding wiring hole 112, to reduce installation difficulty of the input copper bar 1011 to facilitate the electrical connection between the input copper bar 1011 and each of the alternating-current output interface 260 and the electrical connecting piece 150.

Still with reference to FIG. 25, in an embodiment, along the first direction Y, projections of the cooling hole 113 and the power interface mounting holes 460 do not overlap. In this embodiment of this application, if projections of the cooling hole 113 and the power interface mounting hole 460 along the first direction Y at least partially overlap, the cooling hole 113 occupies an adjacent region of the power interface mounting hole 460 along the first direction Y, thereby causing interference to a charging process. In this solution, positions of the cooling hole 113 and the power interface mounting hole 460 are appropriately arranged, to ensure normal working of both the reducer 300 and the motor controller 200 without mutual impact.

Still with reference to FIG. 25, along the second direction Z and the third direction X, the cooling hole 113 and the power interface mounting holes 460 are spaced and arranged. The second direction Z is perpendicular to the first direction Y and the third direction X, and the third direction X is perpendicular to the first direction Y. In this embodiment of this application, no energy is transmitted between the cooling hole 113 and the power interface mounting hole 460, and the cooling hole 113 and the power interface mounting hole 460 are spaced and provided in the second direction Z and the third direction X. In this case, no energy loss is caused. In addition, because there is the cooling oil flowing in the cooling hole 113, this solution further helps prevent the cooling oil from causing adverse impact on the power interface mounting hole 460.

Still with reference to FIG. 25 and FIG. 26, in an embodiment, the motor end cover 110 further includes an oil return hole 116 (as shown in FIG. 25 and FIG. 26). The oil return hole 116 is configured to communicate with two sides of the motor end cover 110 along the axial direction of the motor shaft 140. One end of the oil guide rib 160 is located between the oil return hole 116 and the axis O of the motor shaft hole 111 along the motor radial direction R (as shown in FIG. 26). One end of the oil guide rib 160 and the oil return hole 116 are spaced and arranged along the motor circumferential direction C (as shown in FIG. 26). An arrangement direction of the oil return hole 116 and the axis O of the motor shaft hole 111 intersects the length direction of the oil guide rib 160.

In this embodiment of this application, both the motor shaft hole 111 and the oil return hole 116 can communicate with the inner side of the motor 100 and the outer side of the motor 100. A part of the cooling oil flowing to the outer side of the motor 100 flows into the motor shaft hole 111 through the oil guide rib 160, and the remaining cooling oil may flow into the oil return hole 116. In this solution, the oil return hole 116 is provided on the motor end cover 110. The cooling oil located on the outer side of the motor 100 is fully used by using the oil return hole 116, to further improve utilization of the cooling oil and avoid silting of the cooling oil in a cavity between the motor end cover 110 and the wiring cover 102. The motor shaft hole 111 and the oil return hole 116 are integrated in the motor end cover 110, to save a material of the motor end cover 110 and implement a more lightweight design, thereby optimizing a motor layout and helping implement a miniaturization design of the motor.

In this embodiment of this application, one end of the oil guide rib 160 is located between axes of the oil return hole 116 and the motor shaft hole 111 in the motor radial direction R. The arrangement direction of the axes of the oil return hole 116 and the motor shaft hole 111 intersects the length direction of the oil guide rib 160. If the arrangement direction of the axes of the oil return hole 116 and the motor shaft hole 111 is set to be parallel to the length direction of the oil guide rib 160, it becomes uneasy for the cooling oil to flow to the oil return hole 116. In this embodiment of this application, the oil return hole 116 is located on one side of the length direction of the oil guide rib 160. When the second end of the oil guide rib 160 is higher than the first end, a height of the oil return hole 116 is lower than that of the motor shaft hole 111, to help recycle the cooling oil at a lower position, thereby improving recycling utilization of the cooling oil.

One end of the oil guide rib 160 and the oil return hole 116 are spaced and arranged in the motor circumferential direction C. In this way, the cooling oil flowing to the motor shaft hole 111 and the oil return hole 116 can separately cool different components in the motor 100. This helps enlarge the coverage range of the cooling oil and improve cooling effect.

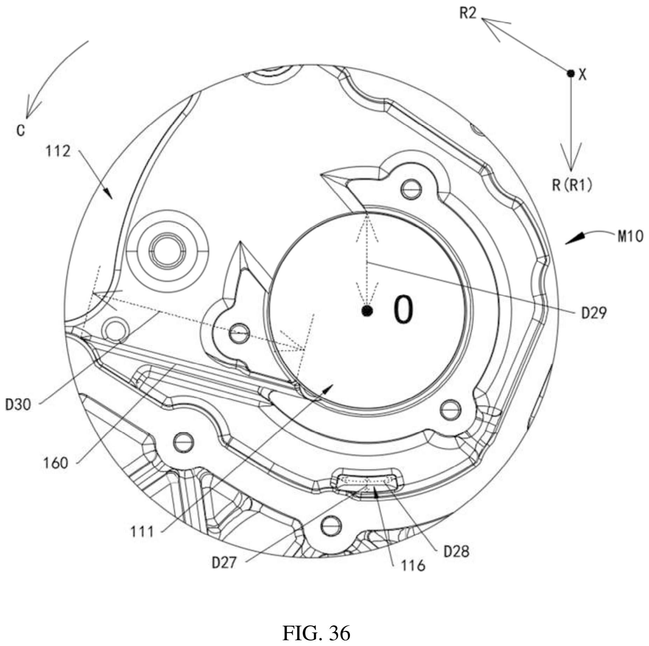

With reference to FIG. 27 and FIG. 36, FIG. 36 is a locally enlarged diagram of an M10 part of the motor end cover 110 shown in FIG. 27. In an embodiment, a width of the oil return hole 116 along the motor radial direction R is less than a radius of the motor shaft hole 111 (as shown in FIG. 36). The width of the oil return hole 116 along the motor circumferential direction C is less than the radius of the motor shaft hole 111 (as shown in FIG. 36). The width of the oil return hole 116 along the motor circumferential direction C is greater than the width of the oil return hole 116 along the motor radial direction R (as shown in FIG. 36). The width of the oil return hole 116 along the motor circumferential direction C is less than a length of the oil guide rib 160 (as shown in FIG. 36).

In this embodiment of this application, the width of the oil return hole 116 along the motor radial direction R is denoted as D27 (as shown in FIG. 36), and the width of the oil return hole 116 along the motor circumferential direction C is denoted as D28. Because the oil return hole 116 has a specific depth along the motor axial direction, in this embodiment of this application, the width of the oil return hole 116 along the motor radial direction R is an average width of the oil return hole 116 along the motor radial direction R, and the width of the oil return hole 116 along the motor circumferential direction C is an average width of the oil return hole 116 along the motor circumferential direction C. The radius of the motor shaft hole 111 is denoted as D29, and the length of the oil guide rib 160 is denoted as D30. In this solution, the oil return hole 116 is compared with the motor shaft hole 111 and the oil guide rib 160 in dimensions, that is, D27<D29, D28<D29, and D28<D30. The widths of the oil return hole 116 in the motor radial direction R and in the motor circumferential direction C to a relatively small range, to avoid providing an excessively large oil return hole 116 on the motor end cover 110. This helps enhance structural strength of the motor end cover 110. In addition, a relatively small oil return hole 116 can be used to prevent a foreign matter from falling into the inner side of the motor 100 through the oil return hole 116, to reduce external impact on the motor 100.

In this embodiment of this application, the radius of the motor shaft hole 111 and the length of the oil guide rib 160 are set to a relatively large range, to ensure that the motor shaft hole 111 and the oil guide rib 160 effectively implement their respective functions. Specifically, if the radius of the motor shaft hole 111 is set to be less than the width of the oil return hole 116 along the motor radial direction R or the width of the oil return hole 116 along the motor circumferential direction C, the motor shaft hole 111 cannot be used to accommodate the motor shaft 140. In addition, it is difficult for the cooling oil on the oil guide rib 160 to flow into the inner side of the motor 100 through the motor shaft hole 111, to reduce utilization of the cooling oil. If the width of the oil guide rib 160 along the motor circumferential direction C is set to be less than the width of the oil return hole 116 along the motor circumferential direction C, an excessively small quantity of the cooling oil is collected by the oil guide rib 160. It is difficult to effectively use the cooling oil. In this embodiment of this application, D28>D27 is set, to reduce a dimension value of the motor end cover 110 in the motor radial direction R and provide space for providing the motor shaft hole 111 and another structure in the motor radial direction R.

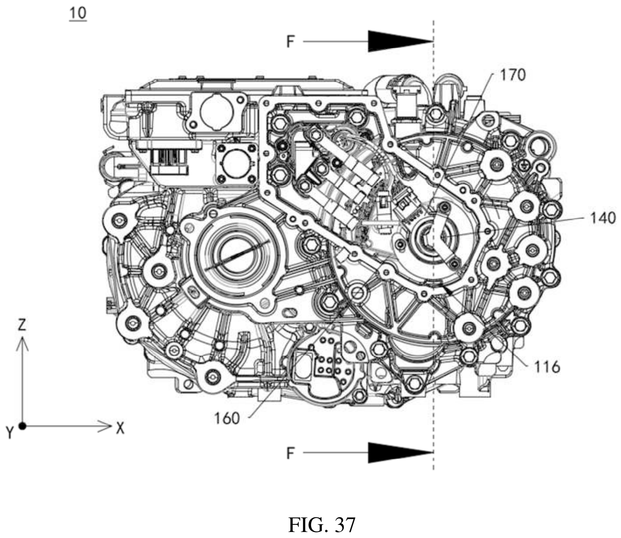

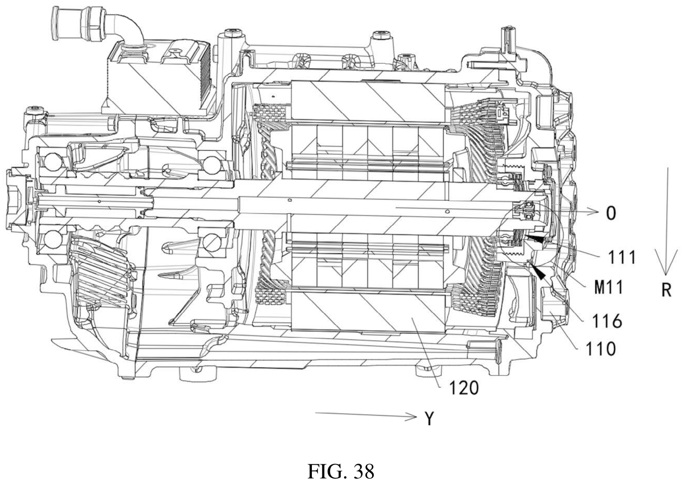

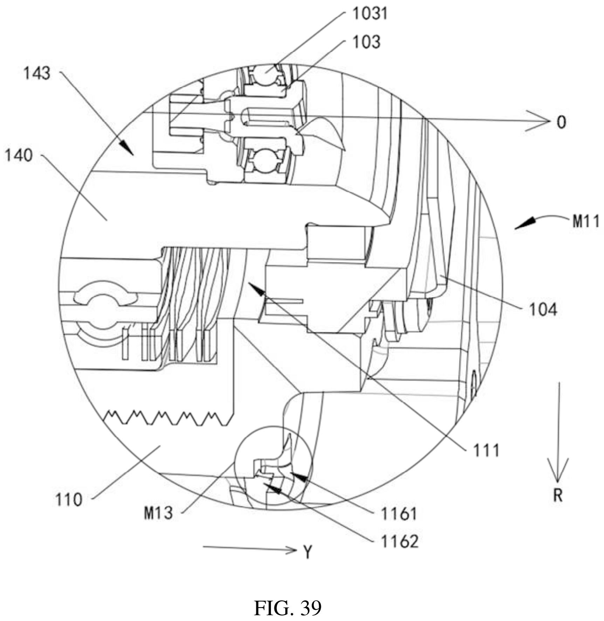

With reference to FIG. 37 to FIG. 39, FIG. 37 is a diagram of a structure of a powertrain 10 according to an embodiment of this application, FIG. 38 is a sectional view of the powertrain 10 shown in FIG. 37 along FF, and FIG. 39 is a locally enlarged diagram of an M11 part of the powertrain 10 shown in FIG. 38. In this embodiment of this application, a projection of the oil return hole 116 does not overlap a projection of the motor stator 120 in the motor axial direction Y.

In an embodiment, the oil return hole 116 includes a first opening 1161 and a second opening 1162 (as shown in FIG. 37 to FIG. 39). The first opening 1161 communicates with the second opening 1162 (as shown in FIG. 39). Along the motor axial direction Y, the first opening 1161 and the second opening 1162 are arranged at two opposite surfaces of the motor end cover 110 (as shown in FIG. 39). The first opening 1161 is located at a surface that is of the motor end cover 110 and that is away from the motor stator 120. The first opening 1161 and the oil guide rib 160 are arranged at the same surface of the motor end cover 110 (as shown in FIG. 37). The second opening 1162 is located on a surface that is of the motor end cover 110 and that faces the motor stator 120. The first opening 1161, the second opening 1162, and the motor stator 120 are spaced and arranged.

In this embodiment of this application, an orientation of the first opening 1161 intersects an orientation of the second opening 1162 (as shown in FIG. 39), and the orientation of the first opening 1161 is parallel to the motor axial direction Y (as shown in FIG. 39).

In this embodiment of this application, the first opening 1161 and the second opening 1162 communicate with each other and are arranged along the motor axial direction Y, and the second opening 1162 is located between the motor stator 120 and the first opening 1161 in the motor axial direction Y, so that the cooling oil entering the oil return hole 116 sequentially flows through the first opening 1161 and the second opening 1162. The first opening 1161 and the oil guide rib 160 are located at a same surface of the motor end cover 110, so that a part of the cooling oil that does not flow through the oil guide rib 160 enters the first opening 1161, to improve recycling utilization of the cooling oil. The orientation of the first opening 1161 is parallel to the motor axial direction Y, and the orientation of the first opening 1161 is not parallel to the orientation of the second opening 1162, to change flow directions of the cooling oil at the first opening 1161 and the second opening 1162, so that the cooling oil is collected after the cooling oil enters the inner side of the motor 100 through the oil return hole 116.

Still with reference to FIG. 39, in an embodiment, the orientation of the first opening 1161 intersects the orientation of the second opening 1162, and the orientation of the first opening 1161 is parallel to the motor axial direction Y. A projection of the first opening 1161 along the motor radial direction R does not overlap a projection of the second opening 1162 along the motor radial direction R. A projection of the first opening 1161 along the motor axial direction Y at most partially overlaps a projection of the second opening 1162 along the motor axial direction Y. An area of the first opening 1161 is greater than an area of the second opening 1162. Along the motor radial direction R, a distance between the first opening 1161 and the motor axis is less than a distance between the second opening 1162 and the motor axis.

In this embodiment of this application, the orientation of the first opening 1161 is parallel to the motor axial direction Y, so that the cooling oil can enter the oil return hole 116 along the motor axial direction Y. In this way, a circulation path of the cooling oil is smoother and shorter. The orientation of the first opening 1161 is not parallel to the orientation of the second opening 1162. For example, as shown in FIG. 37, the second opening 1162 faces a lower left side, so that the cooling oil can better fall into the inner side of the motor. In this embodiment of this application, the orientation of the first opening 1161 is parallel to the motor axial direction Y, and the orientation of the first opening 1161 is not parallel to the orientation of the second opening 1162, to change the flow directions of the cooling oil at the first opening 1161 and the second opening 1162, so that the cooling oil is collected after the cooling oil enters the inner side of the motor 100 through the oil return hole 116.

In this embodiment of this application, the projections of the first opening 1161 and the second opening 1162 in the motor radial direction R do not overlap. This helps guide the cooling oil to the inner side of the motor 100, and shorten the flow path of the cooling oil between the first opening 1161 and the second opening 1162. The projection of the first opening 1161 along the motor axial direction Y at most partially overlaps the projection of the second opening 1162 in the motor axial direction Y, to help change a flow direction of the cooling oil from the first opening 1161 to the second opening 1162 and accelerate the flow of the cooling oil. In this solution, an overlapping relationship between the projections of the first opening 1161 and the second opening 1162 along the motor radial direction R and the motor axial direction Y is set, to prevent the cooling oil from silting near the oil return hole 116, so that the cooling oil can quickly enter the inner side of the motor 100 through the oil return hole 116.

In this embodiment of this application, a projection surface of the projection of the first opening 1161 along the motor axial direction Y is the same as a projection surface of the projection of the second opening 1162 along the motor axial direction Y. The projection of the first opening 1161 along the motor axial direction Y is a projection of a region enclosed by an opening wall of the first opening 1161 along the motor axial direction Y. The projection of the second opening 1162 along the motor axial direction Y is a projection of a region enclosed by an opening wall of the second opening 1162 along the motor axial direction Y.

In this embodiment of this application, along the motor axial direction Y, the first opening 1161 is closer to the outer side of the motor 100 than the second opening 1162. Therefore, a foreign matter may enter the oil return hole 116 through the first opening 1161. In this solution, the area of the second opening 1162 is set to be less than the area of the first opening 1161, so that a foreign matter falling into the first opening 1161 cannot enter the inner side of the motor 100 through the second opening 1162. This helps prevent a foreign matter with a large volume from entering the motor 100 and reduce interference and damage caused by a foreign matter to the motor 100. The area of the first opening 1161 is set to large, to help the cooling oil enter the oil return hole 116, thereby increasing a flow quantity of the recycled cooling oil entering the oil return hole 116. Along the motor radial direction R, the second opening 1162 is located on a side that is of the first opening 1161 and that is away from the motor axis. The orientation of the second opening 1162 intersects the motor axial direction Y. Therefore, the cooling oil can flow along a direction away from the motor axis after passing through the second opening 1162.

In this embodiment of this application, along the motor radial direction R, the distance between the first opening 1161 and the motor axis O is less than the distance between the second opening 1162 and the motor axis O. When the oil return hole 116 is placed in a low position, a height of the second opening 1162 is lower than a height of the first opening 1161 according to the foregoing setting, so that the cooling oil can more smoothly flow to the inner side of the motor.

With reference to FIG. 27 and FIG. 31, in an embodiment, the width of the oil return hole 116 along the motor circumferential direction C is greater than a width of each cooling hole 113 along the motor circumferential direction C. In this embodiment of this application, the width of the cooling hole 113 along the motor circumferential direction C is set in a small range, to ensure a large flow rate of the cooling oil flowing out of the cooling hole 113 and help reduce a loss on a transmission path. Because a quantity of cooling holes 113 is greater than or equal to 1, if the cooling hole 113 is set to be large, structural strength of the motor end cover 110 may be affected. The width of the oil return hole 116 along the motor circumferential direction C is set in a large range, so that more cooling oil flows into the motor 100 through the oil return hole 116, to improve cooling effect, avoid silting of the cooling oil, and prevent the motor 100 from being affected.

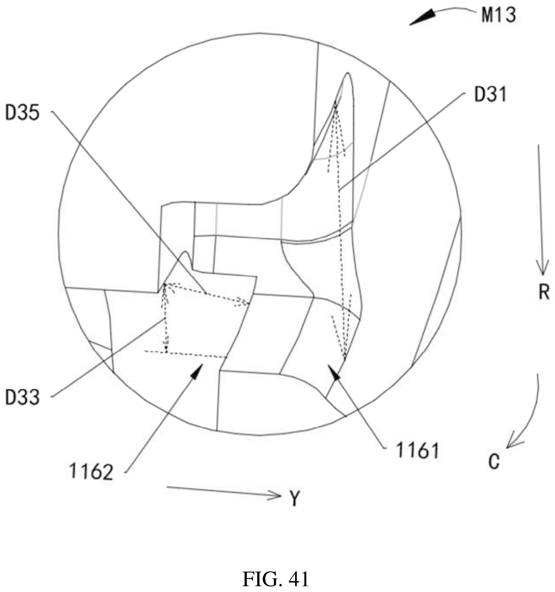

With reference to FIG. 25, FIG. 27, FIG. 40, and FIG. 41, FIG. 40 is a locally enlarged diagram of an M12 part of the motor end cover 110 shown in FIG. 27, and FIG. 41 is a locally enlarged diagram of an M13 part of the powertrain 10 shown in FIG. 39.

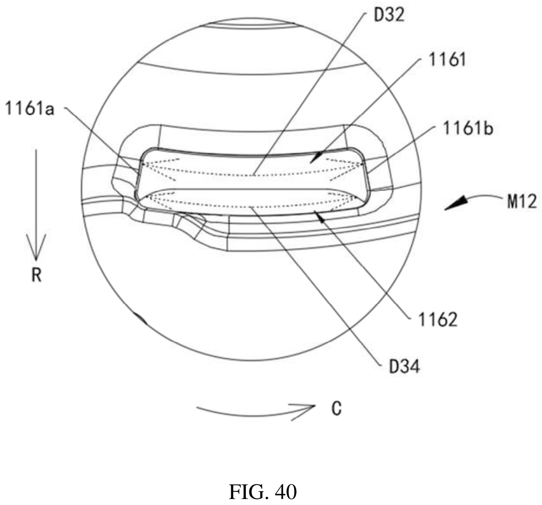

In an embodiment, an average width of either of the first opening 1161 and the second opening 1162 along the motor radial direction R is less than the radius of the motor shaft hole 111 (as shown in FIG. 27 and FIG. 41). An average width of either of the first opening 1161 and the second opening 1162 along the motor circumferential direction C is less than the radius of the motor shaft hole 111 (as shown in FIG. 27 and FIG. 40). The average width of the first opening 1161 along the motor circumferential direction C is greater than the average width of the first opening 1161 along the motor radial direction R (as shown in FIG. 40 and FIG. 41), and the width of the second opening 1162 along the motor circumferential direction C is greater than the width of the second opening 1162 along the motor radial direction R (as shown in FIG. 40 and FIG. 41). The motor axial direction Y is the axial direction of the motor shaft 140, the motor radial direction R is the radial direction of the motor shaft 140, and the motor circumferential direction C is the circumferential direction of the motor shaft. The motor axial direction Y is denoted as the first direction Y.

In this embodiment of this application, the oil return hole 116 and the motor shaft hole 111 are integrated into the motor end cover 110, and a plurality of functions are integrated into the motor end cover 110, to help reduce costs. The average width of the first opening 1161 along the motor radial direction R is denoted as D31 (as shown in FIG. 41). The average width of the first opening 1161 along the motor circumferential direction C is denoted as D32 (as shown in FIG. 40). The average width of the second opening 1162 along the motor radial direction R is denoted as D33 (as shown in FIG. 41). The average width of the second opening 1162 along the motor circumferential direction C is denoted as D34 (as shown in FIG. 40). The radius of the motor shaft hole 111 is denoted as D29 (as shown in FIG. 27).

In this solution, the first opening 1161 and the second opening 1162 of the oil return hole 116 are compared with the motor shaft hole 111 in dimensions, that is, D31<D29, D32<D29, D33<D29, D34<D29, D33>D31, and D34>D32. In this embodiment of this application, the widths of the first opening 1161 and the second opening 1162 in the motor radial direction R and the motor circumferential direction C are set in small ranges, to avoid providing an excessively large oil return hole 116 on the motor end cover 110. This helps enhance structural strength of the motor end cover 110. In addition, a small oil return hole 116 can be used to prevent a foreign matter from falling into the inner side of the motor 100 through the oil return hole 116, to reduce external impact on the motor 100.

In this embodiment of this application, the radius of the motor shaft hole 111 is set in a large range, to ensure that the motor shaft hole 111 can effectively implement functions. Specifically, if the radius D29 of the motor shaft hole 111 is set to be less than the width of the first opening 1161 or the second opening 1162 along the motor radial direction R or along the motor circumferential direction C, the motor shaft hole 111 cannot be used to accommodate the motor shaft 140. In this embodiment of this application, the average width D32 of the first opening 1161 along the motor circumferential direction C is set to be greater than the average width D31 of the first opening 1161 along the motor radial direction R, and the width D34 of the second opening 1162 along the motor circumferential direction C is set to be greater than the width D33 of the second opening 1162 along the motor radial direction R, so that the first opening 1161 and the second opening 1162 have large lengths in the motor circumferential direction C. This helps the cooling oil enter the oil return hole 116. The first opening 1161 and the second opening 1162 have small lengths in the motor radial direction R, to reduce the dimension value of the motor end cover 110 in the motor radial direction R and provide space for providing the motor shaft hole 111 and another structure in the motor radial direction R. In addition, structural strength of the motor end cover 110 can be further ensured, and a large-granularity foreign matter cannot enter the oil return hole 116.

It should be noted that, because a region enclosed by the first opening 1161 is not a regular rectangle, the width of the first opening 1161 in the motor radial direction R is the average width of the first opening 1161 in the motor radial direction R, and the width of the first opening 1161 in the motor circumferential direction C is the average width of the first opening 1161 in the motor circumferential direction C. The second opening 1162 is similar.

Still with reference to FIG. 40 and FIG. 41, in an embodiment, the average width of the first opening 1161 along the motor circumferential direction C is greater than the average width of the second opening 1162 along the motor circumferential direction C (as shown in FIG. 40), and the average width of the first opening 1161 along the motor radial direction R is greater than the width D35 of the second opening 1162 (as shown in FIG. 41). A width direction of the second opening 1162 intersects all of the motor axial direction Y, the motor radial direction R, and the motor circumferential direction C (as shown in FIG. 41).

In this embodiment of this application, dimension values of the first opening 1161 in both the motor circumferential direction C and the motor radial direction R are greater than those of the second opening 1162, so that an area of the first opening 1161 is greater than an area of the second opening 1162. Even if a foreign matter falls into the first opening 1161, it is difficult for the foreign matter to enter the inner side of the motor 100 through the second opening 1162, to avoid damage caused by the foreign matter to components in the motor 100.

In an embodiment, the average width of the first opening 1161 along the motor circumferential direction C is equal to the average width of the second opening 1162 along the motor circumferential direction C.

Still with reference to FIG. 38 and FIG. 39, in an embodiment, the motor 100 further includes a conductive bearing 103 (as shown in FIG. 38 and FIG. 39). The conductive bearing 103 is configured to be grounded. The motor shaft cavity 143 is configured to accommodate the conductive bearing 103 (as shown in FIG. 38 and FIG. 39). The width of the second opening 1162 is less than a diameter of a steel ball 1031 in the conductive bearing 103.

In this embodiment of this application, the conductive bearing 103 is located in the motor shaft cavity 143 and is configured to be grounded, so that a voltage generated by the motor shaft 140 is grounded, to form a grounding path in the motor 100. Accumulated charges can be conducted by the conductive bearing 103 to the ground. In an embodiment, the motor 100 further includes a motor bearing. The motor bearing is sleeved on the motor shaft 140. The conductive bearing 103 is electrically connected to the motor bearing. In this embodiment of this application, the conductive bearing 103 is configured to prevent the motor bearing from being electrically corroded, to ensure normal running of the motor bearing.

In this embodiment of this application, the conductive bearing 103 is a non-working sacrificial bearing. The conductive bearing 103 may be damaged or aged in a working process, so that the steel ball 1031 in the conductive bearing 103 may fall out of the motor shaft cavity 143. Because the motor shaft hole 111 and the oil return hole 116 are adjacently arranged in the motor radial direction R, the steel ball 1031 of the conductive bearing 103 may fall to the oil return hole 116. In this solution, the width of the second opening 1162 is set to be less than a diameter of the steel ball 1031, so that the steel ball 1031 cannot enter the inner side of the motor from the second opening 1162, to protect components in the motor 100. For example, the diameter of the steel ball 1031 may be 3 millimeters, the width value of the second opening 1162 may be 2.3 millimeters, and the diameter of the steel ball 1031 is greater than the width value of the second opening 1162, so that the steel ball 1031 cannot enter the inner side of the motor 100 through the second opening 1162.

Still with reference to FIG. 27 and FIG. 40, in an embodiment, the first opening 1161 includes a first side edge 1161a and a second side edge 1161b (as shown in FIG. 40), and the first side edge 1161a and the second side edge 1161b are arranged relative to each other along the motor circumferential direction C (as shown in FIG. 40). Along the motor radial direction R, an angle value of an included angle between a connecting line between the first side edge 1161a and the motor axis O and a connecting line between the second side edge 1161b and the motor axis O is greater than or equal to 15°, and is less than or equal to 25° (as shown in FIG. 27 and FIG. 40). One end of the connecting line between the first side edge 1161a and the motor axis O intersects one end of the connecting line between the second side edge 1161b and the motor axis O.

In this embodiment of this application, along the motor radial direction R, the angle value of the included angle between the connecting line between the first side edge 1161a and the motor axis O and the connecting line between the second side edge 1161b and the motor axis O is denoted as α (as shown in FIG. 27). In an example, when the vehicle travels on a flat ground, as shown in FIG. 27, the oil return hole 116 is in a lowest position. Heights of the first side edge 1161a and the second side edge 1161b are equal. The cooling oil enters the oil return hole 116 through a region between the first side edge 1161a and the second side edge 1161b. When the vehicle goes up a slope, the oil return hole 116 rotates anticlockwise, so that a height of the first side edge 1161a is lower than that of the second side edge 1161b. This is different from the case in which the vehicle travels on the flat ground. In this solution, 15°≤α≤25° is set. In this way, most cooling oil can cross the first side edge 1161a with a smaller height in the oil return hole 116 and enter the oil return hole 116, and further enter the inner side of the motor 100 through the oil return hole 116, to effectively recycle the cooling oil. When the vehicle goes down a slope, the oil return hole 116 rotates clockwise, so that a height of the first side edge 1161a is higher than that of the second side edge 1161b. This is different from the case in which the vehicle travels on the flat ground. In this solution, 15°≤α≤25° is set. In this way, most cooling oil can cross the second side edge 1161b with a smaller height of the oil return hole 116 and enter the oil return hole 116, to effectively recycle the cooling oil. For example, α may be 20°. It should be noted that clockwise and anticlockwise in this implementation are merely relative concepts. The oil return hole 116 may present different rotation directions at different observation angles.

Still with reference to FIG. 40 and FIG. 41, in an embodiment, a ratio of the width of the first opening 1161 along the motor circumferential direction C to the width of the first opening 1161 along the motor radial direction R is greater than or equal to 1.2, and is less than or equal to 2. In this solution, the width D32 of the first opening 1161 along the motor circumferential direction C is set to be greater than the width D31 of the first opening 1161 along the motor radial direction R, and the ratio between the two is set to be greater than or equal to 1.2 and less than or equal to 2. Because most cooling oil flows into the oil return hole 116 along the motor circumferential direction C, a dimension of the oil return hole 116 is reduced in this solution while a requirement for recycling and using the cooling oil is met, to avoid providing an excessively large oil return hole 116 on the motor end cover 110. This helps ensure both utilization of the cooling oil and structural strength of the motor end cover 110. In this solution, the oil return hole 116 can be used to recycle and use the cooling oil when the vehicle goes up a slope or goes down a slope, to improve practicability of the oil return hole 116. For example, the ratio of the width of the first opening 1161 along the motor circumferential direction C to the width of the first opening 1161 along the motor radial direction R may be 1.65.

In an embodiment, the average width of the first opening 1161 along the motor circumferential direction C is greater than or equal to 10 millimeters and is less than or equal to 20 millimeters. The average width of the first opening 1161 along the motor radial direction R is greater than or equal to 5 millimeters and is less than or equal to 10 millimeters.

In this solution, the average width of the first opening 1161 along the motor circumferential direction C and the average width of the first opening 1161 along the motor radial direction R are set within the foregoing range. Because the cooling oil flows into the oil return hole 116 roughly along the motor circumferential direction C, a dimension of the oil return hole 116 is reduced in this solution while a requirement for recycling and using the cooling oil is met, to avoid providing an excessively large oil return hole 116 on the motor end cover 110. This helps ensure both utilization of the cooling oil and structural strength of the motor end cover 110. In this solution, the oil return hole 116 can be used to recycle and use the cooling oil when the vehicle goes up a slope or goes down a slope, to improve practicability of the oil return hole 116. For example, the average width of the first opening 1161 along the motor circumferential direction C may be 14.9 millimeters, and the average width of the first opening 1161 along the motor radial direction R may be 9 millimeters.

Still with reference to FIG. 27, in an embodiment, along the motor radial direction R, a distance between the oil return hole 116 and the motor shaft hole 111 is less than the distance between the winding wiring hole 112 and the motor shaft hole 111. Along the motor circumferential direction C, axes of the at least one cooling hole 113, the winding wiring hole 112, and the motor shaft hole 111 are arranged on one side of the oil guide rib 160, and the oil return hole 116 is arranged on the other side of the oil guide rib 160.

In this embodiment of this application, it may be understood that the motor radial direction R is not a uniquely determined direction, and a direction that uses the motor axis as an origin and that is perpendicular to the motor axial direction Y may be understood as the motor radial direction R. For example, when the distance between the oil return hole 116 and the motor shaft hole 111 along the motor radial direction R is measured, the motor radial direction R is an R1 direction shown in FIG. 27; and when the distance between the winding wiring hole 112 and the motor shaft hole 111 is measured, the motor radial direction R is an R2 direction shown in FIG. 27. A dimension value of the distance between the oil return hole 116 and the motor shaft hole 111 along the motor radial direction R is denoted as D36 (as shown in FIG. 27). Because there is an electrical connection relationship between the electrical connecting piece 150 in the winding wiring hole 112 and the motor controller 200, and the cooling oil flows into the motor shaft hole 111 through the oil guide rib 160, D17>D36 is set. In other words, a large distance is set between the winding wiring hole 112 and the motor shaft hole 111 along the motor radial direction R, so that an electrical connection and a mechanical connection do not affect each other.

In this embodiment of this application, in the motor circumferential direction C, the axes of the at least one cooling hole 113, the winding wiring hole 112, and the motor shaft hole 111 are arranged on one side of the oil guide rib 160 in the motor circumferential direction C, so that a part of the cooling oil flows to the electrical connecting piece 150 through the cooling hole 113 and can further flow to the oil guide rib 160. The oil return hole 116 is located on the other side of the oil guide rib 160 in the motor circumferential direction C, so that a part of the cooling oil that is located on the outer side of the motor 100 and that does not flow through the oil guide rib 160 can be further recycled and used through the oil return hole 116, to improve utilization of the cooling oil. As shown in FIG. 27, when an up-and-down direction of FIG. 27 is a height direction of placing the powertrain, both the cooling hole 113 and the winding wiring hole 112 are higher than the oil guide rib 160. In this way, the cooling oil sprayed from the cooling hole 113 falls on the electrical connecting piece of the winding wiring hole 112 and then falls on the oil guide rib 160, and the cooling oil flowing from the oil guide rib 160 into the motor shaft hole 111 falls into the oil return hole 116 and enters the inner side of the motor from the oil return hole 116.

Still with reference to FIG. 26, in an embodiment, along the motor radial direction R, the oil return hole 116 and the axis O of the motor shaft hole 111 are arranged on two sides of the arc-shaped protrusion structure 141. In this embodiment of this application, the arc-shaped protrusion structure 141 is away from a protrusion of the motor stator 120 along the motor axial direction Y, and the arc-shaped protrusion structure 141 is located between the oil return hole 116 and the motor shaft hole 111 along the motor radial direction R. When a foreign matter falls out of the motor shaft hole 111, the arc-shaped protrusion structure 141 can block the foreign matter, to prevent the foreign matter from falling into the oil return hole 116 and causing adverse impact on normal working of the motor 100. The axis O of the motor shaft hole 111 is also the motor axis O.

Still with reference to FIG. 26, in an embodiment, the oil guide groove 114 and the oil return hole 116 are spaced and arranged along the motor circumferential direction C. Along the motor circumferential direction C, a distance between the oil guide groove 114 and the oil return hole 116 is greater than a length of the oil guide groove 114, and the length of the oil guide groove 114 is less than a length of the oil return hole 116.

In this embodiment of this application, the oil guide groove 114 is configured to feed the cooling oil into the motor shaft hole 111, and the oil return hole 116 is configured to feed the cooling oil into the inner side of the motor 100. In this solution, it is set that the oil guide groove 114 and the oil return hole 116 are spaced and arranged, and the distance between the oil guide groove 114 and the oil return hole 116 is greater than the length of the oil guide groove 114, to avoid cooling oil mixing between the oil guide groove 114 and the oil return hole 116. Because space in the motor shaft hole 111 is limited, the length of the oil guide groove 114 is set to be less than the length of the oil return hole 116, so that fastening of a component in the motor shaft hole 111 is more stable and the component in the motor shaft hole 111 is not detached due to an excessively large length of the oil guide groove 114. To compensate for a reduced recycling rate of the cooling oil due to a small length of the oil guide groove 114, the oil return hole 116 is set to be long to prevent excessive cooling oil from silting in the motor shaft hole 111.

Still with reference to FIG. 25, in an embodiment, the region enclosed by the projection of the wiring cover fastening structure 142 covers the motor shaft hole 111, the arc-shaped protrusion structure 141, the winding wiring hole 112, the cooling hole 113, and the oil return hole 116.

In this embodiment of this application, the wiring cover 102, the motor shaft hole 111, the arc-shaped protrusion structure 141, the winding wiring hole 112, the cooling hole 113, and the oil return hole 116 are all located on a side away from the motor stator 120, and the region enclosed by the projection of the wiring cover fastening structure 142 covers the motor shaft hole 111, the arc-shaped protrusion structure 141, the winding wiring hole 112, the cooling hole 113, and the oil return hole 116 along the motor axial direction Y. The wiring cover fastening structure 142 is configured to fasten the wiring cover 102. It is set in this solution that the wiring cover fastening structure 142 and the wiring cover 102 can prevent a foreign matter from being mixed with the cooling oil flowing out of the cooling hole 113, avoid external environment impact on an electrical connection relationship between the electrical connecting piece 150 and the motor controller 200, prevent a foreign matter from entering the motor shaft hole 111 and the oil return hole 116, and ensure a fixed connection between the arc-shaped protrusion structure 141 and the rotary sensor stator 170, to ensure normal working of the motor 100 in a plurality of aspects.

In this embodiment of this application, the projection of the wiring cover fastening structure 142 along the motor radial direction R covers the projection of the arc-shaped protrusion structure 141 along the motor radial direction R. This indicates that a dimension value of the wiring cover fastening structure 142 is greater than a dimension value of the arc-shaped protrusion structure 141 in the motor axial direction Y. In other words, a protruding height of the wiring cover 102 along the motor axial direction Y is greater than a protruding height of the arc-shaped protrusion structure 141 along the motor axial direction Y.

In this embodiment of this application, the arrangement direction of the cooling hole 113, the winding wiring hole 112, and the motor shaft hole 111 is approximately parallel to the motor radial direction R, so that an electrical interface layout of the motor 100 is more compact, to help reduce the volume of the wiring cover 102 and reduce costs.

In an embodiment, the wiring cover fastening structure 142, the oil guide rib 160, the arc-shaped protrusion structure 141, and the motor end cover 110 are an integrally formed structure, so that overall structural strength of the motor end cover 110 is higher.

Still with reference to FIG. 38 and FIG. 39, in an embodiment, the wiring cover 102 is configured to electrically connect to the conductive bearing 103. Along the motor radial direction R, the wiring cover fastening structure 142 and the first opening 1161 of the oil return hole 116 are adjacently arranged (as shown in FIG. 25). The wiring cover 102 may also be referred to as a rotary cover.

For example, the motor 100 further includes a spring plate structure 104 (as shown in FIG. 39). One end of the spring plate structure 104 is located in the conductive bearing and is electrically connected to the conductive bearing, and the other end of the spring plate structure 104 abuts against the wiring cover 102, so that a current in the conductive bearing can flow to the wiring cover 102 to implement grounding, to avoid electric corrosion for the motor bearing.

In this embodiment of this application, the wiring cover fastening structure 142 and the first opening 1161 of the oil return hole 116 are adjacently arranged along the motor radial direction R, so that the cooling oil falling on the wiring cover fastening structure 142 can be guided to the first opening 1161.

In an embodiment, the oil return hole 116 of the motor end cover 110 and the wiring cover fastening structure 142 of the motor end cover 110 are adjacently arranged along a height direction, and a projection of the oil return hole 116 along the height direction covers a projection of a lowest point of the wiring cover fastening structure 142 in the motor end cover 110. It may be understood that the flow of the cooling oil is affected by gravity. In this embodiment of this application, the cooling oil is guided by the wiring cover fastening structure 142 to flow to the oil return hole 116. When the motor 100 is used in a vehicle scenario, the oil return hole 116 and the wiring cover fastening structure 142 are set to be adjacently arranged in the gravity direction, so that a flow path of the cooling oil between the oil guide rib 160 and the motor shaft hole 111 complies with the gravity direction, to help reduce flow resistance. The projection of the oil return hole 116 along the height direction is set to cover the projection of the lowest point of the wiring cover fastening structure 142, so that the cooling oil flowing into the oil return hole 116 can be further guided to flow along the gravity direction, to help collect the cooling oil.

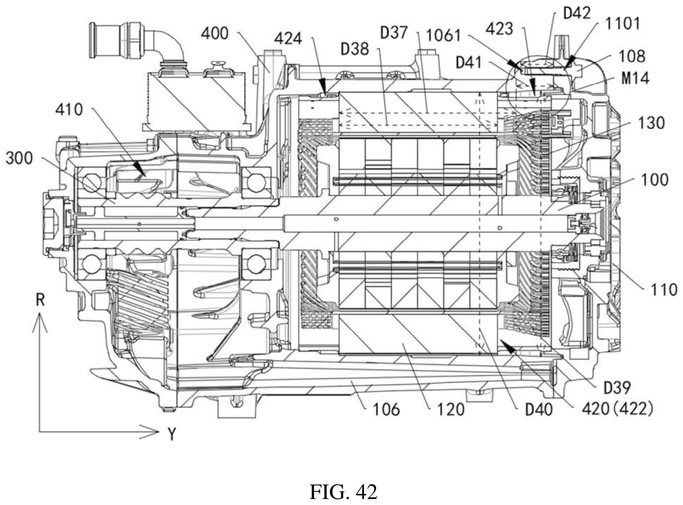

With reference to FIG. 42, FIG. 42 is a sectional view of the motor 100 shown in FIG. 37 along FF. In an embodiment, the motor 100 includes a motor housing 106 (as shown in FIG. 37 and FIG. 42). The motor housing 106 is an integrally formed structure. The motor accommodating cavity 420 is enclosed by the motor housing 106 (as shown in FIG. 42). The motor accommodating cavity 420 penetrates the motor housing 106 along the motor axial direction Y (as shown in FIG. 42). The motor accommodating cavity 420 is configured to fasten the motor stator 120. The motor accommodating cavity 420 includes a stator cavity 422 and an end part cavity 423 (as shown in FIG. 42). The stator cavity 422 and the end part cavity 423 are adjacently arranged (as shown in FIG. 42). Along the motor axial direction Y, a length of the stator cavity 422 is greater than or equal to a length of the motor stator 120 (as shown in FIG. 42). Along the motor radial direction R, an inside diameter of the end part cavity 423 is greater than an inside diameter of the stator cavity 422 (as shown in FIG. 42).

In this embodiment of this application, to cooperate with the motor stator 120 and the motor rotor 190 to implement rotation of the motor shaft, the motor stator and the motor rotor are usually cylindrical. Therefore, the motor accommodating cavity 420 is usually a cylindrical tube-shaped. The motor accommodating cavity 420 includes the stator cavity 422 and the end part cavity 423 that are adjacently arranged. When the motor stator 120 is assembled into the motor housing 106, the motor stator 120 passes through the end part cavity 423 to reach the stator cavity 422. An assembly status of the motor stator 120 has key impact on assembly of other components in the motor 100.

Still with reference to FIG. 42, a length of the stator cavity 422 in the motor axial direction Y is denoted as D37, a length of the motor stator 120 in the motor axial direction Y is denoted as D38, a length of the end part cavity 423 in the motor radial direction R is denoted as D39, and a length of the stator cavity 422 in the motor radial direction R is denoted as D40. D37≥D38 is set in this solution. In this way, a projection of the stator cavity 422 in the motor radial direction R can fully cover a projection of the motor stator 120 in the motor radial direction R, so that the stator cavity 422 accommodates the motor stator 120 in the motor axial direction Y. D39>D40 is set. In this way, in an assembly process of the motor stator 120, abrasion does not occur between the motor stator 120 and the end part cavity 423, or the motor stator 120 is not stuck in the end part cavity 423. Because the end part cavity 423 and the stator cavity 422 are adjacently arranged, the end part cavity 423 can further guide assembly and disassembly of the motor stator 120, to help reduce difficulty in assembling and disassembling the motor stator 120 and improve assembly efficiency of the motor 100. To improve a matching degree between an inner wall of the stator cavity 422 and the motor stator 120, the inner wall of the stator cavity 422 is processed, so that a matching degree between the inner wall of the stator cavity 422 and an outer surface of the motor stator 120 is higher, and structural strength of the motor stator 120 and the motor housing 106 is higher. When D39>D40 is set, the inner wall of the end part cavity 423 is not abraded during machining of the inner wall of the stator cavity 422. In this way, the following case is avoided: Air holes appear on the inner wall of the end part cavity 423, thereby reducing sealing performance.

In this embodiment of this application, in the motor axial direction Y, the length of the stator cavity 422 is greater than or equal to the length of the motor stator 120, so that the stator cavity 422 can fully accommodate the motor stator 120 in the motor axial direction Y. In the motor radial direction R, the inside diameter of the end part cavity 423 is greater than the inside diameter of the stator cavity 422, to prevent the end part cavity 423 from hindering assembly of the motor stator 120. In addition, the end part cavity 423 can be further configured to guide the electric stator to be assembled to the stator cavity 422, to improve assembly efficiency. The inner wall of the end part cavity 423 is not abraded during machining of the inner wall of the stator cavity 422. In this way, the following case is avoided: Air holes appear on the inner wall of the end part cavity 423, thereby reducing sealing performance.

In an embodiment, a projection surface of the stator cavity 422 in the motor radial direction R is the same as a projection surface of the motor stator 120 in the motor radial direction R.

In an embodiment, surface roughness of the inner wall of the end part cavity 423 is greater than surface roughness of the inner wall of the stator cavity 422. The surface roughness means unevenness of a surface with small distances and small peaks and valleys. Smaller surface roughness indicates a smoother surface. In this embodiment of this application, the surface roughness of the inner wall of the stator cavity 422 is relatively small, and the inner wall of the stator cavity 422 is smoother than the inner wall of the end part cavity 423. This helps improve assembly precision between the motor stator 120 and the stator cavity 422, and ensures structural reliability of the motor stator 120 and the motor housing 106. The surface roughness of the inner wall of the end part cavity 423 is relatively large, to reduce processing costs. The inside diameter of the end part cavity 423 in the motor radial direction R is greater than the inside diameter of the stator cavity 422. The surface roughness of the inner wall of the end part cavity 423 does not adversely affect installation of the motor stator 120.

In an embodiment, a quantity of air holes on the inner wall of the stator cavity 422 is greater than a quantity of air holes on the inner wall of the end part cavity 423. When die casting is performed for the motor housing 106, air holes are easily generated in the motor housing 106. A plurality of air holes communicate with each other to form an air hole path (not shown in the figure). When the plurality of air holes communicate with each other along the motor radial direction R, the cooling oil in the motor accommodating cavity 420 leaks. After the inner wall of the stator cavity 422 is cut, some air holes may be exposed. However, the inner wall of the stator cavity 422 is configured to precisely cooperate with the motor stator 120. For example, an interference fit is implemented between the motor stator 120 and the inner wall of the stator cavity 422, so that there is a small gap or no gap between the motor stator 120 and the inner wall of the stator cavity 422. All the inner wall of the stator cavity 422 is machined. Even if some of the air holes are exposed, sealing performance in the motor accommodating cavity 420 is not affected. However, there is no other structural member on the inner wall of the end part cavity 423 for close cooperation. If a large quantity of air holes appear on the inner wall of the end part cavity 423, the cooling oil may leak from a path of air holes communicating with each other. In this solution, the surface roughness of the inner wall of the end part cavity 423 is set to be greater than the surface roughness of the inner wall of the stator cavity 422, or a cutting degree of the inner wall of the end part cavity 423 is set to be less than a cutting degree of the inner wall of the stator cavity 422. In this way, there are a small quantity of air holes on the inner wall of the end part cavity 423, to block circulation of the cooling oil in the air holes and reduce a leakage risk of the cooling oil.

In an embodiment, the inner wall of the end part cavity 423 is a rough surface, and the inner wall of the stator cavity 422 is a machined surface. In this embodiment of this application, the rough surface is a surface formed through die casting, an inner wall of the machined surface has a cutting sign, and an inner wall of the rough surface has no cutting sign. In this embodiment of this application, density of the rough surface is greater than density of the machined surface. The motor housing 106 is formed through die casting. The inner wall of the end part cavity 423 is the rough surface with high density. The inner wall of the end part cavity 423 has no air hole or only few air holes. The inner wall of the end part cavity 423 has better sealing performance. In this embodiment of this application, the inner wall of the machined surface has the cutting sign, the inner wall of the rough surface has no cutting sign, and the surface roughness of the rough surface is greater than the surface roughness of the machined surface.

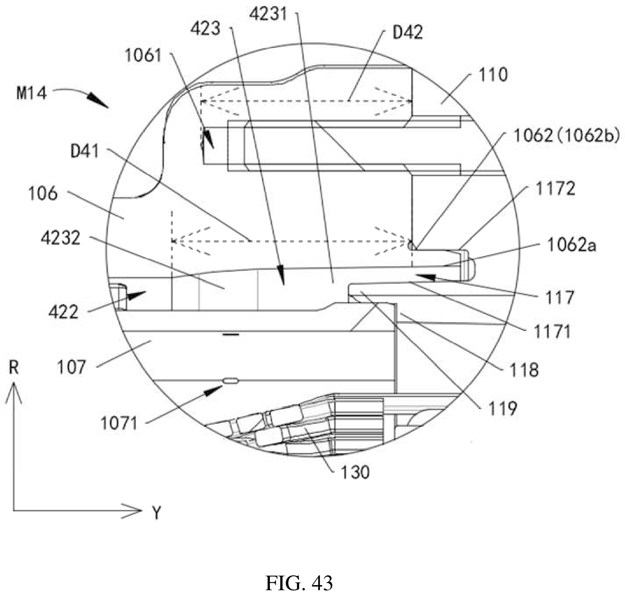

With reference to FIG. 42 and FIG. 43, FIG. 43 is a locally enlarged diagram of an M14 part of the motor 100 shown in FIG. 42. In an embodiment, one end of the end part cavity 423 and the other end of the end part cavity 423 are arranged along the motor axial direction Y (as shown in FIG. 42 and FIG. 43). A diameter of one end of the end part cavity 423 is greater than a diameter of the other end of the end part cavity 423 (as shown in FIG. 42 and FIG. 43). The other end of the end part cavity 423 is adjacent to the stator cavity 422 (as shown in FIG. 42 and FIG. 43).

In this embodiment of this application, one end of the end part cavity 423, the other end of the end part cavity 423, and the stator cavity 422 are sequentially arranged along the motor axial direction Y. In the motor axial direction Y, the diameter of one end of the end part cavity 423 is greater than the diameter of the other end of the end part cavity 423. Therefore, in an assembly process of the motor stator 120, one end of the end part cavity 423 and the other end of the end part cavity 423 can guide the motor stator 120.

Still with reference to FIG. 42 and FIG. 43, in an embodiment, the inner wall of the end part cavity 423 includes a draft section 4231 and a transition arc section 4232. The draft section 4231, the transition arc section 4232, and the stator cavity 422 are sequentially adjacently arranged along the motor axial direction Y. One end of the draft section 4231 and the other end of the draft section 4231 are arranged relative to each other along the motor axial direction Y. The other end of the draft section 4231 is adjacent to the transition arc section 4232. A diameter of the draft section 4231 gradually decreases from one end of the draft section 4231 to the other end of the draft section 4231. An inner wall of the transition arc section 4232 is arc-shaped.

In this embodiment of this application, to reduce the surface roughness of the inner wall of the stator cavity 422, the inner wall of the stator cavity 422 needs to be processed by using a mold. In this solution, the diameter of the draft section 4231 is set to gradually decrease from one end of the draft section 4231 to the other end of the draft section 4231. This is equivalent to a case in which there is an included angle between an extension direction of the draft section 4231 and the motor axial direction Y. In this way, the mold used for processing can be smoothly detached from the motor accommodating cavity 420, to avoid abrasion on the inner wall of the motor accommodating cavity 420. The transition arc section 4232 is provided between the draft section 4231 and the inner wall of the stator cavity 422, to help reduce stress concentration and enhance structural strength of the motor housing 106.

Still with reference to FIG. 42 and FIG. 43, in an embodiment, along the motor axial direction Y, the length of the end part cavity 423 is less than the length of the stator cavity 422 (as shown in FIG. 42 and FIG. 43), and the length of the end part cavity 423 is less than the length of the motor stator 120 (as shown in FIG. 42 and FIG. 43). In this embodiment of this application, the length of the end part cavity 423 in the motor axial direction Y is denoted as D41 (as shown in FIG. 43). Because the end part cavity 423 does not need to be used to accommodate the motor stator 120, D41<D37 and D41<D38 are set in this solution. A volume and manufacturing costs of the motor housing 106 are reduced without affecting assembly and fastening of the motor stator 120.

Still with reference to FIG. 42, in an embodiment, the motor accommodating cavity 420 further includes an inner cavity 424. The inner cavity 424, the stator cavity 42, and the end part cavity 423 are sequentially adjacently arranged along the motor axial direction Y. The inner cavity 424 is configured to accommodate a part of the motor winding 130 on a side that is of the motor stator 120 and that is away from the motor end cover 110. In an embodiment, an inner wall of the inner cavity 424 is a rough surface.

Still with reference to FIG. 42 and FIG. 43, in an embodiment, the motor housing 106 further includes a bolt hole 1061 (as shown in FIG. 42 and FIG. 43). The bolt hole 1061 is configured to fasten the motor housing 106 and the motor end cover 110. Along the motor radial direction R, a projection of the bolt hole 1061 is located in a projection of the end part cavity 423 (as shown in FIG. 43). Along the motor axial direction Y, a length of the bolt hole 1061 is less than the length of the end part cavity 423 (as shown in FIG. 43).

In this embodiment of this application, the motor end cover 110 is close to the adjacent end part cavity 423 along the motor axial direction Y, and the motor housing 106 and the motor end cover 110 are fastened by using the bolt hole 1061, to help enhance structural strength of the motor 100. An opening of the bolt hole 1061 faces the motor end cover 110 along the motor axial direction Y. The length of the bolt hole 1061 in the motor axial direction Y is denoted as D42 (as shown in FIG. 43). D42<D41 is set. In this way, the projection of the end part cavity 423 in the motor radial direction R can cover the projection of the bolt hole 1061 in the motor radial direction R. Because the inner wall of the end part cavity 423 has large surface roughness and high density, the cooling oil in the motor 100 does not flow into the bolt hole 1061 through the inner wall of the end part cavity 423. Usually, the bolt hole 1061 is formed in the motor housing 106 through machining. An air hole is exposed on an inner wall of the bolt hole 1061. If the inner wall of the end part cavity 423 relative to the bolt hole 1061 also has an air hole, the air holes of the bolt hole 1061 and the inner wall of the end part cavity 423 may communicate with each other, thereby increasing a leakage risk of the cooling oil. In this application, the bolt hole 1061 is relative to the end part cavity 423 having a rough surface, and the projection of the bolt hole 1061 along the motor radial direction R is located in the projection of the end part cavity 423, to improve sealing performance and reduce a leakage risk of the cooling oil.

Still with reference to FIG. 42 and FIG. 43, along the motor radial direction R, a distance between the inner wall of the end part cavity 423 and the bolt hole 1061 is greater than a distance between the inner wall of the stator cavity 422 and an outer surface of the motor housing 106 (as shown in FIG. 42 and FIG. 43). In this embodiment of this application, it is set that the distance between the inner wall of the end part cavity 423 and the bolt hole 1061 in the motor radial direction R is large, and the bolt hole 1061 and the inner wall of the stator cavity 422 do not overlap along the motor radial direction R. In this way, the distance between the bolt hole 1061 and the inner wall of the stator cavity 422 is large. Therefore, even if the bolt hole 1061 and the inner wall of the stator cavity 422 have the air holes due to machining, because a transmission path of the cooling oil between the inner wall of the stator cavity 422 and the bolt hole 1061 is long, it is difficult for the cooling oil to enter the bolt hole 1061, to effectively avoid leakage of the cooling oil.

A projection surface of a projection along the motor radial direction R is perpendicular to the motor radial direction R. In this embodiment of this application, a projection surface of the bolt hole 1061 in the motor radial direction R is the same as a projection surface of the end part cavity 423 in the motor axial direction Y.

In an embodiment, an axis of the bolt hole 1061 is parallel to the motor axial direction Y. Along the motor axial direction Y, a distance between the bolt hole 1061 and the motor stator 120 is greater than a distance between the end part cavity 423 and the motor stator 120. This solution helps prevent the cooling oil from entering the bolt hole 1061 through the inner wall of the motor accommodating cavity 420.

In an embodiment, the surface roughness of the inner wall of the end part cavity 423 is greater than surface roughness of a hole wall of the bolt hole 1061. In this embodiment of this application, to effectively fasten the motor housing 106 and the motor end cover 110, the surface roughness of the hole wall of the bolt hole 1061 needs to be set to be small. In other words, the bolt hole 1061 needs to be processed. Similar to the inner wall of the stator cavity 422, the inner wall of the bolt hole 1061 also has an air hole exposed. If the cooling oil flows into the bolt hole 1061 through the air hole, because a hole diameter of the bolt hole 1061 is far greater than a hole diameter of the air hole (not shown in the figure), a leakage quantity of the cooling oil is increased, and a connection relationship between the motor end cover 110 and the motor housing 106 is affected. As a result, the connection relationship becomes loose. In this solution, the surface roughness of the inner wall of the end part cavity 423 is set to be greater than the surface roughness of the hole wall of the bolt hole 1061. Because the inner wall of the end part cavity 423 has no air hole exposed, a problem of leakage of the cooling oil and the loose connection relationship can be effectively avoided.

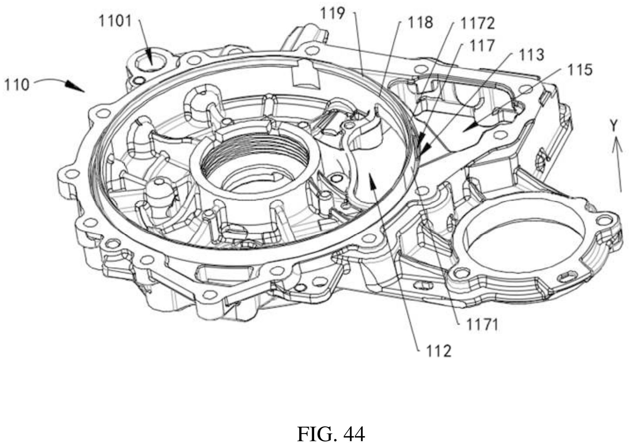

With reference to FIG. 42 to FIG. 44, FIG. 44 is a diagram of a structure of a motor end cover 110 according to an embodiment of this application. In an embodiment, the motor end cover 110 includes a housing limiting groove 117 (as shown in FIG. 43 and FIG. 44), the motor housing 106 includes a housing limiting protrusion 1062 (as shown in FIG. 43 and FIG. 44), and the housing limiting groove 117 is configured to accommodate the housing limiting protrusion 1062. Along the motor axial direction Y, the housing limiting groove 117 is concave from the motor end cover 110 in a direction away from the motor stator 120 (as shown in FIG. 42 to FIG. 44), and the housing limiting protrusion 1062 protrudes from the motor housing 106 to the motor end cover 110 (as shown in FIG. 42 to FIG. 44). The housing limiting protrusion 1062 and the bolt hole 1061 are spaced and arranged along the motor radial direction R (as shown in FIG. 42 and FIG. 43). Along the motor circumferential direction C, the housing limiting groove 117 and the housing limiting protrusion 1062 both circle the motor axis (as shown in FIG. 44).

In an embodiment, the housing limiting groove 117 and the housing limiting protrusion 1062 form a pair of stop structures. A concave direction of the housing limiting groove 117 is the same as a protrusion direction of the housing limiting protrusion 1062. The housing limiting protrusion 1062 is located in the housing limiting groove 117. The housing limiting groove 117 and the housing limiting protrusion 1062 both circle the motor axis along the motor circumferential direction C, to help strengthen a fixed connection relationship between the motor end cover 110 and the motor housing 106.

Still with reference to FIG. 43 and FIG. 44, in an embodiment, the housing limiting groove 117 includes an inner groove wall 1171 and an outer groove wall 1172 (as shown in FIG. 43 and FIG. 44), the housing limiting protrusion 1062 includes a protrusion inner wall 1062a and a protrusion outer wall 1062b (as shown in FIG. 43), and the inner groove wall 1171, the protrusion inner wall 1062a, the protrusion outer wall 1062b, and the outer groove wall 1172 are arranged along the motor radial direction R (as shown in FIG. 43 and FIG. 44). The protrusion inner wall 1062a and the inner groove wall 1171 are spaced and arranged along the motor radial direction R (as shown in FIG. 43), and the protrusion outer wall 1062b is attached to the outer groove wall 1172 (as shown in FIG. 43).

In this embodiment of this application, the motor end cover 110 and the motor housing 106 are jointly configured to protect internal components such as the motor stator 120. In a process of assembling the motor housing 106 and the motor end cover 110, the bolt hole 1061 mainly implements a fastening function, and the housing limiting protrusion 1062 and the housing limiting groove 117 implement a positioning function and an auxiliary fastening function. The protrusion inner wall 1062a and the inner groove wall 1171 are spaced and disposed along the motor radial direction R, to provide an assembly gap for the motor housing 106 and the motor end cover 110. In this way, the housing limiting protrusion 1062 can be smoothly installed into the housing limiting groove 117, the protrusion outer wall 1062b is attached to the outer groove wall 1172 along the motor radial direction R, to implement radial positioning for the motor housing 106 and the motor end cover 110. In an embodiment, an interference fit is implemented between the protrusion outer wall 1062b and the outer groove wall 1172 along the motor radial direction R.

In an embodiment, along the motor radial direction R, a length of the housing limiting protrusion 1062 is less than a length of the housing limiting groove 117. This solution helps reduce difficulty in assembling and disassembling the motor housing 106 and the motor end cover 110. If the length of the housing limiting protrusion 1062 in the motor radial direction R is greater than or equal to the length of the housing limiting groove in the motor radial direction R, it is difficult to assemble the motor housing 106 and the motor end cover 110.

In an embodiment, surface roughness of the protrusion inner wall 1062a is greater than surface roughness of the protrusion outer wall 1062b, and surface roughness of the inner groove wall 1171 is greater than surface roughness of the outer groove wall 1172. The inner wall of the stator cavity 422, the inner wall of the end part cavity 423, and the protrusion inner wall 1062a are sequentially adjacently arranged along the motor axial direction Y. Along the motor radial direction R, a distance between the protrusion inner wall 1062a and the protrusion outer wall 1062b is less than a distance between the inner wall of the end part cavity 423 and the bolt hole 1061.

In this embodiment of this application, the inner wall of the end part cavity 423 and the protrusion inner wall 1062a are adjacently arranged along the motor axial direction Y. The surface roughness of the protrusion inner wall 1062a is set to be greater than the surface roughness of the protrusion outer wall 1062b. This helps reduce processing difficulty and costs of the protrusion inner wall 1062a and the inner wall of the end part cavity 423, and prevent the cooling oil from leaking through the protrusion inner wall 1062a. The surface roughness of the protrusion outer wall 1062b is smaller than that of the protrusion inner wall 1062a. The surface roughness of the outer groove wall 1172 is smaller than that of the inner groove wall 1171. Surfaces of the protrusion outer wall 1062b and the outer groove wall 1172 are smooth after processing. Therefore, the protrusion outer wall 1062b is more closely attached to the outer groove wall 1172, to strengthen a connection relationship between the motor end cover 110 and the motor housing 106 and improve structural strength. In addition, the protrusion outer wall 1062b and the outer groove wall 1172 are closely attached to each other, which further helps enhance sealing effect, thereby avoiding a leakage risk of the cooling oil.

In an embodiment, the housing limiting protrusion 1062 and the motor housing 106 are an integrally formed structure, so that overall structural strength of the motor housing 106 is higher. In an embodiment, the protrusion inner wall 1062a of the housing limiting protrusion 1062 and the inner wall of the end part cavity 423 are both inner walls with rough surfaces, and the protrusion inner wall 1062a of the housing limiting protrusion 1062 and the inner wall of the end part cavity 423 both have drafts during mold extraction. An inside diameter of the housing limiting protrusion 1062 is greater than a diameter of the end part cavity 423.

Still with reference to FIG. 43, in an embodiment, the motor 100 further includes a flow guide ring 107, the motor winding 130, and a flow guide ring axial limiting protrusion 118. The flow guide ring axial limiting protrusion 118 is fastened to the motor end cover 110. The flow guide ring 107 is fastened between the flow guide ring axial limiting protrusion 118 and the motor stator 120 along the motor axial direction Y. The flow guide ring 107 includes a flow guide hole 1071. The end part cavity 423 is configured to accommodate a part of the flow guide ring 107 and a part of the motor winding 130.

The flow guide ring axial limiting protrusion 118 and the housing limiting groove 117 are adjacently arranged along the motor radial direction R. Along the motor radial direction R, the flow guide hole 1071 penetrates the flow guide ring 107; and the motor winding 130, the flow guide ring 107, and the inner wall of the end part cavity 423 are spaced and arranged. Along the motor radial direction R, projections of the motor winding 130 and the flow guide ring 107 partially overlap along the motor radial direction R, projections of the motor winding 130 and the flow guide hole 1071 partially overlap along the motor radial direction R, projections of the flow guide ring 107 and the end part cavity 423 partially overlap, and projections of the flow guide ring 107 and the stator cavity 422 partially overlap.

In this embodiment of this application, the motor winding 130 is configured to receive the alternating current and generate the alternating flux. When the motor 100 works, the motor winding 130 generates heat. Therefore, cooling and heat dissipation need to be performed on the motor winding 130. In this solution, the flow guide ring 107 and the flow guide ring axial limiting protrusion 118 are disposed in the motor 100. The flow guide ring axial limiting protrusion 118 is configured to fasten the flow guide ring 107 along the motor axial direction Y to a side that is of the motor stator 120 and that is close to the motor end cover 110. A part of the flow guide ring 107 is located in the end part cavity 423, and a part of the flow guide ring 107 is located in the stator cavity 422. The flow guide ring 107 is provided with the through flow guide hole 1071. In the motor radial direction R, the projection of the motor winding 130 partially overlaps both the projection of the flow guide ring 107 and the projection of the flow guide hole 1071. Therefore, the cooling oil can pass through the flow guide hole 1071 in the flow guide ring 107 to cool the motor winding 130, to improve working efficiency of the motor 100.

In this embodiment of this application, the flow guide ring 107 and the inner wall of the end part cavity 423 are spaced and arranged. Along the motor radial direction R, the projection of the flow guide ring 107 partially overlaps the projection of the end part cavity 423. Because the surface roughness of the inner wall of the end part cavity 423 is large, there is a distance between the flow guide ring 107 and the inner wall of the end part cavity 423 in the motor radial direction R. Therefore, the cooling oil can flow in the flow guide ring 107, and flows to the motor winding 130 through the flow guide hole 1071, to improve utilization of the cooling oil. The flow guide ring axial limiting protrusion 118 and the housing limiting groove 117 are adjacently arranged along the motor radial direction R. This structure has a compact layout, to help reduce a volume of the motor 100 and implement a miniaturization design.

In an embodiment, the flow guide ring axial limiting protrusion 118 and the motor end cover 110 are integrally formed. This solution helps to enhance overall structural strength of the flow guide ring axial limiting protrusion 118 and the motor end cover 110, and improve an axial limiting function of the flow guide ring 107. In this way, when the motor 100 is in a high-speed working condition, the flow guide hole 1071 of the flow guide ring 107 can be used to stably perform cooling and heat dissipation on the motor winding 130.

Still with reference to FIG. 43, in an embodiment, the motor 100 further includes a flow guide ring radial limiting part 119. The flow guide ring radial limiting part 119, the flow guide ring axial limiting protrusion 118, and the motor end cover 110 are adjacently arranged and relatively fastened along the motor axial direction Y. A projection area of the flow guide ring radial limiting part 119 along the motor axial direction Y is less than a projection area of the flow guide ring axial limiting protrusion 118 along the motor axial direction Y.

Along the motor radial direction R, the flow guide ring 107, the flow guide ring radial limiting part 119, and the inner wall of the end part cavity 423 are sequentially arranged; the flow guide ring 107 is adjacent to the flow guide ring radial limiting part 119; the flow guide ring radial limiting part 119 is spaced from the inner wall of the end part cavity 423; and projections of the flow guide ring 107 and the flow guide ring radial limiting part 119 partially overlap along the motor radial direction R.

In this embodiment of this application, along the motor radial direction R, the flow guide ring radial limiting part 119 and the flow guide ring 107 are adjacently disposed; and the projections of the flow guide ring 107 and the flow guide ring radial limiting part 119 partially overlap along the motor radial direction R. In this way, the flow guide ring radial limiting part 119 can be used to limit movement of the flow guide ring 107 in the motor radial direction R. Along the motor radial direction R, the flow guide ring radial limiting part 119 is located between the flow guide ring 107 and the inner wall of the end part cavity 423; and the flow guide ring radial limiting part 119 and the inner wall of the end part cavity 423 are spaced and disposed. In this way, the housing limiting protrusion 1062 can smoothly enter the housing limiting groove 117 through a gap between the flow guide ring radial limiting part 119 and the inner wall of the end part cavity 423. Along the motor axial direction Y, a projection area of the flow guide ring radial limiting part 119 is less than that of the flow guide ring axial limiting protrusion 118, so that the flow guide ring radial limiting part 119 does not block a connection between the flow guide ring axial limiting protrusion 118 and the flow guide ring 107.

The flow guide ring axial limiting protrusion 118 is configured to axially limit the flow guide ring 107. The flow guide ring radial limiting part 119 is configured to radially limit the flow guide ring 107. The flow guide ring axial limiting protrusion 118 cooperates with the flow guide ring radial limiting part 119. Therefore, the flow guide ring 107 is not prone to displacement relative to the motor end cover 110 and the motor stator 120, to help enhance structural stability of the flow guide ring 107.

In an embodiment, the flow guide ring radial limiting part 119, the flow guide ring axial limiting protrusion 118, and the motor end cover 110 are integrally formed. This solution helps enhance structural strength of the flow guide ring radial limiting part 119, and improve a radial limiting function for the flow guide ring 107. In this way, when the motor 100 is in a high-speed working condition, the flow guide hole 1071 of the flow guide ring 107 can stably perform cooling and heat dissipation on the motor winding 130.

Still with reference to FIG. 42 to FIG. 44, in an embodiment, the motor end cover 110 further includes a mold assembly screw hole 1101 (as shown in FIG. 42 and FIG. 44). The motor end cover 110 is fastened to the motor housing 106 by using a mold assembly bolt 108. The mold assembly bolt 108 is fastened in the mold assembly screw hole 1101 and the bolt hole 1061 (as shown in FIG. 42 and FIG. 44). Along the motor axial direction Y, the mold assembly screw hole 1101 and the bolt hole 1061 are adjacently arranged and communicate with each other (as shown in FIG. 42). The flow guide ring axial limiting protrusion 118, the housing limiting groove 117, and the mold assembly screw hole 1101 are sequentially arranged along the motor radial direction R (as shown in FIG. 42 and FIG. 43).

In this embodiment of this application, the mold assembly bolt 108 sequentially penetrates the mold assembly screw hole 1101 and the bolt hole 1061, to fasten the motor end cover 110 and the motor housing 106 and ensure structural stability of the motor 100. The flow guide ring axial limiting protrusion 118, the housing limiting groove 117, and the mold assembly screw hole 1101 are sequentially arranged in the motor radial direction R. This structure has a compact and orderly layout, to help reduce a volume of the motor end cover 110.

In an embodiment, the mold assembly screw hole 1101 and the bolt hole 1061 are coaxially arranged. This solution helps reduce installation difficulty when the mold assembly bolt 108 penetrates the mold assembly screw hole 1101 and the bolt hole 1061, and improve stability of a connection between the motor end cover 110 and the motor housing 106.

Still with reference to FIG. 44, along the first direction Y, the cooling hole 113 and the housing limiting groove 117 of the motor 100 are adjacently arranged; and the cooling hole 113 communicates with the housing limiting groove 117. In this embodiment of this application, the housing limiting groove 117 and the flow guide ring 107 are adjacently provided (as shown in FIG. 43). A part of the cooling oil cools the motor winding 130 through the flow guide ring 107, and the remaining cooling oil can flow into the cooling hole 113 through the housing limiting groove 117. Because the cooling hole 113 communicates with two sides of the motor end cover 110 along the motor axial direction Y, the cooling hole 113 is adjacent to the electrical connecting piece 150 and the three phases of input copper bars 101 (as shown in FIG. 25). Therefore, after the cooling oil entering the cooling hole 113 flows out of the motor 100, the cooling oil can further cool the electrical connecting piece 150 and the three phases of input copper bars 101, to ensure that the motor 100 works in an appropriate temperature range and improve utilization of the cooling oil.

The powertrain arranged along a power flow, and the electric vehicle provided in embodiments of this application are described in detail above. The principles and embodiments of this application are described herein by using specific examples. The descriptions about embodiments are merely provided, to help understand the method and core ideas of this application. In addition, a person of ordinary skill in the art can make variations and modifications to this application in terms of specific embodiments and application scopes according to the ideas of this application. Therefore, the content of this specification shall not be construed as limitation on this application.

## Claims

1. A powertrain arranged along a power flow, wherein the powertrain comprises an integrated housing, a motor, and a motor controller, the integrated housing comprises a motor accommodating cavity, a controller accommodating cavity, a direct-current input interface mounting hole, and an alternating-current output interface mounting hole, and the motor comprises a motor shaft and a motor winding;
the direct-current input interface mounting hole and the alternating-current output interface mounting hole are arranged relative to each other along a first direction, the alternating-current output interface mounting hole and a wiring terminal of the motor winding are arranged on one side along the first direction, and the direct-current input interface mounting hole and an output end of the motor shaft are arranged on the other side along the first direction;
a projection of the controller accommodating cavity partially overlaps a projection of the motor accommodating cavity along a second direction, and a projection of the direct-current input interface mounting hole, a projection of the alternating-current output interface mounting hole, and a projection of the motor shaft do not overlap along a third direction; and
any two of the first direction, the second direction, and the third direction are perpendicular to each other.

2. The powertrain according to claim 1, wherein the motor controller comprises a capacitor module, a power module, and a copper bar assembly, and the controller accommodating cavity is configured to accommodate the capacitor module, the power module, and the copper bar assembly; and
the capacitor module and the power module are stacked along the second direction, the copper bar assembly and the power module are adjacently arranged along the third direction, and a distance between the power module and the motor shaft is greater than a distance between the copper bar assembly and the motor shaft along a radial direction of the motor.

3. The powertrain according to claim 2, wherein the motor controller further comprises a circuit board, and the circuit board is electrically connected to the power module;
along the second direction, the circuit board, the capacitor module, and the power module are stacked, a projection of any one of the capacitor module, the power module, and the circuit board does not overlap the copper bar assembly, and the projection of the motor shaft does not overlap the projection of any one of the capacitor module, the power module, and the circuit board; and
the projection of the motor shaft does not overlap a projection of any one of the capacitor module, the power module, and the circuit board along the third direction, the controller accommodating cavity at least partially overlaps the motor accommodating cavity along the third direction, and a length of an overlapping part between the controller accommodating cavity and the motor accommodating cavity in the third direction is less than an outside diameter of the motor stator.

4. The powertrain according to claim 2, wherein the direct-current input interface mounting hole is configured to fasten a direct-current input interface, the direct-current input interface is configured to electrically connect to the power battery, the power module comprises a plurality of bridge arm components, and the plurality of bridge arm components are configured to form an inverter circuit to convert a direct current into an alternating current;
along the first direction, the plurality of bridge arm components are sequentially and adjacently arranged, projections of the plurality of bridge arm components do not overlap a projection of the alternating-current output interface mounting hole, and the projections of the plurality of bridge arm components overlap a projection of the direct-current input interface mounting hole; and
a projection of the capacitor module covers projections of the plurality of bridge arm components along the second direction.

5. The powertrain according to claim 4, wherein the power module comprises three bridge arm components, two ends of the three bridge arm components are respectively configured to electrically connect to a positive electrode and a negative electrode of the direct-current input interface through two first connecting pieces, a bridge arm midpoint of each bridge arm component is configured to connect to the copper bar assembly through a second connecting piece, and the three bridge arm components output three phases of alternating currents to the copper bar assembly through three second connecting pieces;
the two first connecting pieces are spaced and arranged in the controller accommodating cavity along the first direction, and projections of the two first connecting pieces at least partially overlap the projection of the direct-current input interface mounting hole along the first direction; and
the three second connecting pieces are spaced and arranged in the controller accommodating cavity along the first direction, and projections of the three second connecting pieces at least partially overlap the projection of the alternating-current output interface mounting hole along the first direction.

6. The powertrain according to claim 1, wherein the integrated housing further comprises a power interface mounting hole;
the power interface mounting hole and the direct-current input interface mounting hole are arranged relative to each other along the first direction, and the power interface mounting hole, the alternating-current output interface mounting hole, and the wiring terminal of the motor winding are arranged on the side along the first direction; and
the power interface mounting hole and the alternating-current output interface mounting hole are adjacently arranged along the third direction.

7. The powertrain according to claim 6, wherein the power interface mounting hole is configured to fasten a power interface, the power interface is configured to electrically connect to an external power supply, and the power interface mounting hole penetrates the integrated housing along the first direction and communicates with the controller accommodating cavity; and
a distance between the alternating-current output interface mounting hole and the motor shaft is greater than a distance between the power interface mounting hole and the motor shaft along the radial direction of the motor.

8. The powertrain according to claim 2, wherein the alternating-current output interface mounting hole is configured to fasten an alternating-current output interface, and the alternating-current output interface is configured to electrically connect to the wiring terminal of the motor winding through an input copper bar;
the input copper bar, the alternating-current output interface mounting hole, and the wiring terminal of the motor winding are arranged on the side along the first direction; and
a length direction of the input copper bar intersects the first direction, the second direction, and the third direction.

9. The powertrain according to claim 8, wherein the alternating-current output interface comprises three wiring ports, the three wiring ports are electrically connected to the wiring terminal of the motor winding respectively through three input copper bars, the three input copper bars are spaced and arranged, and an arrangement direction of the three input copper bars intersects both the first direction and the second direction.

10. The powertrain according to any one of claims 1 to 9, wherein the powertrain further comprises a reducer, and the reducer is connected to the output end of the motor shaft in a transmission manner; and
the reducer and the alternating-current output interface mounting hole are arranged relative to each other along the first direction, and the reducer and the direct-current input interface mounting hole are arranged on the other side along the first direction.

11. The powertrain according to claim 10, wherein the integrated housing further comprises a reducer accommodating cavity, the reducer accommodating cavity is configured to accommodate the reducer, the reducer accommodating cavity communicates with the motor accommodating cavity, and the controller accommodating cavity, the motor accommodating cavity, and the reducer accommodating cavity each comprise an opening;
along the first direction, an orientation of the opening of the motor accommodating cavity is opposite to an orientation of the opening of the reducer accommodating cavity, and a length of the opening of the controller accommodating cavity is less than a sum of lengths of the reducer accommodating cavity and the motor accommodating cavity; and
an orientation of the opening of the controller accommodating cavity is perpendicular to the first direction and the third direction.

12. The powertrain according to claim 11, wherein the powertrain further comprises a motor end cover, a reducer end cover, and a motor controller cover, and the motor end cover, the reducer end cover, and the motor controller cover are respectively configured to cover the opening of the controller accommodating cavity, the opening of the motor accommodating cavity, and the opening of the reducer accommodating cavity; and
along the first direction, a length of the motor controller cover is less than a distance between the motor end cover and the reducer end cover, and a length of the controller accommodating cavity is less than a distance between the motor end cover and the reducer end cover.

13. The powertrain according to claim 11, wherein the powertrain further comprises a wiring cover; and
along the first direction, the wiring cover and the reducer cover are arranged relative to each other, the motor end cover is arranged between the motor stator and the wiring cover, a gap between the wiring cover and the motor end cover is used to accommodate the input copper bar, and a projection of the wiring cover covers projections of the alternating-current output interface mounting hole, the three input copper bars, the wiring terminal of the motor winding, and the motor shaft.

14. The powertrain according to any one of claims 1 to 9, wherein the integrated housing further comprises a coolant inlet and a coolant outlet, the coolant inlet is configured to provide a coolant for the motor controller, the coolant outlet is configured to output the coolant, the coolant inlet, the power interface mounting hole, and the alternating-current output interface mounting hole are arranged on the side along the first direction, the coolant inlet and the power interface mounting hole are adjacently arranged along the second direction, and a projection of the coolant outlet overlaps a projection of the controller accommodating cavity and does not overlap the projection of the motor shaft along the third direction.

15. An electric vehicle, comprising a vehicle body, a battery pack, and the powertrain according to any one of claims 1 to 14, wherein the powertrain is fastened to the vehicle body, the battery pack is connected to the motor controller through the direct-current input interface mounting hole, and a wheel drive terminal in the powertrain is connected to a wheel of the vehicle in a transmission manner and is configured to provide power for the wheel.
